# EUROPEAN PATENT APPLICATION

(11) **EP 4 617 919 A1**
(43) Date of publication of application: **17.09.2025**
(21) Application number: 25160813.9
(22) Date of filing: 28.02.2025
(51) Int. Cl.: G06F 17/16

(54) **LOW-RANK DECOMPOSITION-BASED HARDWARE COMPRESSION OF MATRICES AND TENSORS**

(30) Priority: 14.03.2024 US 202463565207 P; 11.02.2025 US 202519050607
(71) Applicant: INTEL Corporation, Santa Clara, CA 95054 (US)
(72) Inventor: Kaplanyan, Anton, Mercer Island, 98040 (US)
(74) Representative: Goddar, Heinz J.

(57) **Abstract**

Low-rank decomposition-based hardware compression of matrices and tensors is described. An example of an apparatus includes a computer memory to store data for processing, and one or more processing resources including one or more accelerators, the one or more accelerators including circuitry for processing of one or more matrices. The circuitry includes decomposition-based compression circuitry, the decomposition-based compression circuitry performing decomposition of one or more input matrices to generate components representing approximated versions of the one or more input matrices.

## Description

### CLAIM TO PRIORITY

This application claims priority to U.S. Provisional Application Serial No. 63/565,207, entitled DECOMPOSITION-BASED STREAMING LOSSY MATRIX COMPRESSION, by Anton Kaplanyan, filed March 14, 2024, the entire contents of which are incorporated herein by reference.

### BACKGROUND OF THE DISCLOSURE

In the processing of artificial intelligence (AI) workloads, it is necessary to store and multiply high numbers of very large matrices and tensors. As a result, AI operations require significant and growing amounts of storage, bandwidth, and power.

Existing compression techniques can assist in reducing costs that are related to handling of matrices and tensors, but these techniques may be insufficient to sufficiently address the costs of modern AI processing.

### BRIEF DESCRIPTION OF THE DRAWINGS

Embodiments described herein are illustrated by way of example and not limitation in the figures of the accompanying drawings in which like references indicate similar elements, and in which:
**FIG. 1** is a block diagram illustrating a computer system configured to implement one or more aspects of the embodiments described herein;
**FIGS. 2A-2E** illustrate parallel processor components, including graphics multiprocessors;
**FIG. 3** illustrates a graphics processing unit that includes dedicated sets of graphics processing resources arranged into multi-core groups;
**FIGS. 4A-4E** illustrate an exemplary architecture in which a plurality of GPUs is communicatively coupled to a plurality of multi-core processors;
**FIG. 5** illustrates a graphics processing pipeline;
**FIG. 6** illustrates a machine learning software stack;
**FIG. 7** illustrates a general-purpose graphics processing unit;
**FIG. 8** illustrates a multi-GPU computing system;
**FIGS. 9A-9B** illustrate layers of exemplary deep neural networks;
**FIGS. 10A-10B** illustrate exemplary language models;
**FIG. 11** illustrates training and deployment of a deep neural network;
**FIG. 12A** is a block diagram illustrating distributed learning;
**FIG. 12B** is a block diagram illustrating a programmable network interface and data processing unit;
**FIG. 13** illustrates an exemplary inferencing system on a chip (SOC) suitable for performing inferencing using a trained model;
**FIG. 14** is a block diagram of a processing system;
**FIGS. 15A-15C** illustrate computing systems and graphics processors;
**FIG. 16** is a block diagram of a graphics processor, which may be a discrete or integrated graphics processing unit;
**FIGS. 17A-17B** illustrate block diagrams of additional graphics processor and compute accelerator architectures;
**FIGS. 18A-18C** illustrate thread execution logic including an array of processing elements employed in a graphics processor core;
**FIG. 19** illustrates a tile of a multi-tile processor, according to an embodiment;
**FIG. 20** is a block diagram illustrating graphics processor instruction formats;
**FIG. 21** is a block diagram of an additional graphics processor architecture;
**FIGS. 22A-22B** illustrate a graphics processor command format and command sequence;
**FIG. 23** illustrates exemplary graphics software architecture for a data processing system;
**FIG. 24** is a block diagram illustrating an IP core development system;
**FIG. 25A** illustrates a cross-section side view of an integrated circuit package assembly that includes multiple units of hardware logic chiplets connected to a substrate (e.g., base die);
**FIG. 25B** illustrates a package assembly including interchangeable chiplets;
**FIG. 26** is a block diagram illustrating a system on a chip integrated circuit;
**FIG. 27** is an illustration of an apparatus or system to provide for low-rank decomposition-based hardware compression, according to some embodiments;
**FIG. 28** is an illustration of circuitry of a graphical processing unit (GPU) or other accelerator, according to some embodiments;
**FIG. 29** is an illustration of an example decomposition of a matrix in a compression operation, according to some embodiments;
**FIG. 30** is an illustration of an example decomposition of a tensor in an operation, according to some embodiments;
**FIG. 31** is an illustration of an example decomposition of a matrix in an operation, according to some embodiments; and
**FIG. 32** is an illustration of a process for decomposition-based compression of a matrix or tensor, according to some embodiments.

### DETAILED DESCRIPTION

In some embodiments, an apparatus, system, or process provides for low-rank decomposition-based hardware compression of matrices and tensors.

Current parallel graphics data processing includes systems and methods developed to perform specific operations on graphics data such as, for example, linear interpolation, tessellation, rasterization, texture mapping, depth testing, etc. Traditionally, graphics processors used fixed function computational units to process graphics data. However, more recently, portions of graphics processors have been made programmable, enabling such processors to support a wider variety of operations for processing vertex and fragment data.

To further increase performance, graphics processors typically implement processing techniques such as pipelining that attempt to process, in parallel, as much graphics data as possible throughout the different parts of the graphics pipeline. Parallel graphics processors with single instruction, multiple thread (SIMT) architectures are designed to maximize the amount of parallel processing in the graphics pipeline. In a SIMT architecture, groups of parallel threads attempt to execute program instructions synchronously together as often as possible to increase processing efficiency.

A graphics processing unit (GPU) is communicatively coupled to host/processor cores to accelerate, for example, graphics operations, machine-learning operations, pattern analysis operations, and/or various general-purpose GPU (GPGPU) functions. The GPU may be communicatively coupled to the host processor/cores over a bus or another interconnect (e.g., a high-speed interconnect such as PCIe or NVLink). Alternatively, the GPU may be integrated on the same package or chip as the cores and communicatively coupled to the cores over an internal processor bus/interconnect (i.e., internal to the package or chip). Regardless of the manner in which the GPU is connected, the processor cores may allocate work to the GPU in the form of sequences of commands/instructions contained in a work descriptor. The GPU then uses dedicated circuitry/logic for efficiently processing these commands/instructions.

While the techniques described herein are primarily discussed in the context of a GPU, techniques may also be implemented in other types of processors, including but not limited to general-purpose processors and accelerator devices, such as artificial intelligence accelerators, vision processors, and neural processing units.

In the following description, numerous specific details are set forth to provide a more thorough understanding. However, it will be apparent to one of skill in the art that the embodiments described herein may be practiced without one or more of these specific details. In other instances, well-known features have not been described to avoid obscuring the details of the present embodiments.

### System Overview

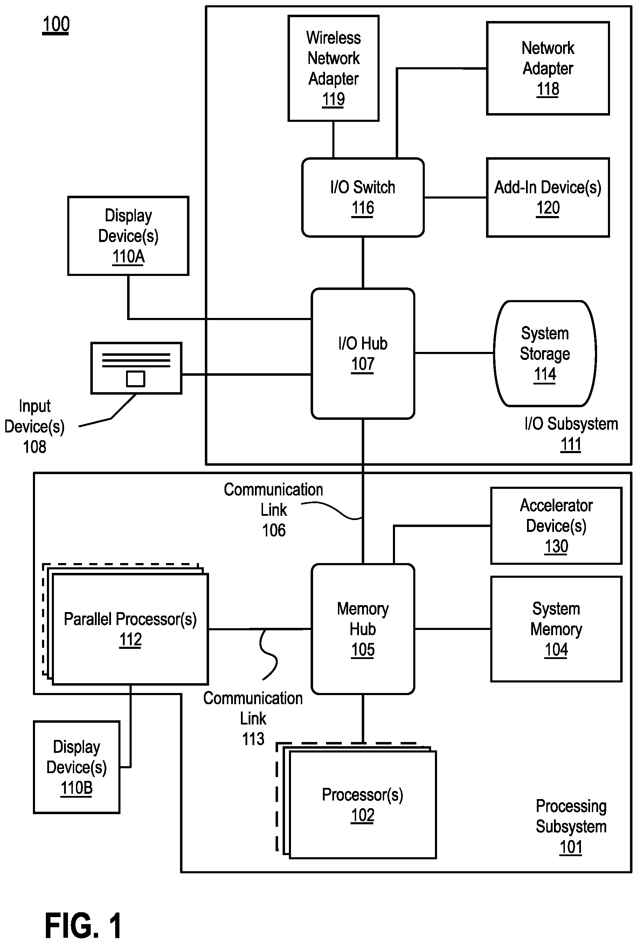

**FIG. 1** is a block diagram illustrating a computing system 100 configured to implement one or more aspects of the embodiments described herein. The computing system 100 includes a processing subsystem 101 having one or more processor(s) 102 and a system memory 104 communicating via an interconnection path that may include a memory hub 105. The memory hub 105 may be a separate component within a chipset component or may be integrated within the one or more processor(s) 102. The memory hub 105 couples with an I/O subsystem 111 via a communication link 106. The I/O subsystem 111 includes an I/O hub 107 that can enable the computing system 100 to receive input from one or more input device(s) 108. Additionally, the I/O hub 107 can enable a display controller, which may be included in the one or more processor(s) 102, to provide outputs to one or more display device(s) 110A. In one embodiment the one or more display device(s) 110A coupled with the I/O hub 107 can include a local, internal, or embedded display device.

The processing subsystem 101, for example, includes one or more parallel processor(s) 112 coupled to memory hub 105 via a communication link 113, such as a bus or fabric. The communication link 113 may be one of any number of standards-based communication link technologies or protocols, such as, but not limited to PCI Express, or may be a vendor specific communications interface or communications fabric. The one or more parallel processor(s) 112 may form a computationally focused parallel or vector processing system that can include a large number of processing cores and/or processing clusters, such as a many integrated core (MIC) processor. For example, the one or more parallel processor(s) 112 form a graphics processing subsystem that can output pixels to one of the one or more display device(s) 110A coupled via the I/O hub 107. The one or more parallel processor(s) 112 can also include a display controller and display interface (not shown) to enable a direct connection to one or more display device(s) 110B.

Within the I/O subsystem 111, a system storage unit 114 can connect to the I/O hub 107 to provide a storage mechanism for the computing system 100. An I/O switch 116 can be used to provide an interface mechanism to enable connections between the I/O hub 107 and other components, such as a network adapter 118 and/or wireless network adapter 119 that may be integrated into the platform, and various other devices that can be added via one or more add-in device(s) 120. The add-in device(s) 120 may also include, for example, one or more external graphics processor devices, graphics cards, and/or compute accelerators. The network adapter 118 can be an Ethernet adapter or another wired network adapter. The wireless network adapter 119 can include one or more of a Wi-Fi, Bluetooth, near field communication (NFC), or other network device that includes one or more wireless radios.

The computing system 100 can include other components not explicitly shown, including USB or other port connections, optical storage drives, video capture devices, and the like, which may also be connected to the I/O hub 107. Communication paths interconnecting the various components in FIG. 1 may be implemented using any suitable protocols, such as PCI (Peripheral Component Interconnect) based protocols (e.g., PCI-Express), or any other bus or point-to-point communication interfaces and/or protocol(s), such as the NVLink high-speed interconnect, Compute Express Link^{™} (*CXL*^{™}) (e.g., CXL.mem), Infinity Fabric (IF), Ethernet (IEEE 802.3), remote direct memory access (RDMA), InfiniBand, Internet Wide Area RDMA Protocol (iWARP), Transmission Control Protocol (TCP), User Datagram Protocol (UDP), quick UDP Internet Connections (QUIC), RDMA over Converged Ethernet (RoCE), Intel QuickPath Interconnect (QPI), Intel Ultra Path Interconnect (UPI), Intel On-Chip System Fabric (IOSF), Omni-Path, HyperTransport, Advanced Microcontroller Bus Architecture (AMBA) interconnect, OpenCAPI, Gen-Z, Cache Coherent Interconnect for Accelerators (CCIX), 3GPP Long Term Evolution (LTE) (4G), 3GPP 5G, and variations thereof, or wired or wireless interconnect protocols known in the art. In some examples, data can be copied or stored to virtualized storage nodes using a protocol such as non-volatile memory express (NVMe) over Fabrics (NVMe-oF) or NVMe.

The one or more parallel processor(s) 112 may incorporate circuitry optimized for graphics and video processing, including, for example, video output circuitry, and constitutes a graphics processing unit (GPU). Alternatively or additionally, the one or more parallel processor(s) 112 can incorporate circuitry optimized for general purpose processing, while preserving the underlying computational architecture, described in greater detail herein. Components of the computing system 100 may be integrated with one or more other system elements on a single integrated circuit. For example, the one or more parallel processor(s) 112, memory hub 105, processor(s) 102, and I/O hub 107 can be integrated into a system on chip (SoC) integrated circuit. Alternatively, the components of the computing system 100 can be integrated into a single package to form a system in package (SIP) configuration. In one embodiment at least a portion of the components of the computing system 100 can be integrated into a multi-chip module (MCM), which can be interconnected with other multi-chip modules into a modular computing system. In some configurations, the computing system 100 includes one or more accelerator device(s) 130 coupled with the memory hub 105, in addition to the processor(s) 102 and the one or more parallel processor(s) 112. The accelerator device(s) 130 are configured to perform domain specific acceleration of workloads to handle tasks that are computationally intensive or require high throughput. The accelerator device(s) 130 can reduce the burden placed on the processor(s) 102 and/or parallel processor(s) 112 of the computing system 100. The accelerator device(s) 130 can include but are not limited to smart network interface cards, data processing units, cryptographic accelerators, storage accelerators, artificial intelligence (AI) accelerators, neural processing units (NPUs), storage accelerators, and/or video transcoding accelerators.

It will be appreciated that the computing system 100 shown herein is illustrative and that variations and modifications are possible. The connection topology, including the number and arrangement of bridges, the number of processor(s) 102, and the number of parallel processor(s) 112, may be modified as desired. For instance, system memory 104 can be connected to the processor(s) 102 directly rather than through a bridge, while other devices communicate with system memory 104 via the memory hub 105 and the processor(s) 102. In other alternative topologies, the parallel processor(s) 112 are connected to the I/O hub 107 or directly to one of the one or more processor(s) 102, rather than to the memory hub 105. In other embodiments, the I/O hub 107 and memory hub 105 may be integrated into a single chip. It is also possible that two or more sets of processor(s) 102 are attached via multiple sockets, which can couple with two or more instances of the parallel processor(s) 112.

Some of the particular components shown herein are optional and may not be included in all implementations of the computing system 100. For example, any number of add-in cards or peripherals may be supported, or some components may be eliminated. Furthermore, some architectures may use different terminology for components similar to those illustrated in FIG. 1. For example, the memory hub 105 may be referred to as a Northbridge in some architectures, while the I/O hub 107 may be referred to as a Southbridge.

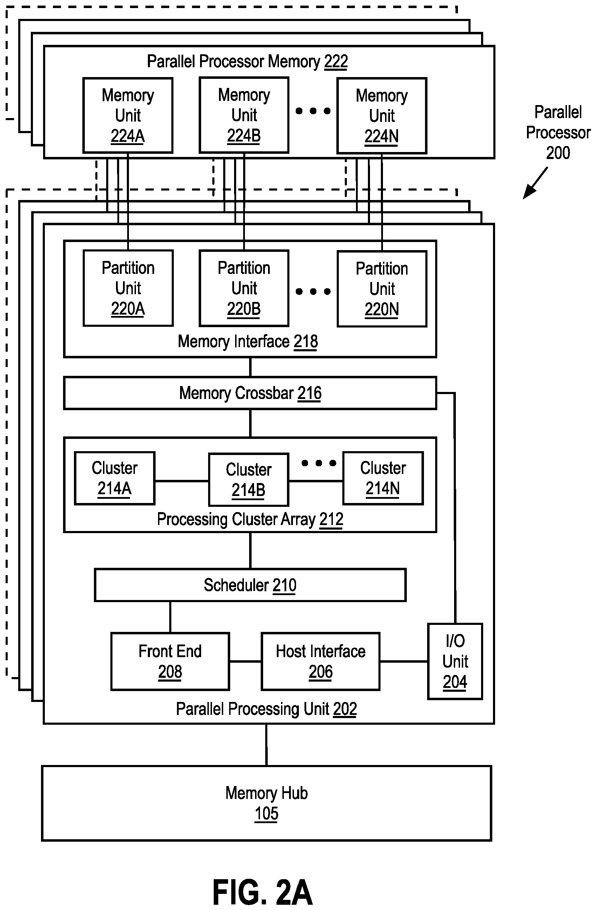

**FIG. 2A** illustrates a parallel processor 200. The parallel processor 200 may be a GPU, GPGPU or the like as described herein. The various components of the parallel processor 200 may be implemented using one or more integrated circuit devices, such as programmable processors, application specific integrated circuits (ASICs), or field programmable gate arrays (FPGA). The parallel processor 200 may be one or more of the parallel processor(s) 112 shown in FIG. 1.

The parallel processor 200 includes a parallel processing unit 202. The parallel processing unit includes an I/O unit 204 that enables communication with other devices, including other instances of the parallel processing unit 202. The I/O unit 204 may be directly connected to other devices. For instance, the I/O unit 204 connects with other devices via the use of a hub or switch interface, such as memory hub 105. The connections between the memory hub 105 and the I/O unit 204 form a communication link 113. Within the parallel processing unit 202, the I/O unit 204 connects with a host interface 206 and a memory crossbar 216, where the host interface 206 receives commands directed to performing processing operations and the memory crossbar 216 receives commands directed to performing memory operations. In one embodiment, the I/O unit 204 is configured to enable secure I/O operations via Trusted Execution Environment (TEE)-I/O support. TEE-IO enables trusted I/O virtualization, in which a trust relationship can be established directly between a secure virtual environment, such as trusted virtual machine, and the parallel processor 200 or secure partitions of the parallel processor.

When the host interface 206 receives a command buffer via the I/O unit 204, the host interface 206 can direct work operations to perform those commands to a front end 208. In one embodiment the front end 208 couples with a scheduler 210, which is configured to distribute commands or other work items to a processing cluster array 212. The scheduler 210 ensures that the processing cluster array 212 is properly configured and in a valid state before tasks are distributed to the processing clusters of the processing cluster array 212. The scheduler 210 may be implemented via firmware logic executing on a microcontroller. The microcontroller implemented scheduler 210 is configurable to perform complex scheduling and work distribution operations at coarse and fine granularity, enabling rapid preemption and context switching of threads executing on the processing cluster array 212. Preferably, the host software can prove workloads for scheduling on the processing cluster array 212 via one of multiple graphics processing doorbells. In other examples, polling for new workloads or interrupts can be used to identify or indicate availability of work to perform. The workloads can then be automatically distributed across the processing cluster array 212 by the scheduler 210 logic within the scheduler microcontroller.

The processing cluster array 212 can include up to "N" processing clusters (e.g., cluster 214A, cluster 214B, through cluster 214N). Each cluster 214A-214N of the processing cluster array 212 can execute a large number of concurrent threads. The scheduler 210 can allocate work to the clusters 214A-214N of the processing cluster array 212 using various scheduling and/or work distribution algorithms, which may vary depending on the workload arising for each type of program or computation. The scheduling can be handled dynamically by the scheduler 210 or can be assisted in part by compiler logic during compilation of program logic configured for execution by the processing cluster array 212. Optionally, different clusters 214A-214N of the processing cluster array 212 can be allocated for processing different types of programs or for performing different types of computations.

The processing cluster array 212 can be configured to perform various types of parallel processing operations. For example, the processing cluster array 212 is configured to perform general-purpose parallel compute operations. For example, the processing cluster array 212 can include logic to execute processing tasks including filtering of video and/or audio data, performing modeling operations, including physics operations, and performing data transformations.

The processing cluster array 212 is configured to perform parallel graphics processing operations. In such embodiments in which the parallel processor 200 is configured to perform graphics processing operations, the processing cluster array 212 can include additional logic to support the execution of such graphics processing operations, including, but not limited to texture sampling logic to perform texture operations, as well as tessellation logic and other vertex processing logic. Additionally, the processing cluster array 212 can be configured to execute graphics processing related shader programs such as, but not limited to vertex shaders, tessellation shaders, geometry shaders, and pixel shaders. The parallel processing unit 202 can transfer data from system memory via the I/O unit 204 for processing. During processing, the transferred data can be stored to on-chip memory (e.g., parallel processor memory 222) during processing, then written back to system memory.

In embodiments in which the parallel processing unit 202 is used to perform graphics processing, the scheduler 210 may be configured to divide the processing workload into approximately equal sized tasks, to better enable distribution of the graphics processing operations to multiple clusters 214A-214N of the processing cluster array 212. In some of these embodiments, portions of the processing cluster array 212 can be configured to perform different types of processing. For example, a first portion may be configured to perform vertex shading and topology generation, a second portion may be configured to perform tessellation and geometry shading, and a third portion may be configured to perform pixel shading or other screen space operations, to produce a rendered image for display. Intermediate data produced by one or more of the clusters 214A-214N may be stored in buffers to allow the intermediate data to be transmitted between clusters 214A-214N for further processing.

During operation, the processing cluster array 212 can receive processing tasks to be executed via the scheduler 210, which receives commands defining processing tasks from front end 208. For graphics processing operations, processing tasks can include indices of data to be processed, e.g., surface (patch) data, primitive data, vertex data, and/or pixel data, as well as state parameters and commands defining how the data is to be processed (e.g., what program is to be executed). The scheduler 210 may be configured to fetch the indices corresponding to the tasks or may receive the indices from the front end 208. The front end 208 can be configured to ensure the processing cluster array 212 is configured to a valid state before the workload specified by incoming command buffers (e.g., batch-buffers, push buffers, etc.) is initiated.

Each of the one or more instances of the parallel processing unit 202 can couple with parallel processor memory 222. The parallel processor memory 222 can be accessed via the memory crossbar 216, which can receive memory requests from the processing cluster array 212 as well as the I/O unit 204. The memory crossbar 216 can access the parallel processor memory 222 via a memory interface 218. The memory interface 218 can include multiple partition units (e.g., partition unit 220A, partition unit 220B, through partition unit 220N) that can each couple to a portion (e.g., memory unit) of parallel processor memory 222. The number of partition units 220A-220N may be configured to be equal to the number of memory units, such that each partition unit 220A0-220) has a corresponding memory unit 224A-224N. In other embodiments, the number of partition units 220A-220N may not be equal to the number of memory units.

The memory units 224A-224N can include various types of memory devices, including dynamic random-access memory (DRAM) or graphics random access memory, such as synchronous graphics random access memory (SGRAM), including graphics double data rate (GDDR) memory. Optionally, the memory units 224A-224N may also include 3D stacked memory, including but not limited to high bandwidth memory (HBM). Persons skilled in the art will appreciate that the specific implementation of the memory units 224A-224N can vary and can be selected from one of various conventional designs. Render targets, such as frame buffers or texture maps may be stored across the memory units 224A-224N, allowing partition units 220A-220N to write portions of each render target in parallel to efficiently use the available bandwidth of parallel processor memory 222. In some embodiments, a local instance of the parallel processor memory 222 may be excluded in favor of a unified memory design that utilizes system memory in conjunction with local cache memory.

Optionally, any one of the clusters 214A-214N of the processing cluster array 212 has the ability to process data that will be written to any of the memory units 224A-224N within parallel processor memory 222. The memory crossbar 216 can be configured to transfer the output of each cluster 214A-214N to any partition unit 220A-220N or to another cluster 214A-214N, which can perform additional processing operations on the output. Each cluster 214A-214N can communicate with the memory interface 218 through the memory crossbar 216 to read from or write to various external memory devices. In one of the embodiments with the memory crossbar 216 the memory crossbar 216 has a connection to the memory interface 218 to communicate with the I/O unit 204, as well as a connection to a local instance of the parallel processor memory 222, enabling the processing units within the different processing clusters 214A-214N to communicate with system memory or other memory that is not local to the parallel processing unit 202. Generally, the memory crossbar 216 may, for example, be able to use virtual channels to separate traffic streams between the clusters 214A-214N and the partition units 220A-220N.

While a single instance of the parallel processing unit 202 is illustrated within the parallel processor 200, any number of instances of the parallel processing unit 202 can be included. For example, multiple instances of the parallel processing unit 202 can be provided on a single add-in card, or multiple add-in cards can be interconnected. For example, the parallel processor 200 can be an add-in device, included in the add-in device(s) 120 of FIG. 1, which may be a graphics card such as a discrete graphics card that includes one or more GPUs, one or more memory devices, and device-to-device or network or fabric interfaces. The different instances of the parallel processing unit 202 can be configured to inter-operate even if the different instances have different numbers of processing cores, different amounts of local parallel processor memory, and/or other configuration differences. Optionally, some instances of the parallel processing unit 202 can include higher precision floating-point units relative to other instances. Systems incorporating one or more instances of the parallel processing unit 202 or the parallel processor 200 can be implemented in a variety of configurations and form factors, including but not limited to desktop, laptop, or handheld personal computers, servers, workstations, game consoles, and/or embedded systems. An orchestrator can form composite nodes for workload performance using one or more of: disaggregated processor resources, cache resources, memory resources, storage resources, and networking resources.

In one embodiment, the parallel processing unit 202 can be partitioned into multiple instances. Those multiple instances can be configured to execute workloads associated with different clients in an isolated manner, enabling a pre-determined quality of service to be provided for each client. For example, each cluster 214A-214N can be compartmentalized and isolated from other clusters, allowing the processing cluster array 212 to be divided into multiple compute partitions or instances. In such configuration, workloads that execute on an isolated partition are protected from faults or errors associated with a different workload that executes on a different partition. The partition units 220A-220N can be configured to enable a dedicated and/or isolated path to memory for the clusters 214A-214N associated with the respective compute partitions. This datapath isolation enables the compute resources within a partition can communicate with one or more assigned memory units 224A-224N without being subjected to interference by the activities of other partitions. In one embodiment, datapath isolation can be enhanced by encrypting data in memory of the various partitions with encryption keys that are unique to an associated partition, such that data is secured on a per-partition basis while at rest and in transit.

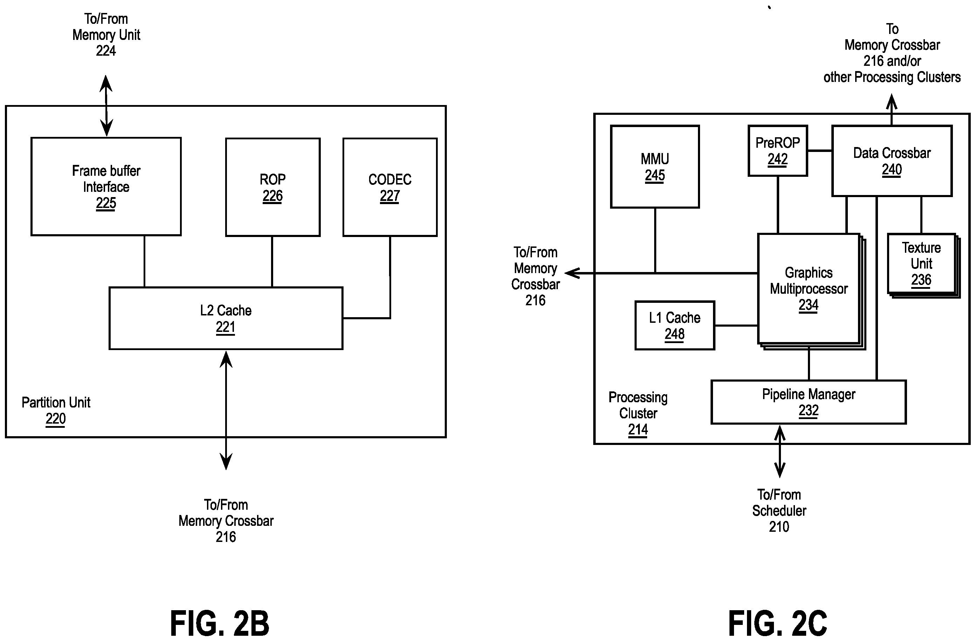

**FIG. 2B** is a block diagram of a partition unit 220. The partition unit 220 may be an instance of one of the partition units 220A-220N of FIG. 2A. As illustrated, the partition unit 220 includes an L2 cache 221, a frame buffer interface 225, and a ROP 226 (raster operations unit). The L2 cache 221 is a read/write cache that is configured to perform load and store operations received from the memory crossbar 216 and ROP 226. Read misses and urgent write-back requests are output by L2 cache 221 to frame buffer interface 225 for processing. Updates can also be sent to the frame buffer via the frame buffer interface 225 for processing. In one embodiment, the frame buffer interface 225 interfaces with a memory unit 224 of the memory units 224A-224N within parallel processor memory 222 of FIG. 2A. The partition unit 220 may additionally or alternatively also interface with one of the memory units in parallel processor memory via a memory controller (not shown).

In graphics applications, the ROP 226 is a processing unit that performs raster operations such as stencil, z test, blending, and the like. The ROP 226 then outputs processed graphics data that is stored in graphics memory. In some embodiments the ROP 226 includes or couples with a CODEC 227 that includes compression logic to compress depth or color data that is written to memory or the L2 cache 221 and decompress depth or color data that is read from memory or the L2 cache 221. The compression logic can be lossless compression logic that makes use of one or more of multiple compression algorithms. The type of compression that is performed by the CODEC 227 can vary based on the statistical characteristics of the data to be compressed. For example, in one embodiment, delta color compression is performed on depth and color data on a per-tile basis. In one embodiment the CODEC 227 includes compression and decompression logic that can compress and decompress compute data associated with machine learning operations. The CODEC 227 can, for example, compress sparse matrix data for sparse machine learning operations. The CODEC 227 can also compress sparse matrix data that is encoded in a sparse matrix format (e.g., coordinate list encoding (COO), compressed sparse row (CSR), compress sparse column (CSC), etc.) to generate compressed and encoded sparse matrix data. The compressed and encoded sparse matrix data can be decompressed and/or decoded before being processed by processing elements or the processing elements can be configured to consume compressed, encoded, or compressed and encoded data for processing. In one embodiment, the CODEC 227 can be configured as a general-purpose data compression engine for use in GPU database acceleration and large volume data analytics.

The ROP 226 may be included within each processing cluster (e.g., cluster 214A-214N of FIG. 2A) instead of within the partition unit 220. In such embodiment, read and write requests for pixel data are transmitted over the memory crossbar 216 instead of pixel fragment data. The processed graphics data may be displayed on a display device, such as one of the one or more display device(s) 110A-110B of FIG. 1, routed for further processing by the processor(s) 102, or routed for further processing by one of the processing entities within the parallel processor 200 of FIG. 2A.

**FIG. 2C** is a block diagram of a processing cluster 214 within a parallel processing unit. For example, the processing cluster 214 represents an instance of one of the processing clusters 214A-214N of FIG. 2A. The processing cluster 214 can be configured to execute many threads in parallel, where the term "thread" refers to an instance of a particular program executing on a particular set of input data. Optionally, single-instruction, multiple-data (SIMD) instruction issue techniques may be used to support parallel execution of a large number of threads without providing multiple independent instruction units. Alternatively, single-instruction, multiple-thread (SIMT) techniques may be used to support parallel execution of a large number of generally synchronized threads, using a common instruction unit configured to issue instructions to a set of processing engines within each one of the processing clusters. Unlike a SIMD execution regime, where all processing engines typically execute identical instructions, SIMT execution allows different threads to follow divergent execution paths more readily through a given thread program. Persons skilled in the art will understand that a SIMD processing regime represents a functional subset of a SIMT processing regime.

Operation of the processing cluster 214 can be controlled via a pipeline manager 232 that distributes processing tasks to SIMT parallel processors. The pipeline manager 232 receives instructions from the scheduler 210 of FIG. 2A and manages execution of those instructions via a graphics multiprocessor 234 and/or a texture unit 236. The graphics multiprocessor 234 is an exemplary instance of a SIMT parallel processor. However, various types of SIMT parallel processors of differing architectures may be included within the processing cluster 214. One or more instances of the graphics multiprocessor 234 can be included within a processing cluster 214. The graphics multiprocessor 234 may also be referred to as a streaming multiprocessors (SM) and is capable of simultaneous execution of a large number of execution threads.

The graphics multiprocessor 234 can process data and a data crossbar 240 can be used to distribute the processed data to one of multiple possible destinations, including instances of the graphics multiprocessor 234 within the processing cluster 214. The pipeline manager 232 can facilitate the distribution of processed data by specifying destinations for processed data to be distributed via the data crossbar 240. Each graphics multiprocessor 234 within the processing cluster 214 can include an identical set of functional execution logic (e.g., arithmetic logic units, load-store units, etc.). The functional execution logic can be configured in a pipelined manner in which new instructions can be issued before previous instructions are complete. The functional execution logic supports a variety of operations including integer and floating-point arithmetic, comparison operations, Boolean operations, bit-shifting, and computation of various algebraic functions. The same functional-unit hardware could be leveraged to perform different operations and any combination of functional units may be present.

The instructions transmitted to the processing cluster 214 constitute a thread. A set of threads executing across the set of parallel processing engines is a thread group. A thread group executes the same program on different input data. Each thread within a thread group can be assigned to a different processing engine within a graphics multiprocessor 234. A thread group may include fewer threads than the number of processing engines within the graphics multiprocessor 234. When a thread group includes fewer threads than the number of processing engines, one or more of the processing engines may be idle during cycles in which that thread group is being processed. A thread group may also include more threads than the number of processing engines within the graphics multiprocessor 234. When the thread group includes more threads than the number of processing engines within the graphics multiprocessor 234, processing can be performed over consecutive clock cycles. Optionally, multiple thread groups can be executed concurrently on the graphics multiprocessor 234.

The graphics multiprocessor 234 may include an internal cache memory to perform load and store operations. Optionally, the graphics multiprocessor 234 can forego an internal cache and use a cache memory (e.g., level 1 (L1) cache 248) within the processing cluster 214. Each graphics multiprocessor 234 also has access to level 2 (L2) caches within the partition units (e.g., partition units 220A-220N of FIG. 2A) that are shared among all instances of the processing cluster 214 and may be used to transfer data between threads. The graphics multiprocessor 234 may also access off-chip global memory, which can include one or more of local parallel processor memory and/or system memory. Any memory external to the parallel processing unit 202 may be used as global memory. Embodiments in which the processing cluster 214 includes multiple instances of the graphics multiprocessor 234 can share common instructions and data, which may be stored in the L1 cache 248.

Each processing cluster 214 may include an MMU 245 (memory management unit) that is configured to map virtual addresses into physical addresses. In other embodiments, one or more instances of the MMU 245 may reside within the memory interface 218 of FIG. 2A. The MMU 245 includes a set of page table entries (PTEs) used to map a virtual address to a physical address of a tile and optionally a cache line index. The MMU 245 may include address translation lookaside buffers (TLB) or caches that may reside within the graphics multiprocessor 234 or the L1 cache 248 of processing cluster 214. The physical address is processed to distribute surface data access locality to allow efficient request interleaving among partition units. The cache line index may be used to determine whether a request for a cache line is a hit or miss.

In graphics and computing applications, a processing cluster 214 may be configured such that each graphics multiprocessor 234 is coupled to a texture unit 236 for performing texture mapping operations, e.g., determining texture sample positions, reading texture data, and filtering the texture data. Texture data is read from an internal texture L1 cache (not shown) or in some embodiments from the L1 cache within graphics multiprocessor 234 and is fetched from an L2 cache, local parallel processor memory, or system memory, as needed. Each graphics multiprocessor 234 outputs processed tasks to the data crossbar 240 to provide the processed task to another processing cluster 214 for further processing or to store the processed task in an L2 cache, local parallel processor memory, or system memory via the memory crossbar 216. A preROP 242 (pre-raster operations unit) is configured to receive data from graphics multiprocessor 234, direct data to ROP units, which may be located with partition units as described herein (e.g., partition units 220A-220N of FIG. 2A). The preROP 242 unit can perform optimizations for color blending, organize pixel color data, and perform address translations.

It will be appreciated that the core architecture described herein is illustrative and that variations and modifications are possible. Any number of processing units, e.g., graphics multiprocessor 234, texture units 236, preROPs 242, etc., may be included within a processing cluster 214. A parallel processing unit as described herein may include any number of instances of the processing cluster 214. Optionally, each processing cluster 214 can be configured to operate independently of other instances of the processing cluster 214 using, for example, separate and distinct processing units, L1 caches, L2 caches to facilitate data and fault isolation.

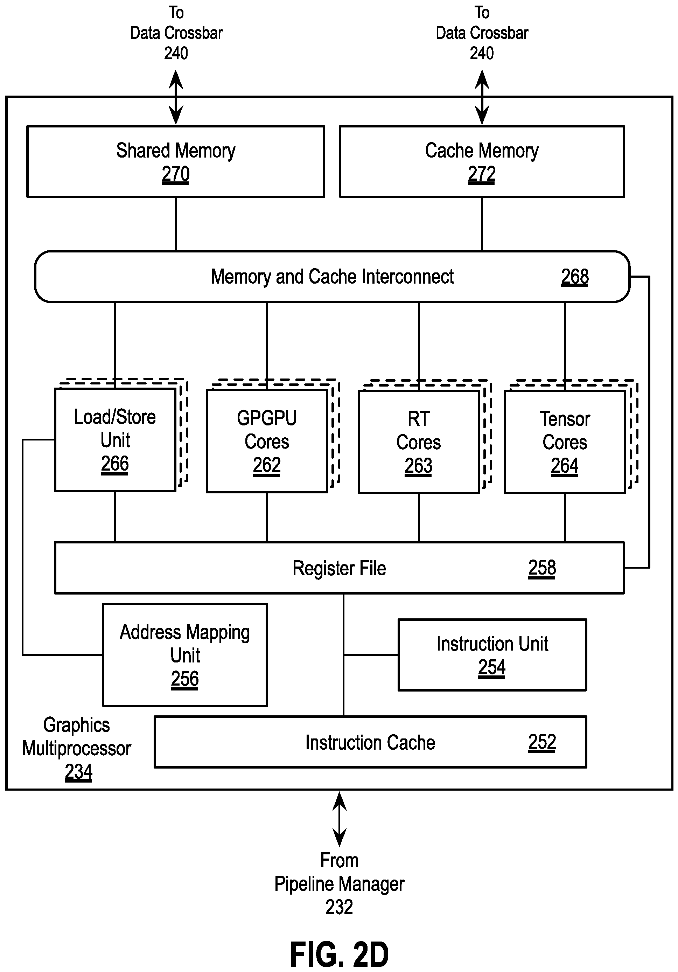

**FIG. 2D** shows an example of the graphics multiprocessor 234 in which the graphics multiprocessor 234 couples with the pipeline manager 232 of the processing cluster 214. The graphics multiprocessor 234 has an execution pipeline including but not limited to an instruction cache 252, an instruction unit 254, an address mapping unit 256, a register file 258, one or more general purpose graphics processing unit cores (GPGPU cores 262), and one or more load/store units 266. The GPGPU cores 262 and load/store units 266 are coupled with cache memory 272 and shared memory 270 via a memory and cache interconnect 268. The graphics multiprocessor 234 may additionally include ray-tracing cores 263 that include hardware logic to accelerate ray-tracing operations and tensor cores 264 that include hardware logic to accelerate tensor (e.g., matrix) operations. The instruction cache 252 may receive a stream of instructions to execute from the pipeline manager 232. The instructions are cached in the instruction cache 252 and dispatched for execution by the instruction unit 254. The instruction unit 254 can dispatch instructions as thread groups (e.g., warps), with each thread of the thread group assigned to a different execution unit within the GPGPU cores 262. An instruction can access any of a local, shared, or global address space by specifying an address within a unified address space. The address mapping unit 256 can be used to translate addresses in the unified address space into a distinct memory address that can be accessed by the load/store units 266.

The register file 258 provides a set of registers for the functional units of the graphics multiprocessor 234. The register file 258 provides temporary storage for operands connected to the data paths of the functional units (e.g., GPGPU cores 262, load/store units 266) of the graphics multiprocessor 234. The register file 258 may be divided between each of the functional units such that each functional unit is allocated a dedicated portion of the register file 258. For example, the register file 258 may be divided between the different warps being executed by the graphics multiprocessor 234.

The GPGPU cores 262 can each include floating-point units (FPUs) and/or integer arithmetic logic units (ALUs) that are used to execute instructions of the graphics multiprocessor 234. In some implementations, the GPGPU cores 262 can include hardware logic that may otherwise reside within the tensor cores 264 and/or ray-tracing cores 263. The GPGPU cores 262 can be similar in architecture or can differ in architecture. For example and in one embodiment, a first portion of the GPGPU cores 262 include a single precision FPU and an integer ALU while a second portion of the GPGPU cores include a double precision FPU. Optionally, the FPUs can implement the IEEE 754-2008 standard for floating-point arithmetic or enable variable precision floating-point arithmetic. In one embodiment, the single precision FPUs, or a separate set of FPUs, are configurable to perform operations on 16-bit floating-point operands, such as operands in a half precision format or a bfloat16 format (e.g., Brain floating-point), which is a 16-bit floating-point format with one sign bit, eight exponent bits, and eight significand bits, of which seven are explicitly stored. The FPUs within one or more of the GPGPU cores 262 may also support one or more 8-bit floating-point formats. Supported 8-bit floating-point formats include the E4M3 format having a 4-bit exponent and a 3-bit mantissa and the E5M2 format having a 5-bit exponent and 2-bit mantissa. The graphics multiprocessor 234 can additionally include one or more fixed function or special function units to perform specific functions such as copy rectangle or pixel blending operations. One or more of the GPGPU cores can also include fixed or special function logic.

The GPGPU cores 262 may include SIMD logic capable of performing a single instruction on multiple sets of data. Optionally, GPGPU cores 262 can physically execute SIMD4, SIMD8, and SIMD16 instructions and logically execute SIMD1, SIMD2, and SIMD32 instructions. The SIMD instructions for the GPGPU cores can be generated at compile time by a shader compiler or automatically generated when executing programs written and compiled for single program multiple data (SPMD) or SIMT architectures. Multiple threads of a program configured for the SIMT execution model can be executed via a single SIMD instruction. For example and in one embodiment, eight SIMT threads that perform the same or similar operations can be executed in parallel as a SIMD8 instruction. In one embodiment, a warp of 32 SIMT threads can be executed as a single SIMD32 instruction. Warp divergence can be handled via multiple SIMD instructions.

The memory and cache interconnect 268 is an interconnect network that connects each of the functional units of the graphics multiprocessor 234 to the register file 258 and to the shared memory 270. For example, the memory and cache interconnect 268 is a crossbar interconnect that allows the load/store unit 266 to implement load and store operations between the shared memory 270 and the register file 258. The register file 258 can operate at the same frequency as the GPGPU cores 262, thus data transfer between the GPGPU cores 262 and the register file 258 is very low latency. The shared memory 270 can be used to enable communication between threads that execute on the functional units within the graphics multiprocessor 234. The shared memory 270 can also be used as a program managed cached. The cache memory 272 can be used as an automatically managed data cache for example, to cache texture data communicated between the functional units and the texture unit 236. The shared memory 270 and the cache memory 272 can couple with the data crossbar 240 to enable communication with other components of the processing cluster, facilitating the cooperative execution of cluster workgroups via multiple graphics multiprocessors within a processing cluster. Threads executing on the GPGPU cores 262 can programmatically store data within the shared memory in addition to the automatically cached data that is stored within the cache memory 272. In one embodiment, the shared memory 270 and the cache memory 272 may be combined into a single configurable memory unit that can be selectively configured as the cache memory 272 or the shared memory 270.

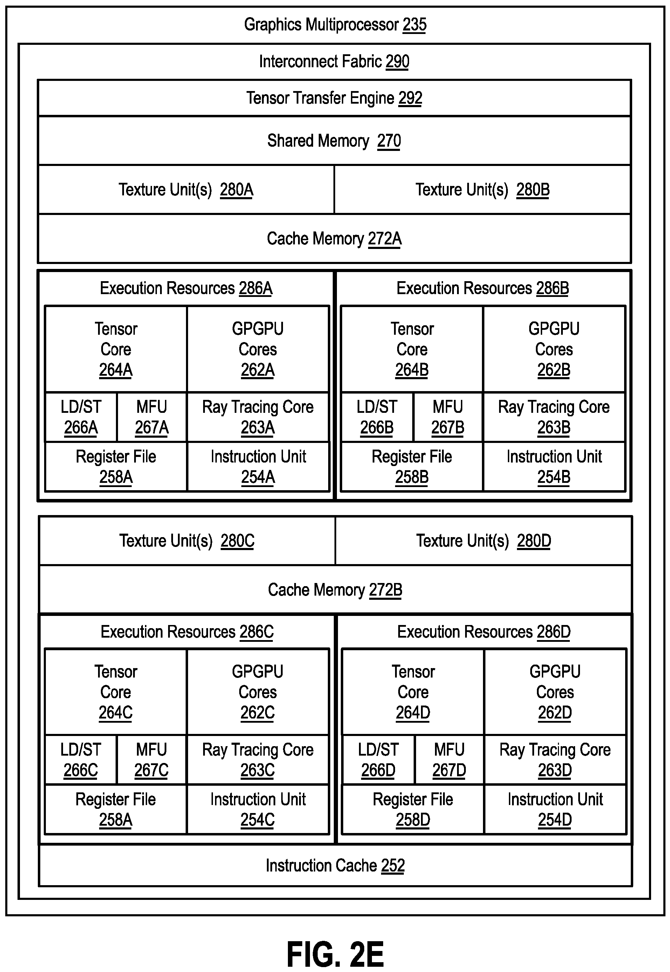

**FIG. 2E** illustrates a graphics multiprocessor 235 having an alternate configuration relative to the graphics multiprocessor 234 of FIG. 2D. The disclosure of any features in combination with the graphics multiprocessor 235 described herein also discloses a corresponding combination with the graphics multiprocessor 234 of FIG. 2D, but is not limited as such. The graphics multiprocessor 235 of FIG. 2E includes multiple additional instances of execution resources 286A-286D relative to the graphics multiprocessor 234 of FIG. 2D. For example, the graphics multiprocessor 235 can include multiple instruction units 254A-254D, register files 258A-258D, and texture units 280A-280D. The graphics multiprocessor 235 also includes multiple sets of graphics or compute execution units (e.g., GPGPU cores 262A-262D, ray-tracing cores 263A-263D, and tensor cores 264A-264D) and multiple sets of load/store units 266A-266D. The execution resources 286A-286D work in concert with texture unit(s) 280A-280D for texture operations, while sharing an instruction cache 252, shared memory 270, and cache memories 272A-272B. In one embodiment, the execution resources 286A-286D additionally include multi-function units (MUFU) and/or special-function units (SFU) (e.g., MFU 267A-267D) that are used to perform specialized mathematical operations, such as transcendental operations including exponential, logarithmic, and trigonometric functions.

The various components can communicate via an interconnect fabric 290. The interconnect fabric 290 may include one or more crossbar switches to enable communication between the various components of the graphics multiprocessor 235. The GPGPU cores 262A-262D, ray tracing cores 263A-263B, and tensor cores 264A-264D can each communicate with shared memory 270 via the interconnect fabric 290. The interconnect fabric 290 can arbitrate communication within the graphics multiprocessor 235 to ensure a fair bandwidth allocation between components. In one embodiment, the interconnect fabric 290 may be a separate, high-speed network fabric layer upon which each component of the graphics multiprocessor 235 is stacked. The components of the graphics multiprocessor 235 can also communicate with remote components via the interconnect fabric 290.

In one embodiment, the graphics multiprocessor 235 includes a tensor transfer engine 292, which is a copy engine that is configurable to accelerate the movement of tensor data into and out of the graphics multiprocessor 235. The tensor transfer engine 292 can accelerate tensor memory operations by asynchronously performing address generation and data movement operations for N-dimensional blocks of tensor data, which offloads operations that would otherwise be performed manually by program code executed by the graphics multiprocessor 235. The tensor transfer engine 292 is configurable to copy data between, for example, the shared memory 270 and/or cache memory 272A-272B of the graphics multiprocessor 235 and memory external to the graphics multiprocessor 235, such as graphics processor global memory (e.g., parallel processor memory 222). In one embodiment, data transfers performed by the tensor transfer engine 292 can be configured to selectively bypass various levels of intermediate data storage between the source and destination memories. For example, a transfer between global memory and shared memory 270 can bypass the register files 258A-258D. In one embodiment, threads can synchronize on asynchronous tensor transfers via a non-blocking barrier synchronization mechanism.

In various embodiments, the graphics multiprocessor 235 can be tailored for specific use cases via the inclusion or exclusion of certain components, allowing various implementations of the graphics multiprocessor 235 that are tailored to target power, performance, and area characteristic. For example, compute oriented variants of the graphics multiprocessor 235 that will not perform graphics operations can exclude the ray tracing cores 263A-263D. Fully graphics oriented variants can exclude the tensor transfer engine 292, while graphics oriented variants additionally configured to accelerate neural network inference may include at least a version of the tensor transfer engine 292.

Persons skilled in the art will understand that the architecture described in FIG. 1 and FIGS. 2A-2E are descriptive and not limiting as to the scope of the present embodiments. Thus, the techniques described herein may be implemented on any properly configured processing unit, including, without limitation, one or more mobile application processors, one or more desktop or server central processing units (CPUs) including multi-core CPUs, one or more parallel processing units, such as the parallel processing unit 202 of FIG. 2A, as well as one or more graphics processors or special purpose processing units, without departure from the scope of the embodiments described herein.

The parallel processor or GPGPU as described herein may be communicatively coupled to host/processor cores to accelerate graphics operations, machine-learning operations, pattern analysis operations, and various general-purpose GPU (GPGPU) functions. The GPU may be communicatively coupled to the host processor/cores over a bus or other interconnect (e.g., a high-speed interconnect such as PCIe, NVLink, or other known protocols, standardized protocols, or proprietary protocols). In other embodiments, the GPU may be integrated on the same package or chip as the cores and communicatively coupled to the cores over an internal processor bus/interconnect (i.e., internal to the package or chip). Regardless of the manner in which the GPU is connected, the processor cores may allocate work to the GPU in the form of sequences of commands/instructions contained in a work descriptor. The GPU then uses dedicated circuitry/logic for efficiently processing these commands/instructions.

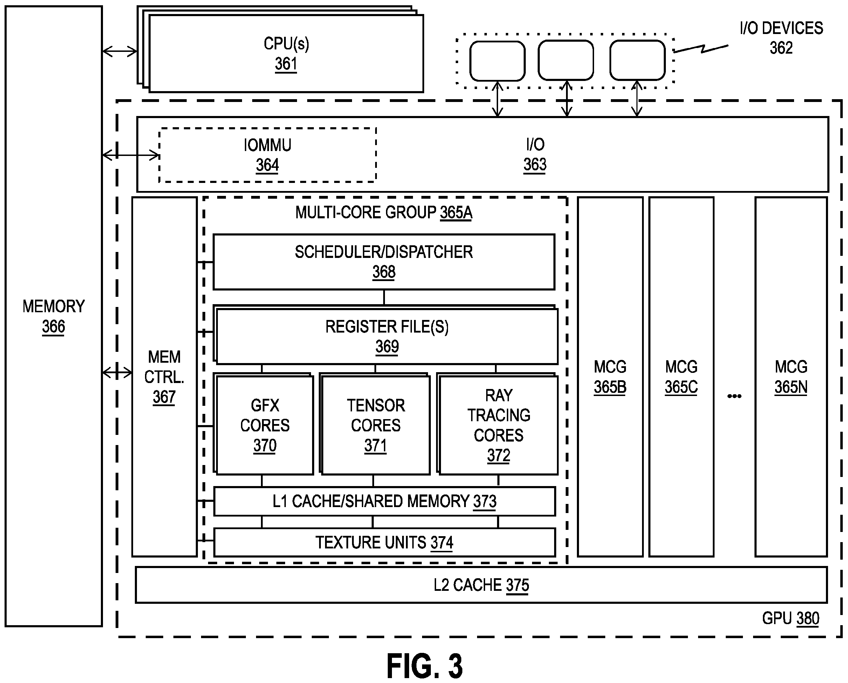

**FIG. 3** illustrates a graphics processing unit (GPU 380) which includes dedicated sets of graphics processing resources arranged into multi-core groups 365A-365N. The multi-core groups 365A-365N correspond with the graphics multiprocessor 234 of FIG. 2D or the graphics multiprocessor 235 of FIG. 2E. While the details of a single example of the multi-core groups 365A-365N (e.g., multi-core group 365A) are provided, it will be appreciated that the other multi-core groups 365B-365N may be equipped with the same or similar sets of graphics processing resources. Details described with respect to the multi-core groups 365A-365N may also apply to graphics multiprocessor 234 or graphics multiprocessor 235, as described herein.

As illustrated, a multi-core group 365A may include graphics cores 370, tensor cores 371, and ray tracing cores 372. The graphics cores 370 are analogous to the GPGPU cores 262A-262D and are configurable to execute instructions to perform graphics and/or general-purpose compute operations. A scheduler/dispatcher 368 schedules and dispatches the graphics threads for execution on the various cores within the multi-core group 365A. Register files 369 are included that store operand values used by the cores when performing graphics or general-purpose compute operations for executed threads. These register files 369 may include, for example, registers configurable to store integer values or floating-point values, including vector registers for storing packed integer and/or floating-point data elements and tile registers for storing tensor/matrix values. The tile registers may be implemented as multi-dimensional registers that include combined sets of vector registers.

One or more combined level 1 (L1) caches and shared memory units 373 store graphics data such as texture data, vertex data, pixel data, ray data, bounding volume data, etc., locally within each multi-core group 365A. One or more texture units 374 can also be used to perform texturing operations, such as texture mapping and sampling. A Level 2 (L2) cache 375 shared by all or a subset of the multi-core groups 365A-365N stores graphics data and/or instructions for multiple concurrent graphics threads. As illustrated, the L2 cache 375 may be shared across a plurality of multi-core groups 365A-365N. One or more memory controllers 367 couple the GPU 380 to a memory 366 which may be a system memory (e.g., DRAM) and/or a dedicated graphics memory (e.g., GDDR6 memory).

Input/output circuitry (I/O circuitry 363) couples the GPU 380 to one or more I/O devices 362 such as digital signal processors (DSPs), network controllers, or user input devices. An on-chip interconnect may be used to couple the I/O devices 362 to the GPU 380 and memory 366. At least one I/O memory management unit (IOMMU 364) of the I/O circuitry 363 couples the I/O devices 362 directly to the memory 366. Optionally, the IOMMU 364 manages multiple sets of page tables to map virtual addresses to physical addresses in memory 366. The I/O devices 362, CPU(s) 361, and GPU 380 may then share the same virtual address space.

In one implementation of the IOMMU 364, the IOMMU 364 supports virtualization. In this case, it may manage a first set of page tables to map guest/graphics virtual addresses to guest/graphics physical addresses and a second set of page tables to map the guest/graphics physical addresses to system/host physical addresses (e.g., within memory 366). The base addresses of each of the first and second sets of page tables may be stored in control registers and swapped out on a context switch (e.g., so that the new context is provided with access to the relevant set of page tables). While not illustrated in FIG. 3, each of the cores within the multi-core groups 365A-365N may include translation lookaside buffers (TLBs) to cache guest virtual to guest physical translations, guest physical to host physical translations, and guest virtual to host physical translations.

The CPU(s) 361, GPU 380, and I/O devices 362 may be integrated on a single semiconductor chip and/or chip package. The memory 366 may be integrated on the same chip or may be coupled to the one or more memory controllers 367 via an off-chip interface. In one implementation, the memory 366 comprises GDDR6 memory which shares the same virtual address space as other physical system-level memories, although the underlying principles described herein are not limited to this specific implementation.

The tensor cores 371 may include a plurality of execution units specifically designed to perform matrix operations, which are the fundamental compute operation used to perform deep learning operations. For example, simultaneous matrix multiplication operations may be used for neural network training and inferencing. The tensor cores 371 may perform matrix processing using a variety of operand precisions including single precision floating-point (e.g., 32 bits), half-precision floating-point (e.g., 16 bits), integer words (16 bits), bytes (8 bits), and half-bytes (4 bits). For example, a neural network implementation extracts features of each rendered scene, potentially combining details from multiple frames, to construct a high-quality final image.

In deep learning implementations, parallel matrix multiplication work may be scheduled for execution on the tensor cores 371. The training of neural networks, in particular, requires a significant number of matrix dot product operations. In order to process an inner-product formulation of an N x N x N matrix multiply, the tensor cores 371 may include at least N dot-product processing elements. Before the matrix multiply begins, one entire matrix is loaded into tile registers and at least one column of a second matrix is loaded each cycle for N cycles. Each cycle, there are N dot products that are processed.

Matrix elements may be stored at different precisions depending on the particular implementation, including 16-bit words, 8-bit bytes (e.g., INT8) and 4-bit half-bytes (e.g., INT4). Different precision modes may be specified for the tensor cores 371 to ensure that the most efficient precision is used for different workloads (e.g., such as inferencing workloads which can tolerate quantization to bytes and half-bytes). Supported formats additionally include 64-bit floating-point (FP64) and non-IEEE floating-point formats such as the bfloat16 format. One embodiment includes support for a reduced precision tensor-float (TF32) mode, which performs computations using the range of FP32 (8-bits) and the precision of FP16 (10-bits). Reduced precision TF32 operations can be performed on FP32 inputs and produce FP32 outputs at higher performance relative to FP32 and increased precision relative to FP16. In one embodiment, one or more 8-bit floating-point (FP8), 6-bit floating-point (FP6), and 4-bit floating-point (FP4) formats are supported, including floating-point formats represented as microscaling (MX) formats.

In one embodiment the tensor cores 371 support a sparse mode of operation for matrices in which the vast majority of values are zero. The tensor cores 371 include support for sparse input matrices that are encoded in a sparse matrix representation (e.g., coordinate list encoding (COO), compressed sparse row (CSR), compress sparse column (CSC), etc.). The tensor cores 371 also include support for compressed sparse matrix representations in the event that the sparse matrix representation may be further compressed. Compressed, encoded, and/or compressed and encoded matrix data, along with associated compression and/or encoding metadata, can be read by the tensor cores 371 and the non-zero values can be extracted. For example, for a given input matrix A, a non-zero value can be loaded from the compressed and/or encoded representation of at least a portion of matrix A. Based on the location in matrix A for the non-zero value, which may be determined from index or coordinate metadata associated with the non-zero value, a corresponding value in input matrix B may be loaded. Depending on the operation to be performed (e.g., multiply), the load of the value from input matrix B may be bypassed if the corresponding value is a zero value. In one embodiment, the pairings of values for certain operations, such as multiply operations, may be pre-scanned by scheduler logic and only operations between non-zero inputs are scheduled. Depending on the dimensions of matrix A and matrix B and the operation to be performed, output matrix C may be dense or sparse. Where output matrix C is sparse and depending on the configuration of the tensor cores 371, output matrix C may be output in a compressed format, a sparse encoding, or a compressed sparse encoding.

The ray tracing cores 372 may accelerate ray tracing operations for both real-time ray tracing and non-real-time ray tracing implementations. In particular, the ray tracing cores 372 may include ray traversal/intersection circuitry for performing ray traversal using bounding volume hierarchies (BVHs) and identifying intersections between rays and primitives enclosed within the BVH volumes. The ray tracing cores 372 may also include circuitry for performing depth testing and culling (e.g., using a Z buffer or similar arrangement). In one implementation, the ray tracing cores 372 perform traversal and intersection operations in concert with the image denoising techniques described herein, at least a portion of which may be executed on the tensor cores 371. For example, the tensor cores 371 may implement a deep learning neural network to perform denoising of frames generated by the ray tracing cores 372. However, the CPU(s) 361, graphics cores 370, and/or ray tracing cores 372 may also implement all or a portion of the denoising and/or deep learning algorithms.

In addition, as described above, a distributed approach to denoising may be employed in which the GPU 380 is in a computing device coupled to other computing devices over a network or high-speed interconnect. In this distributed approach, the interconnected computing devices may share neural network learning/training data to improve the speed with which the overall system learns to perform denoising for different types of image frames and/or different graphics applications.

The ray tracing cores 372 may process all BVH traversal and/or ray-primitive intersections, saving the graphics cores 370 from being overloaded with thousands of instructions per ray. For example, each ray tracing core 372 includes a first set of specialized circuitry for performing bounding box tests (e.g., for traversal operations) and/or a second set of specialized circuitry for performing the ray-triangle intersection tests (e.g., intersecting rays which have been

traversed). Thus, for example, the multi-core group 365A can simply launch a ray probe, and the ray tracing cores 372 independently perform ray traversal and intersection and return hit data (e.g., a hit, no hit, multiple hits, etc.) to the thread context. The graphics cores 370 and tensor cores 371 are then freed to perform other graphics or compute work while the ray tracing cores 372 perform the traversal and intersection operations. Optionally, each ray tracing core 372 may include a traversal unit to perform BVH testing operations and/or an intersection unit which performs ray-primitive intersection tests. The intersection unit generates a "hit", "no hit", or "multiple hit" response, which it provides to the appropriate thread. During the traversal and intersection operations, the execution resources of the other cores (e.g., graphics cores 370 and tensor cores 371) are freed to perform other forms of graphics work. In one optional embodiment described below, a hybrid rasterization/ray tracing approach is used in which rendering operations are distributed between the graphics cores 370 and ray tracing cores 372.

The ray tracing cores 372 may include hardware support for a ray tracing instruction set such as Microsoft's DirectX Ray Tracing (DXR) which includes a DispatchRays command, as well as ray-generation, closest-hit, any-hit, and miss shaders, which enable the assignment of unique sets of shaders and textures for each object. Another ray tracing platform which may be supported by the ray tracing cores 372, graphics cores 370 and tensor cores 371 is Vulkan API (e.g., Vulkan version 1.1.85 and later). Note, however, that the underlying principles described herein are not limited to any particular ray tracing ISA. In general, the ray tracing cores 372, tensor cores 371, and graphics cores 370 may support a ray tracing instruction set that includes instructions/functions for one or more of ray generation, closest hit, any hit, ray-primitive intersection, per-primitive and hierarchical bounding box construction, miss, visit, and exceptions. More specifically, a preferred embodiment includes ray tracing instructions to perform one or more of the following functions:
Ray Generation - Ray generation instructions may be executed for each pixel, sample, or other user-defined work assignment.
Closest Hit - A closest hit instruction may be executed to locate the closest intersection point of a ray with primitives within a scene.
Any Hit - An any hit instruction identifies multiple intersections between a ray and primitives within a scene, potentially to identify a new closest intersection point.
Intersection - An intersection instruction performs a ray-primitive intersection test and outputs a result.
Per-primitive Bounding box Construction - This instruction builds a bounding box around a given primitive or group of primitives (e.g., when building a new BVH or other acceleration data structure).
Miss - Indicates that a ray misses all geometry within a scene, or specified region of a scene.
Visit - Indicates the child volumes a ray will traverse.
Exceptions - Includes various types of exception handlers (e.g., invoked for various error conditions).

In one embodiment the ray tracing cores 372 may be adapted to accelerate general-purpose compute operations using computational techniques that are analogous to ray intersection tests. A compute framework can be provided that enables shader programs to be compiled into low level instructions and/or primitives that perform general-purpose compute operations via the ray tracing cores. Exemplary computational problems that can benefit from compute operations performed on the ray tracing cores 372 include computations involving beam, wave, ray, or particle propagation within a coordinate space. Interactions associated with that propagation can be computed relative to a geometry or mesh within the coordinate space. For example, computations associated with electromagnetic signal propagation through an environment can be accelerated via the use of instructions or primitives that are executed via the ray tracing cores. Diffraction and reflection of the signals by objects in the environment can be computed as direct ray-tracing analogies.

Ray tracing cores 372 can also be used to perform computations that are not directly analogous to ray tracing. For example, mesh projection, mesh refinement, and volume sampling computations can be accelerated using the ray tracing cores 372. Generic coordinate space calculations, such as nearest neighbor calculations can also be performed. For example, the set of points near a given point can be discovered by defining a bounding box in the coordinate space around the point. BVH and ray probe logic within the ray tracing cores 372 can then be used to determine the set of point intersections within the bounding box. The intersections constitute the origin point and the nearest neighbors to that origin point. Computations that are performed using the ray tracing cores 372 can be performed in parallel with computations performed on the graphics cores 370 and tensor cores 371. A shader compiler can be configured to compile a compute shader or other general-purpose graphics processing program into low level primitives that can be parallelized across the graphics cores 370, tensor cores 371, and ray tracing cores 372.

### Techniques for GPU to Host Processor Interconnection

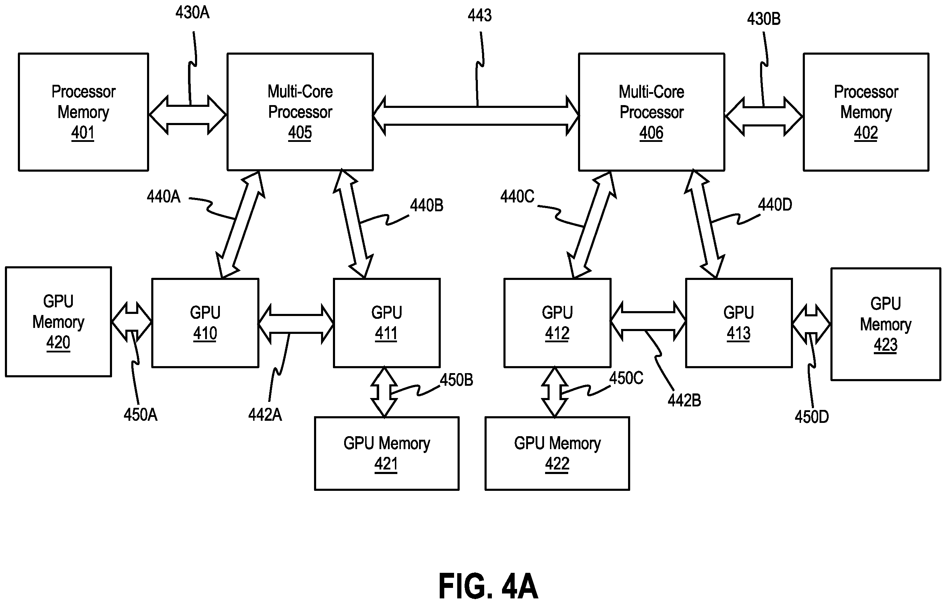

**FIG. 4A** illustrates an exemplary architecture in which a plurality of GPUs 410-413, e.g., such as the parallel processor 200 shown in FIG. 2A, are communicatively coupled to a plurality of multi-core processors 405-406 over high-speed links 440A-440D (e.g., buses, point-to-point interconnects, etc.). The high-speed links 440A-440D may support a communication throughput of 4GB/s, 30GB/s, 80GB/s or higher, depending on the implementation. Various interconnect protocols may be used including, but not limited to, PCIe 4.0, PCIe 5.0, PCIe 6.0, and various NVLink and NVlink-C2C (Chip-to-Chip) interconnect protocols (e.g., NVLink v5). However, the underlying principles described herein are not limited to any particular communication protocol or throughput.

Two or more of the GPUs 410-413 may be interconnected over high-speed links 442A-442B, which may be implemented using the same or different protocols/links than those used for high-speed links 440A-440D. Similarly, two or more of the multi-core processors 405-406 may be connected over high-speed link 443 which may be symmetric multi-processor (SMP) buses operating at 20GB/s, 30GB/s, 120GB/s or lower or higher speeds. Alternatively, all communication between the various system components shown in **FIG. 4A** may be accomplished using the same protocols/links (e.g., over a common interconnection fabric). As mentioned, however, the underlying principles described herein are not limited to any particular type of interconnect technology.

Each of multi-core processor 405 and multi-core processor 406 may be communicatively coupled to a processor memory 401-402, via memory interconnects 430A-430B, respectively, and each GPU 410-413 is communicatively coupled to GPU memory 420-423 over GPU memory interconnects 450A-450D, respectively. The memory interconnects 430A-430B and 450A-450D may utilize the same or different memory access technologies. By way of example, and not limitation, the processor memories 401-402 and GPU memories 420-423 may be volatile memories such as dynamic random-access memories (DRAMs) (including stacked DRAMs), Graphics DDR SDRAM (GDDR) (e.g., GDDR5, GDDR6), or High Bandwidth Memory (HBM) and/or may be non-volatile memories such as 3D XPoint/Optane or Nano-Ram. For example, some portion of the memories may be volatile memory and another portion may be non-volatile memory (e.g., using a two-level memory (2LM) hierarchy). A memory subsystem as described herein may be compatible with a number of memory technologies, such as Double Data Rate versions released by JEDEC (Joint Electronic Device Engineering Council).

As described below, although the various processors 405-406 and GPUs 410-413 may be physically coupled to particular processor memory 401-402 and GPU memory 420-423, respectively, a unified memory architecture may be implemented in which the same virtual system address space (also referred to as the "effective address" space) is distributed among all of the various physical memories. For example, processor memories 401-402 may each comprise 64GB of the system memory address space and GPU memories 420-423 may each comprise 32GB of the system memory address space (resulting in a total of 256GB addressable memory in this example).

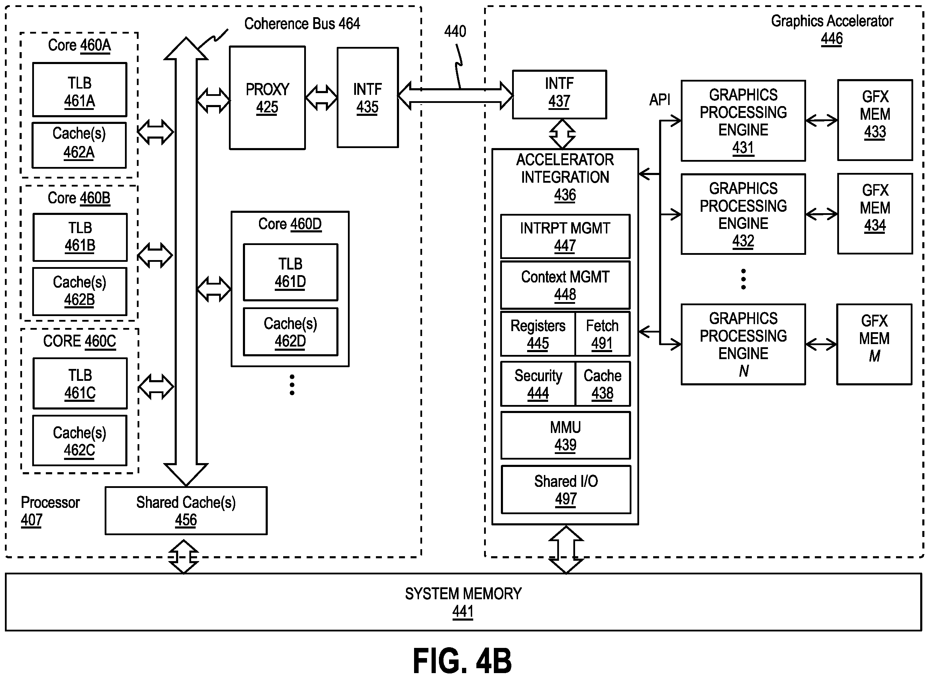

**FIG. 4B** illustrates additional optional details for an interconnection between a processor 407 and a graphics accelerator 446. The graphics accelerator 446 may include one or more GPU chips integrated on a line card which is coupled to the processor 407 via the high-speed link 440. Alternatively, the graphics accelerator 446 may be integrated on the same package or chip as the processor 407. The processor 407 includes a plurality of cores 460A-460D, each with a translation lookaside buffer 461A-461D and one or more caches 462A-462D. The cores may include various other components for executing instructions and processing data which are not illustrated to avoid obscuring the underlying principles of the components described herein (e.g., instruction fetch units, branch prediction units, decoders, execution units, reorder buffers, etc.). The caches 462A-462D may comprise level 1 (L1) and level 2 (L2) caches. In addition, one or more shared cache(s) 456 may be included in the caching hierarchy and shared by sets of the cores 460A-460D. For example, one embodiment of the processor 407 includes 24 cores, each with its own L1 cache, twelve shared L2 caches, and twelve shared L3 caches. In this embodiment, one of the L2 and L3 caches are shared by two adjacent cores. The processor 407 connects with system memory 441, which may include processor memories 401-402.

Coherency is maintained for data and instructions stored in the various caches 462A-462D, shared cache(s) 456 and system memory 441 via inter-core communication over a coherence bus 464. For example, each cache may have cache coherency logic/circuitry associated therewith to communicate to over the coherence bus 464 in response to detected reads or writes to particular cache lines. In one implementation, a cache snooping protocol is implemented over the coherence bus 464 to snoop cache accesses. Cache snooping/coherency techniques are well understood by those of skill in the art and will not be described in detail here to avoid obscuring the underlying principles described herein. A proxy circuit 425 may be provided that communicatively couples the graphics accelerator 446 to the coherence bus 464, allowing the graphics accelerator 446 to participate in the cache coherence protocol as a peer of the cores. In particular, an interface 435 provides connectivity to the proxy circuit 425 over high-speed link 440 (e.g., a PCIe bus, NVLink, etc.) and an interface 437 connects the graphics accelerator 446 to the high-speed link 440.

In one implementation, the interface 437 couples with an accelerator integration circuit 436 that provides cache management, memory access, context management, and interrupt management services on behalf of graphics processing engines 431, 432, ..., N of the graphics accelerator 446. The graphics processing engines 431, 432, ..., N may each comprise a separate graphics processing unit (GPU). Alternatively, the graphics processing engines 431, 432, ..., N may comprise different types of graphics processing engines within a GPU such as graphics execution units, media processing engines (e.g., video encoders/decoders), samplers, and block image transfer (BLIT) engines. In other words, the graphics accelerator may include graphics processing engines 431-432, ..., N of a single GPU or the graphics processing engines 431-432, ..., N may be associated with multiple GPUs integrated on a common package, line card, or chip. The graphics processing engines 431-432, ..., N may be configured with any graphics processor or compute accelerator architecture described herein. Work to be performed by the graphics processing engines 431, 432 can be specified via work descriptors that provide an indication of the work to be done by the graphics accelerator 446.

The accelerator integration circuit 436 may include a memory management unit (MMU 439) for performing various memory management functions such as virtual-to-physical memory translations (also referred to as effective-to-real memory translations) and memory access protocols for accessing the system memory 441. The MMU 439 may also include a translation lookaside buffer (TLB) (not shown) for caching the virtual/effective to physical/real address translations. In one implementation, a cache 438 stores commands and data for efficient access by the graphics processing engines 431, 432, ..., N. The data stored in cache 438 and graphics memories 433-434, ..., M may be kept coherent with the core caches 462A-462D, shared cache(s) 456 and system memory 441. As mentioned, this may be accomplished via a proxy circuit 425 which takes part in the cache coherency mechanism on behalf of the cache 438 and graphics memories 433-434, ..., M (e.g., sending updates to the cache 438 related to modifications/accesses of cache lines on processor caches 462A-462D, shared cache(s) 456 and receiving updates from the cache 438).

Registers 445 store context data for threads executed by the graphics processing engines 431-432, ..., N and a context management circuit 448 manages the thread contexts. For example, the context management circuit 448 may perform save and restore operations to save and restore contexts of the various threads during contexts switches (e.g., where a first thread is saved and a second thread is restored so that the second thread can be executed by a graphics processing engine). For example, on a context switch, the context management circuit 448 may store current register values to a designated region in memory (e.g., identified by a context pointer). It may then restore the register values when returning to the context. An interrupt management circuit 447, for example, may receive and processes interrupts received from system devices.

In one implementation, virtual/effective addresses from a graphics processing engine are translated to real/physical addresses in system memory 441 by the MMU 439. Optionally, the accelerator integration circuit 436 supports multiple (e.g., 4, 8, 16) graphics accelerators 446 and/or other accelerator devices. The graphics accelerator 446 may be dedicated to a single application executed on the processor 407 or may be shared between multiple applications. Optionally, a virtualized graphics execution environment is provided in which the resources of the graphics processing engines 431-432, ..., N are shared with multiple applications, virtual machines (VMs), or containers. The resources may be subdivided into "slices" which are allocated to different VMs and/or applications based on the processing requirements and priorities associated with the VMs and/or applications, or based on a pre-determined partitioning profile for a graphics accelerator 446. VMs and containers can be used interchangeably herein.

A virtual machine (VM) can be software that runs an operating system and one or more applications. A VM can be defined by specification, configuration files, virtual disk file, non-volatile random-access memory (NVRAM) setting file, and the log file and is backed by the physical resources of a host computing platform. A VM can include an operating system (OS) or application environment that is installed on software, which imitates dedicated hardware. The end user has the same experience on a virtual machine as they would have on dedicated hardware. Specialized software, called a hypervisor, emulates the PC client or server's CPU, memory, hard disk, network, and other hardware resources completely, enabling virtual machines to share the resources. The hypervisor can emulate multiple virtual hardware platforms that are isolated from each other, allowing virtual machines to run Linux^{®}, Windows^{®} Server, VMware ESXi, and other operating systems on the same underlying physical host.

A container can be a software package of applications, configurations, and dependencies so the applications run reliably on one computing environment to another. Containers can share an operating system installed on the server platform and run as isolated processes. A container can be a software package that contains everything the software needs to run such as system tools, libraries, and settings. Containers are not installed like traditional software programs, which allows them to be isolated from the other software and the operating system itself. The isolated nature of containers provides several benefits. First, the software in a container will run the same in different environments. For example, a container that includes PHP and MySQL can run identically on both a Linux^{®} computer and a Windows^{®} machine. Second, containers provide added security since the software will not affect the host operating system. While an installed application may alter system settings and modify resources, such as the Windows registry, a container can only modify settings within the container.

Thus, the accelerator integration circuit 436 acts as a bridge to the system for the graphics accelerator 446 and provides address translation and system memory cache services. In one embodiment, to facilitate the bridging functionality, the accelerator integration circuit 436 may also include shared I/O 497 (e.g., PCIe, USB, or others) and hardware to enable system control of voltage, clocking, performance, thermals, and security. The shared I/O 497 may utilize separate physical connections or may traverse the high-speed link 440. In addition, the accelerator integration circuit 436 may provide virtualization facilities for the host processor to manage virtualization of the graphics processing engines, interrupts, and memory management.

Because hardware resources of the graphics processing engines 431-432, ..., N are mapped explicitly to the real address space seen by the processor 407, any host processor can address these resources directly using an effective address value. One optional function of the accelerator integration circuit 436 is the physical separation of the graphics processing engines 431-432, ..., N so that they appear to the system as independent units. In one embodiment, the accelerator integration circuit 436 includes security circuitry 444 that enables configurable cryptographic isolation of data associated with each slice of resources. Different slices can be associated with different security domains, such that data associated with the various security domains are encrypted using different cryptographic keys. In one embodiment, the security domains of the graphics accelerator 446 can be integrated into trusted execution environments supported by the processor 407. In one embodiment, secure I/O capabilities can be enabled that allow each security domain to be presented as a separate trusted I/O device, which enables support for trusted DMA and MMIO operations.

One or more graphics memories 433-434, ... , M may be coupled to each of the graphics processing engines 431-432, ..., N, respectively. The graphics memories 433-434, ... M store instructions and data being processed by each of the graphics processing engines 431-432, ..., N. The graphics memories 433-434, ..., M may be volatile memories such as DRAMs (including stacked DRAMs), GDDR memory (e.g., GDDR5, GDDR6), or HBM, and/or may be non-volatile memories such as 3D XPoint/Optane, Samsung Z-NAND, or Nano-Ram.

To reduce data traffic over the high-speed link 440, biasing techniques may be used to ensure that the data stored in graphics memories 433-434, ..., M is data which will be used most frequently by the graphics processing engines 431-432, ..., N and preferably not used by the cores 460A-460D (at least not frequently). Similarly, the biasing mechanism attempts to keep data needed by the cores (and preferably not the graphics processing engines 431-432, ..., N) within the caches 462A-462D, shared cache(s) 456 and the system memory 441.

In an alternative variant, the accelerator integration circuit 436 is integrated within the processor 407 and the graphics processing engines 431-432, ..., N communicate over the high-speed link 440 to the accelerator integration circuit 436 via interface 437 and interface 435 (which, again, may be utilize any form of bus, fabric, or interface protocol). In this variant, the accelerator integration circuit 436 performs the same operations as those described above.

The embodiments described may support different programming models including a dedicated-process programming model (no graphics accelerator virtualization) and shared programming models (with virtualization). The latter may include programming models which are controlled by the accelerator integration circuit 436 and programming models which are controlled by the graphics accelerator 446. In the embodiments of the dedicated process model, graphics processing engines 431, 432, ... N may be dedicated to a single application or process under a single operating system. The single application can funnel other application requests to the graphics processing engines 431, 432, ... N, providing virtualization within a VM/partition. In the dedicated-process programming models, the graphics processing engines 431,432, ..., N, may be shared by multiple VM/application partitions. The shared models require a system hypervisor to virtualize the graphics processing engines 431-432, ..., N to allow access by each operating system. For single-partition systems without a hypervisor, the graphics processing engines 431-432, ..., N are owned by the operating system. In both cases, the operating system can virtualize the graphics processing engines 431-432, ..., N to provide access to each process or application. For the shared programming model, the graphics accelerator 446 or individual graphics processing engines 431-432, ..., N selects a process element using a process handle. The process elements may be stored in system memory 441 and be addressable using the effective address to real address translation techniques described herein. The process handle may be an implementation-specific value provided to the host process when registering its context with the graphics processing engines 431-432, ..., N, which can be performed by the host process by calling system software to add the process element to the process element linked list. The lower 16-bits of the process handle may be the offset of the process element within the process element linked list.

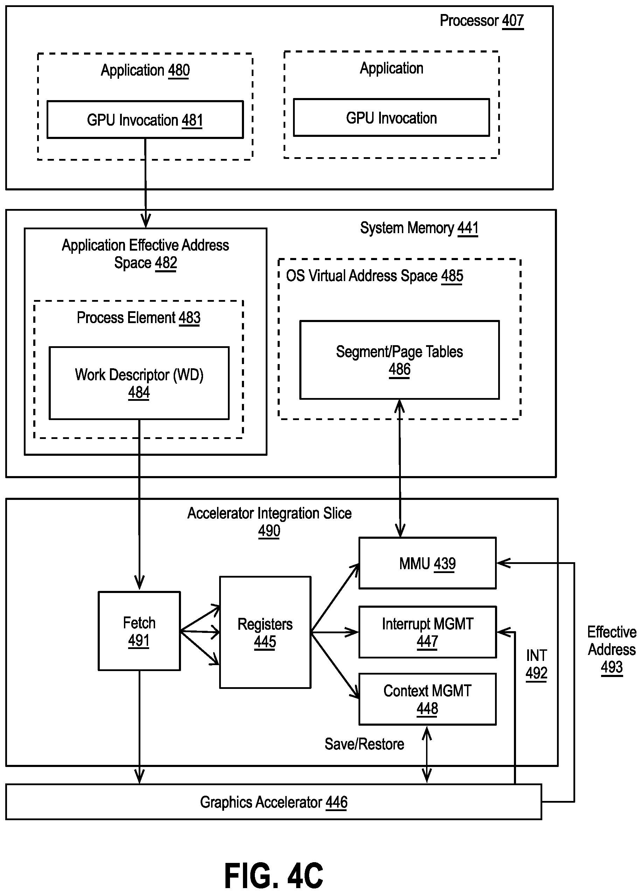

**FIG. 4C** illustrates an accelerator integration slice 490. As used herein, a "slice" comprises a specified portion of the processing resources of the accelerator integration circuit 436. The application's address space 482 within system memory 441 stores process elements 483. The process elements 483 may be stored in response to GPU invocations 481 from an application 480 executed on the processor 407. A process element 483 contains the process state for the application 480. A work descriptor (WD 484) contained in the process element 483 can be a single job requested by an application or may contain a pointer to a queue of jobs. In the latter case, the WD 484 is a pointer to the job request queue in the application's address space 482.

The graphics accelerator 446 and/or the individual graphics processing engines 431-432, ..., N can be shared by all or a subset of the processes in the system. For example, the technologies described herein may include an infrastructure for setting up the process state and sending a WD 484 to a graphics accelerator 446 to start a job in a virtualized environment.

In one implementation, the dedicated-process programming model is implementation-specific. In this model, a single process owns the graphics accelerator 446 or an individual graphics processing engine (e.g., graphics processing engine 431). Because the graphics accelerator 446 is owned by a single process, the hypervisor initializes the accelerator integration circuit 436 for the owning partition and the operating system initializes the accelerator integration circuit 436 for the owning process at the time when the graphics accelerator 446 is assigned.

In operation, the fetch unit 491 in the accelerator integration slice 490 fetches a WD 484 to be processed. The WD 484 includes the indication of work to be done by one or more graphics processing engines of the graphics accelerator 446. Data from the WD 484 may be stored in registers 445 and used by the MMU 439, interrupt management circuit 447 and/or context management circuit 448 as illustrated. For example, the MMU 439 may include segment/page walk circuitry for accessing segment/page tables 486 within the OS virtual address space 485. The interrupt management circuit 447 may process interrupt events 492 received from the graphics accelerator 446. When performing graphics operations, an effective address 493 generated by a graphics processing engine 431-432, ..., N is translated to a real address by the MMU 439.

The registers 445 may be duplicated for each graphics processing engine 431-432, ..., N and/or graphics accelerator 446 and may be initialized by the hypervisor or operating system. Each of these duplicated registers may be included in an accelerator integration slice 490. In one embodiment, each graphics processing engine 431-432, ..., N may be presented to the hypervisor 496 as a distinct graphics processor device. Quality of Service (QoS) settings can be configured for clients of a specific graphics processing engine 431-432, ..., N. Cryptographic and physical data isolation between the clients of each engine can be enabled via isolated memory access paths and automatic data encryption for each client. Exemplary registers that may be initialized by the hypervisor are shown in **Table 1.**

**Table 1 - Hypervisor Initialized Registers**

| | |
|---|---|
| 1 | Slice Control Register |
| 2 | Real Address (RA) Scheduled Processes Area Pointer |
| 3 | Authority Mask Override Register |
| 4 | Interrupt Vector Table Entry Offset |
| 5 | Interrupt Vector Table Entry Limit |
| 6 | State Register |
| 7 | Logical Partition ID |
| 8 | Real address (RA) Hypervisor Accelerator Utilization Record Pointer |
| 9 | Storage Description Register |

Exemplary registers that may be initialized by the operating system are shown in **Table 2.**

**Table 2 - Operating System Initialized Registers**

| | |
|---|---|
| 1 | Process and Thread Identification |
| 2 | Effective Address (EA) Context Save/Restore Pointer |
| 3 | Virtual Address (VA) Accelerator Utilization Record Pointer |
| 4 | Virtual Address (VA) Storage Segment Table Pointer |
| 5 | Authority Mask |
| 6 | Work descriptor |

Each WD 484 may be specific to a particular graphics accelerator 446 and/or graphics processing engine 431-432, ..., N. It contains all the information a graphics processing engine requires to do its work, or it can be a pointer to a memory location where the application has set up a command queue of work to be completed.

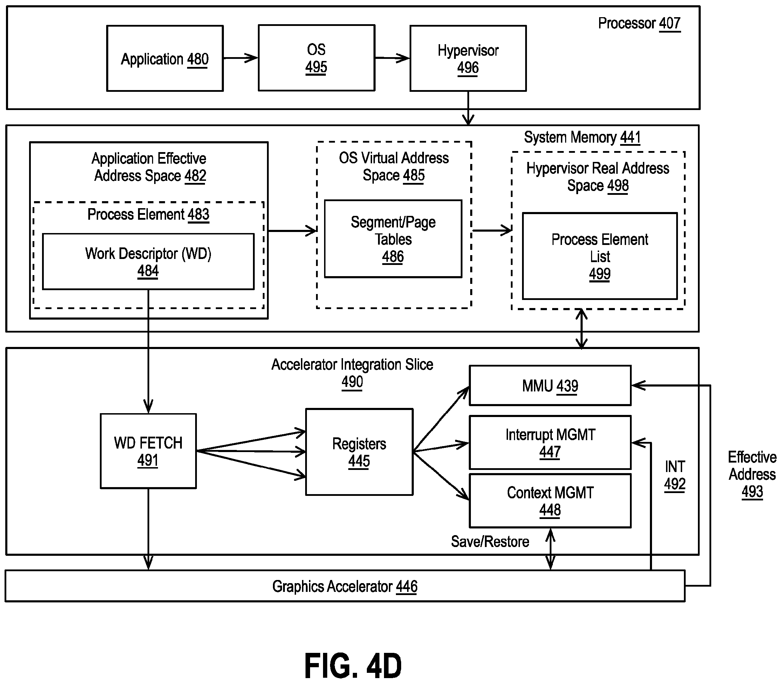

**FIG. 4D** illustrates additional optional details of a shared model. It includes a hypervisor real address space 498 in which a process element list 499 is stored. The hypervisor real address space 498 is accessible via a hypervisor 496 which virtualizes the graphics processing engines for the operating system 495.

The shared programming models allow for all or a subset of processes from all or a subset of partitions in the system to use a graphics accelerator 446. There are two programming models where the graphics accelerator 446 is shared by multiple processes and partitions: time-sliced shared and graphics directed shared.

In this model, the hypervisor 496 owns the graphics accelerator 446 and makes its function available to all operating systems 495. For a graphics accelerator 446 to support virtualization by the hypervisor 496, the graphics accelerator 446 may adhere to the following requirements: 1) An application's job request must be autonomous (that is, the state does not need to be maintained between jobs), or the graphics accelerator 446 must provide a context save and restore mechanism. 2) An application's job request is guaranteed by the graphics accelerator 446 to complete in a specified amount of time, including any translation faults, or the graphics accelerator 446 provides the ability to preempt the processing of the job. 3) The graphics accelerator 446 must be guaranteed fairness between processes when operating in the directed shared programming model.

For the directed shared model, the application 480 may be required to make an operating system 495 system call with a graphics accelerator 446 type, a work descriptor (WD), an authority mask register (AMR) value, and a context save/restore area pointer (CSRP). The graphics accelerator 446 type describes the targeted acceleration function for the system call. The graphics accelerator 446 type may be a system-specific value. The WD is formatted specifically for the graphics accelerator 446 and can be in the form of a graphics accelerator 446 command, an effective address pointer to a user-defined structure, an effective address pointer to a queue of commands, or any other data structure to describe the work to be done by the graphics accelerator 446. In one embodiment, the AMR value is the AMR state to use for the current process. The value passed to the operating system is similar to an application setting the AMR. If the accelerator integration circuit 436 and graphics accelerator 446 implementations do not support a User Authority Mask Override Register (UAMOR), the operating system may apply the current UAMOR value to the AMR value before passing the AMR in the hypervisor call. The hypervisor 496 may optionally apply the current Authority Mask Override Register (AMOR) value before placing the AMR into the process element 483. The CSRP may be one of the registers 445 containing the effective address of an area in the application's address space 482 for the graphics accelerator 446 to save and restore the context state. This pointer is optional if no state is required to be saved between jobs or when a job is preempted. The context save/restore area may be pinned system memory.

Upon receiving the system call, the operating system 495 may verify that the application 480 has registered and been given the authority to use the graphics accelerator 446. The operating system 495 then calls the hypervisor 496 with the information shown in **Table 3.**

**Table 3 - OS to Hypervisor Call Parameters**

| | |
|---|---|
| 1 | A work descriptor (WD) |
| 2 | An Authority Mask Register (AMR) value (potentially masked). |
| 3 | An effective address (EA) Context Save/Restore Area Pointer (CSRP) |
| 4 | A process ID (PID) and optional thread ID (TID) |
| 5 | A virtual address (VA) accelerator utilization record pointer (AURP) |
| 6 | The virtual address of the storage segment table pointer (SSTP) |
| 7 | A logical interrupt service number (LISN) |

Upon receiving the hypervisor call, the hypervisor 496 verifies that the operating system 495 has registered and been given the authority to use the graphics accelerator 446. The hypervisor 496 then puts the process element 483 into the process element linked list for the corresponding graphics accelerator 446 type. The process element may include the information shown in **Table 4.**

**Table 4 - Process Element Information**

| | |
|---|---|
| 1 | A work descriptor (WD) |
| 2 | An Authority Mask Register (AMR) value (potentially masked). |
| 3 | An effective address (EA) Context Save/Restore Area Pointer (CSRP) |
| 4 | A process ID (PID) and optional thread ID (TID) |
| 5 | A virtual address (VA) accelerator utilization record pointer (AURP) |
| 6 | The virtual address of the storage segment table pointer (SSTP) |
| 7 | A logical interrupt service number (LISN) |
| 8 | Interrupt vector table, derived from the hypervisor call parameters. |
| 9 | A state register (SR) value |
| 10 | A logical partition ID (LPID) |
| 11 | A real address (RA) hypervisor accelerator utilization record pointer |
| 12 | The Storage Descriptor Register (SDR) |

The hypervisor may initialize the registers 445 of accelerator integration slice 490.

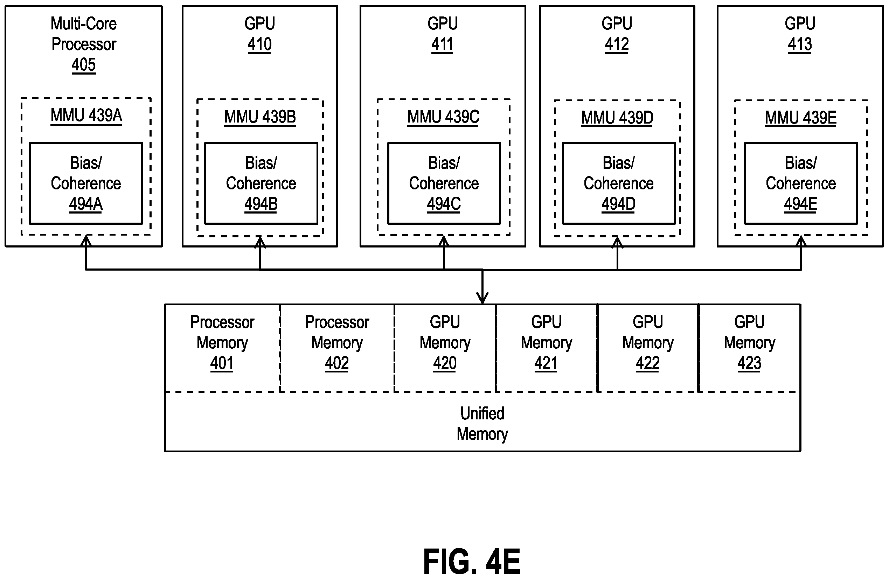

As illustrated in **FIG. 4E****,** in one optional implementation a unified memory addressable via a common virtual memory address space used to access the physical processor memories 401-402 and GPU memories 420-423 is employed. In this implementation, operations executed on the GPUs 410-413 utilize the same virtual/effective memory address space to access the processors memories 401-402 and vice versa, thereby simplifying programmability. A first portion of the virtual/effective address space may be allocated to the processor memory 401, a second portion to the second processor memory 402, a third portion to the GPU memory 420, and so on. The entire virtual/effective memory space (sometimes referred to as the effective address space) may thereby be distributed across each of the processor memories 401-402 and GPU memories 420-423, allowing any processor or GPU to access any physical memory with a virtual address mapped to that memory.

Bias/coherence management circuitry 494A-494E within one or more of the MMUs 439A-439E may be provided that ensures cache coherence between the caches of the host processors (e.g., multi-core processor 405) and the GPUs 410-413 and implements biasing techniques indicating the physical memories in which certain types of data should be stored. While multiple instances of bias/coherence management circuitry 494A-494E are illustrated in **FIG. 4E****,** the bias/coherence circuitry may be implemented within the MMU of one or more host processors and/or within the accelerator integration circuit 436.

The GPU-attached memory 420-423 may be mapped as part of system memory and accessed using shared virtual memory (SVM) technology, but without suffering the typical performance drawbacks associated with full system cache coherence. The ability to GPU-attached memory 420-423 to be accessed as system memory without onerous cache coherence overhead provides a beneficial operating environment for GPU offload. This arrangement allows the host processor software to set up operands and access computation results, without the overhead of tradition I/O DMA data copies. Such traditional copies involve driver calls, interrupts and memory mapped I/O (MMIO) accesses that are all inefficient relative to simple memory accesses. At the same time, the ability to access GPU attached memory 420-423 without cache coherence overheads can be critical to the execution time of an offloaded computation. In cases with substantial streaming write memory traffic, for example, cache coherence overhead can significantly reduce the effective write bandwidth seen by a GPU 410-413. The efficiency of operand setup, the efficiency of results access, and the efficiency of GPU computation all play a role in determining the effectiveness of GPU offload.

A selection between GPU bias and host processor bias may be driven by a bias tracker data structure. A bias table may be used, for example, which may be a page-granular structure (i.e., controlled at the granularity of a memory page) that includes 1 or 2 bits per GPU-attached memory page. The bias table may be implemented in a stolen memory range of one or more GPU-attached memories 420-423, with or without a bias cache in the GPU 410-413 (e.g., to cache frequently/recently used entries of the bias table). Alternatively, the entire bias table may be maintained within the GPU.

In one implementation, the bias table entry associated with each access to the GPU-attached memory 420-423 is accessed prior to the actual access to the GPU memory, causing the following operations. First, local requests from the GPU 410-413 that find their page in GPU bias are forwarded directly to a corresponding GPU memory 420-423. Local requests from the GPU that find their page in host bias are forwarded to the processor (e.g., over a high-speed link as discussed above). Optionally, requests from the host processor that find the requested page in host processor bias complete the request like a normal memory read. Alternatively, requests directed to a GPU-biased page may be forwarded to the GPU 410-413. The GPU may then transition the page to a host processor bias if it is not currently using the page. The bias state of a page can be changed either by a software-based mechanism, a hardware-assisted software-based mechanism, or, for a limited set of cases, a purely hardware-based mechanism. One mechanism for changing the bias state employs an API call (e.g., OpenCL), which, in turn, calls the GPU's device driver which, in turn, sends a message (or enqueues a command descriptor) to the GPU directing it to change the bias state and, for some transitions, perform a cache flushing operation in the host. The cache flushing operation is required for a transition from host processor bias to GPU bias but is not required for the opposite transition.

Cache coherency may be maintained by temporarily rendering GPU-biased pages uncacheable by the host processor. To access these pages, the host processor may request access from the GPU 410 which may or may not grant access right away, depending on the implementation. Thus, to reduce communication between the host processor and GPU 410 it is beneficial to ensure that GPU-biased pages are those which are required by the GPU but not the host processor and vice versa.

### Graphics Processing Pipeline

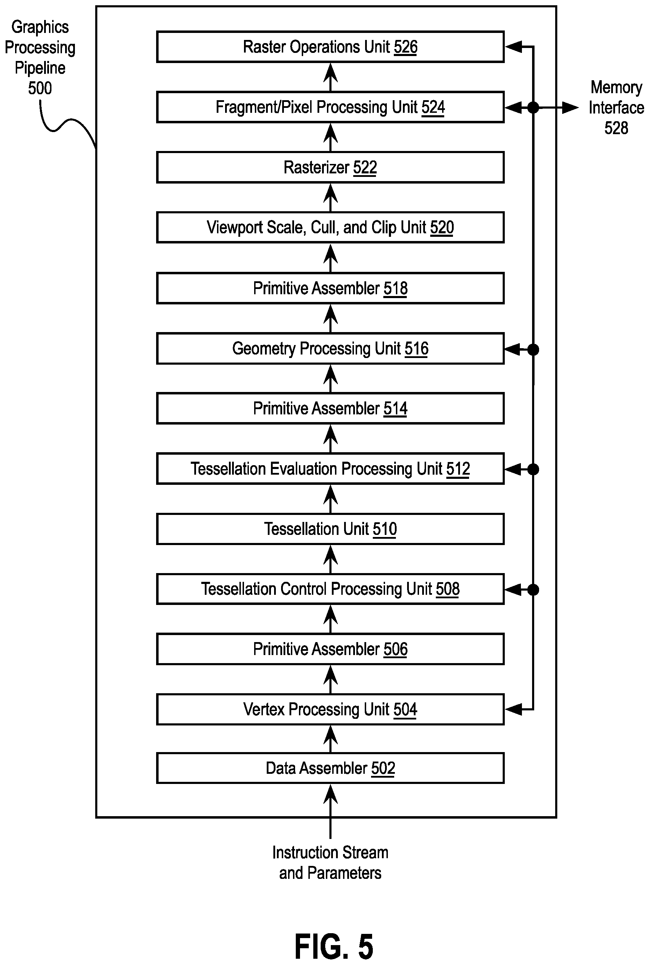

**FIG. 5** illustrates a graphics processing pipeline 500. A graphics multiprocessor, such as graphics multiprocessor 234 as in FIG. 2D or graphics multiprocessor 235 of FIG. 2E can implement the graphics processing pipeline 500. The graphics multiprocessor can be included within the parallel processing subsystems as described herein, such as the parallel processor 200 of FIG. 2A, which may be related to the parallel processor(s) 112 of FIG. 1 and may be used in place of one of those. The various parallel processing systems can implement the graphics processing pipeline 500 via one or more instances of the parallel processing unit (e.g., parallel processing unit 202 of FIG. 2A) as described herein. For example, a shader unit (e.g., graphics multiprocessor 234 of FIG. 2C) may be configured to perform the functions of one or more of a vertex processing unit 504, a tessellation control processing unit 508, a tessellation evaluation processing unit 512, a geometry processing unit 516, and a fragment/pixel processing unit 524. The functions of data assembler 502, primitive assemblers 506, 514, 518, tessellation unit 510, rasterizer 522, and raster operations unit 526 may also be performed by other processing engines within a processing cluster (e.g., processing cluster 214 of FIG. 2A) and a corresponding partition unit (e.g., partition unit 220A-220N of FIG. 2A). The graphics processing pipeline 500 may also be implemented using dedicated processing units for one or more functions. It is also possible that one or more portions of the graphics processing pipeline 500 are performed by parallel processing logic within a general-purpose processor (e.g., CPU). Optionally, one or more portions of the graphics processing pipeline 500 can access on-chip memory (e.g., parallel processor memory 222 as in FIG. 2A) via a memory interface 528, which may be an instance of the memory interface 218 of FIG. 2A. The graphics processing pipeline 500 may also be implemented via a multi-core group 365A as in FIG. 3.

The data assembler 502 is a processing unit that may collect vertex data for surfaces and primitives. The data assembler 502 then outputs the vertex data, including the vertex attributes, to the vertex processing unit 504. The vertex processing unit 504 is a programmable execution unit that executes vertex shader programs, lighting and transforming vertex data as specified by the vertex shader programs. The vertex processing unit 504 reads data that is stored in cache, local or system memory for use in processing the vertex data and may be programmed to transform the vertex data from an object-based coordinate representation to a world space coordinate space or a normalized device coordinate space.

A first instance of a primitive assembler 506 receives vertex attributes from the vertex processing unit 504. The primitive assembler 506 readings stored vertex attributes as needed and constructs graphics primitives for processing by tessellation control processing unit 508. The graphics primitives include triangles, line segments, points, patches, and so forth, as supported by various graphics processing application programming interfaces (APIs).

The tessellation control processing unit 508 treats the input vertices as control points for a geometric patch. The control points are transformed from an input representation from the patch (e.g., the patch's bases) to a representation that is suitable for use in surface evaluation by the tessellation evaluation processing unit 512. The tessellation control processing unit 508 can also compute tessellation factors for edges of geometric patches. A tessellation factor applies to a single edge and quantifies a view-dependent level of detail associated with the edge. A tessellation unit 510 is configured to receive the tessellation factors for edges of a patch and to tessellate the patch into multiple geometric primitives such as line, triangle, or quadrilateral primitives, which are transmitted to a tessellation evaluation processing unit 512. The tessellation evaluation processing unit 512 operates on parameterized coordinates of the subdivided patch to generate a surface representation and vertex attributes for each vertex associated with the geometric primitives.

A second instance of a primitive assembler 514 receives vertex attributes from the tessellation evaluation processing unit 512, reading stored vertex attributes as needed, and constructs graphics primitives for processing by the geometry processing unit 516. The geometry processing unit 516 is a programmable execution unit that executes geometry shader programs to transform graphics primitives received from primitive assembler 514 as specified by the geometry shader programs. The geometry processing unit 516 may be programmed to subdivide the graphics primitives into one or more new graphics primitives and calculate parameters used to rasterize the new graphics primitives.

The geometry processing unit 516 may be able to add or delete elements in the geometry stream. The geometry processing unit 516 outputs the parameters and vertices specifying new graphics primitives to primitive assembler 518. The primitive assembler 518 receives the parameters and vertices from the geometry processing unit 516 and constructs graphics primitives for processing by a viewport scale, cull, and clip unit 520. The geometry processing unit 516 reads data that is stored in parallel processor memory or system memory for use in processing the geometry data. The viewport scale, cull, and clip unit 520 performs clipping, culling, and viewport scaling and outputs processed graphics primitives to a rasterizer 522.

The rasterizer 522 can perform depth culling and other depth-based optimizations. The rasterizer 522 also performs scan conversion on the new graphics primitives to generate fragments and output those fragments and associated coverage data to the fragment/pixel processing unit 524. The fragment/pixel processing unit 524 is a programmable execution unit that is configured to execute fragment shader programs or pixel shader programs. The fragment/pixel processing unit 524 transforming fragments or pixels received from rasterizer 522, as specified by the fragment or pixel shader programs. For example, the fragment/pixel processing unit 524 may be programmed to perform operations included but not limited to texture mapping, shading, blending, texture correction and perspective correction to produce shaded fragments or pixels that are output to a raster operations unit 526. The fragment/pixel processing unit 524 can read data that is stored in either the parallel processor memory or the system memory for use when processing the fragment data. Fragment or pixel shader programs may be configured to shade at sample, pixel, tile, or other granularities depending on the sampling rate configured for the processing units.

The raster operations unit 526 is a processing unit that performs raster operations including, but not limited to stencil, z-test, blending, and the like, and outputs pixel data as processed graphics data to be stored in graphics memory (e.g., parallel processor memory 222 as in FIG. 2A, and/or system memory 104 as in FIG 1), to be displayed on the one or more display device(s) 110A-110B or for further processing by one of the one or more processor(s) 102 or parallel processor(s) 112. The raster operations unit 526 may be configured to compress z or color data that is written to memory and decompress z or color data that is read from memory.

### Machine Learning Overview

The architecture described above can be applied to perform training and inference operations using machine learning models. Machine learning has been successful at solving many kinds of tasks. The computations that arise when training and using machine learning algorithms (e.g., neural networks) lend themselves naturally to efficient parallel implementations. Accordingly, parallel processors such as general-purpose graphics processing units (GPGPUs) have played a significant role in the practical implementation of deep neural networks. Parallel graphics processors with single instruction, multiple thread (SIMT) architectures are designed to maximize the amount of parallel processing in the graphics pipeline. In an SIMT architecture, groups of parallel threads attempt to execute program instructions synchronously together as often as possible to increase processing efficiency. The efficiency provided by parallel machine learning algorithm implementations allows the use of high-capacity networks and enables those networks to be trained on larger datasets.

A machine learning algorithm is an algorithm that can learn based on a set of data. For example, machine learning algorithms can be designed to model high-level abstractions within a data set. For example, image recognition algorithms can be used to determine which of several categories to which a given input belong; regression algorithms can output a numerical value given an input; and pattern recognition algorithms can be used to generate translated text or perform text to speech and/or speech recognition.

An exemplary type of machine learning algorithm is a neural network. There are many types of neural networks; a simple type of neural network is a feedforward network. A feedforward network may be implemented as an acyclic graph in which the nodes are arranged in layers. Typically, a feedforward network topology includes an input layer and an output layer that are separated by at least one hidden layer. The hidden layer transforms input received by the input layer into a representation that is useful for generating output in the output layer. The network nodes are fully connected via edges to the nodes in adjacent layers, but there are no edges between nodes within each layer. Data received at the nodes of an input layer of a feedforward network are propagated (i.e., "fed forward") to the nodes of the output layer via an activation function that calculates the states of the nodes of each successive layer in the network based on coefficients ("weights") respectively associated with each of the edges connecting the layers. Depending on the specific model being represented by the algorithm being executed, the output from the neural network algorithm can take various forms.

Before a machine learning algorithm can be used to model a particular problem, the algorithm is trained using a training data set. Training a neural network involves selecting a network topology, using a set of training data representing a problem being modeled by the network, and adjusting the weights until the network model performs with a minimal error for all instances of the training data set. For example, during a supervised learning training process for a neural network, the output produced by the network in response to the input representing an instance in a training data set is compared to the "correct" labeled output for that instance, an error signal representing the difference between the output and the labeled output is calculated, and the weights associated with the connections are adjusted to minimize that error as the error signal is backward propagated through the layers of the network. The network is considered "trained" when the errors for each of the outputs generated from the instances of the training data set are minimized.

The accuracy of a machine learning algorithm can be affected significantly by the quality of the data set used to train the algorithm. The training process can be computationally intensive and may require a significant amount of time on a conventional general-purpose processor. Accordingly, parallel processing hardware is used to train many types of machine learning algorithms. This is particularly useful for optimizing the training of neural networks, as the computations performed in adjusting the coefficients in neural networks lend themselves naturally to parallel implementations. Specifically, many machine learning algorithms and software applications have been adapted to make use of the parallel processing hardware within general-purpose graphics processing devices.

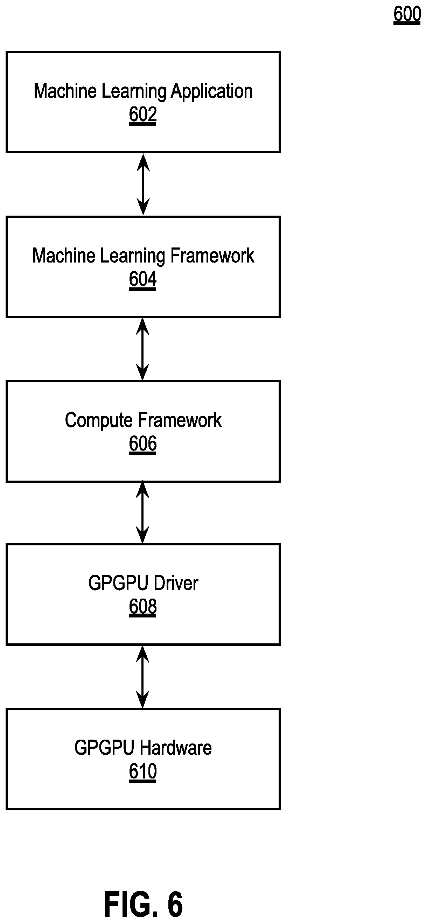

**FIG.** 6 is a generalized diagram of a machine learning software stack 600. A machine learning application 602 is any logic that can be configured to train a neural network using a training dataset or to use a trained deep neural network to implement machine intelligence. The machine learning application 602 can include training and inference functionality for a neural network and/or specialized software that can be used to train a neural network before deployment. The machine learning application 602 can implement any type of machine intelligence including but not limited to image recognition, mapping and localization, autonomous navigation, speech synthesis, medical imaging, or language translation. Example machine learning applications 602 include, but are not limited to, voice-based virtual assistants, image or facial recognition algorithms, autonomous navigation, and the software tools that are used to train the machine learning models used by the machine learning applications 602.

Hardware acceleration for the machine learning application 602 can be enabled via a machine learning framework 604. The machine learning framework 604 can provide a library of machine learning primitives. Machine learning primitives are basic operations that are commonly performed by machine learning algorithms. Without the machine learning framework 604, developers of machine learning algorithms would be required to create and optimize the main computational logic associated with the machine learning algorithm, then re-optimize the computational logic as new parallel processors are developed. Instead, the machine learning application can be configured to perform the necessary computations using the primitives provided by the machine learning framework 604. Exemplary primitives include tensor convolutions, activation functions, and pooling, which are computational operations that are performed while training a convolutional neural network (CNN). The machine learning framework 604 can also provide primitives to implement basic linear algebra subprograms performed by many machine-learning algorithms, such as matrix and vector operations. Examples of a machine learning framework 604 include, but are not limited to, TensorFlow, TensorRT, PyTorch, MXNet, Caffe, and other high-level machine learning frameworks.

The machine learning framework 604 can process input data received from the machine learning application 602 and generate the appropriate input to a compute framework 606. The compute framework 606 can abstract the underlying instructions provided to the GPGPU driver 608 to enable the machine learning framework 604 to take advantage of hardware acceleration via the GPGPU hardware 610 without requiring the machine learning framework 604 to have intimate knowledge of the architecture of the GPGPU hardware 610. Additionally, the compute framework 606 can enable hardware acceleration for the machine learning framework 604 across a variety of types and generations of the GPGPU hardware 610. In one example, compute frameworks 606 can include the CUDA compute framework and associated machine learning libraries, such as the CUDA Deep Neural Network (cuDNN) library. The machine learning software stack 600 can also include communication libraries or frameworks to facilitate multi-GPU and multi-node compute.

### GPGPU Machine Learning Acceleration

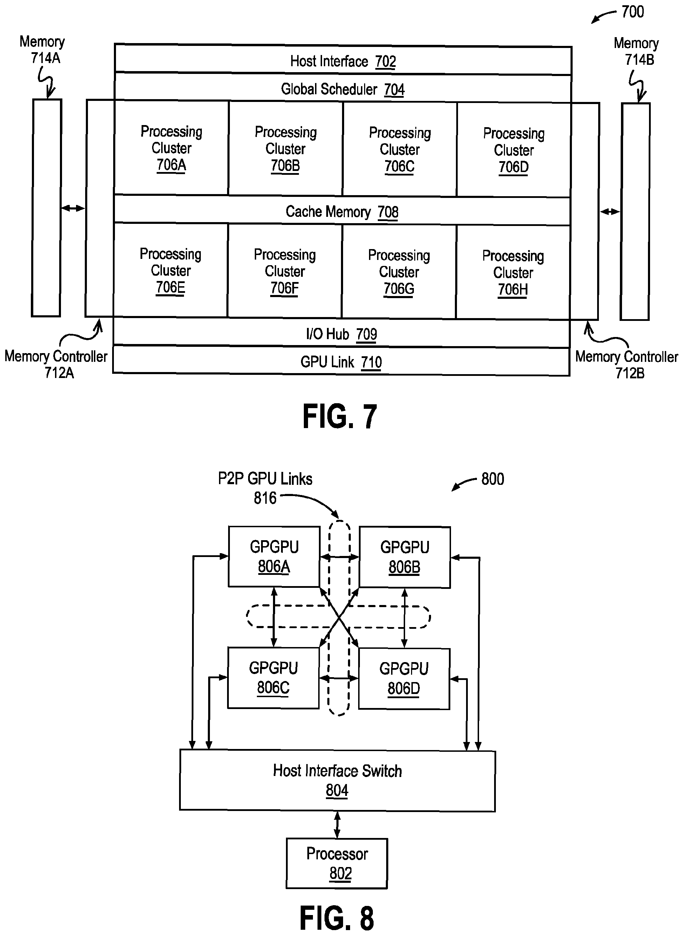

**FIG. 7** illustrates a general-purpose graphics processing unit (GPGPU 700), which may be the parallel processor 200 of FIG. 2A or the parallel processor(s) 112 of FIG. 1. The general-purpose processing unit may be configured to provide support for hardware acceleration of primitives provided by a machine learning framework to accelerate the processing the type of computational workloads associated with training deep neural networks. Additionally, the GPGPU 700 can be linked directly to other instances of the GPGPU to create a multi-GPU cluster to improve training speed for particularly deep neural networks. Primitives are also supported to accelerate inference operations for deployed neural networks.

The GPGPU 700 includes a host interface 702 to enable a connection with a host processor. The host interface 702 may be a PCI Express interface. However, the host interface can also be a vendor specific communications interface or communications fabric. The GPGPU 700 receives commands from the host processor and uses a global scheduler 704 to distribute execution threads associated with those commands to a set of processing clusters 706A-706H. The processing clusters 706A-706H share a cache memory 708. The cache memory 708 can serve as a higher-level cache for cache memories within the processing clusters 706A-706H. The illustrated processing clusters 706A-706H may correspond with processing clusters 214A-214N as in FIG. 2A.

The GPGPU 700 includes memory 714A-714B coupled with the processing clusters 706A-706H via a set of memory controllers 712A-712B. The memory 714A-714B can include various types of memory devices including dynamic random-access memory (DRAM) or graphics random access memory, such as synchronous graphics random access memory (SGRAM), including graphics double data rate (GDDR) memory. The memory 714A-714B may also include 3D stacked memory, including but not limited to high bandwidth memory (HBM).

Each of the processing clusters 706A-706H may include a set of graphics multiprocessors, such as the graphics multiprocessor 234 of FIG. 2D, graphics multiprocessor 235 of FIG. 2E, or may include a multi-core group 365A-365N as in FIG. 3. The graphics multiprocessors of the compute cluster include multiple types of integer and floating-point logic units that can perform computational operations at a range of precisions including suited for machine learning computations. For example, at least a subset of the floating-point units in each of the processing clusters 706A-706H can be configured to perform 16-bit or 32-bit floating-point operations, while a different subset of the floating-point units can be configured to perform 64-bit floating-point operations.

Multiple instances of the GPGPU 700 can be configured to operate as a compute cluster. The communication mechanism used by the compute cluster for synchronization and data exchange varies across embodiments. For example, the multiple instances of the GPGPU 700 communicate over the host interface 702. In one embodiment the GPGPU 700 includes an I/O hub 709 that couples the GPGPU 700 with a GPU link 710 that enables a direct connection to other instances of the GPGPU. The GPU link 710 may be coupled to a dedicated GPU-to-GPU bridge that enables communication and synchronization between multiple instances of the GPGPU 700. Optionally, the GPU link 710 couples with a high-speed interconnect to transmit and receive data to other GPGPUs or parallel processors. The multiple instances of the GPGPU 700 may be located in separate data processing systems and communicate via a network device that is accessible via the host interface 702. The GPU link 710 may be configured to enable a connection to a host processor in addition to or as an alternative to the host interface 702.

While the illustrated configuration of the GPGPU 700 can be configured to train neural networks, an alternate configuration of the GPGPU 700 can be configured for deployment within a high performance or low power inferencing platform. In an inferencing configuration, the GPGPU 700 includes fewer of the processing clusters 706A-706H relative to the training configuration. Additionally, memory technology associated with the memory 714A-714B may differ between inferencing and training configurations. In one embodiment, the inferencing configuration of the GPGPU 700 can support inferencing specific instructions. For example, an inferencing configuration can provide support for one or more 8-bit integer or floating-point dot product instructions, which are commonly used during inferencing operations for deployed neural networks.

**FIG. 8** illustrates a multi-GPU computing system 800. The multi-GPU computing system 800 can include a processor 802 coupled to multiple GPGPUs 806A-806D via a host interface switch 804. The host interface switch 804 may be a PCI express switch device that couples the processor 802 to a PCI express bus over which the processor 802 can communicate with the set of GPGPUs 806A-806D. Each of the multiple GPGPUs 806A-806D can be an instance of the GPGPU 700 of FIG. 7. The GPGPUs 806A-806D can interconnect via a set of high-speed point to point GPU to GPU links (P2P GPU links 816). The high-speed GPU to GPU links can connect to each of the GPGPUs 806A-806D via a dedicated GPU link, such as the GPU link 710 as in FIG. 7. The P2P GPU links 816 enable direct communication between each of the GPGPUs 806A-806D without requiring communication over the host interface bus to which the processor 802 is connected. With GPU-to-GPU traffic directed to the P2P GPU links, the host interface bus remains available for system memory access or to communicate with other instances of the multi-GPU computing system 800, for example, via one or more network devices. While in FIG. 8 the GPGPUs 806A-806D connect to the processor 802 via the host interface switch 804, the processor 802 may alternatively include direct support for the P2P GPU links 816 and connect directly to the GPGPUs 806A-806D. In one embodiment the P2P GPU link 816 enable the multi-GPU computing system 800 to operate as a single logical GPU.

### Machine Learning Neural Network Implementations

The computing architecture described herein can be configured to perform the types of parallel processing that is particularly suited for training and deploying neural networks for machine learning. A neural network can be generalized as a network of functions having a graph relationship. As is well-known in the art, there are a variety of types of neural network implementations used in machine learning. One exemplary type of neural network is the feedforward network, as previously described. A second exemplary type of neural network is the Convolutional Neural Network (CNN), while a third exemplary type of neural network are recurrent neural networks (RNNs).

A CNN is a specialized feedforward neural network for processing data having a known, grid-like topology, such as image data. Accordingly, CNNs are commonly used for compute vision and image recognition applications, but they also may be used for other types of pattern recognition such as speech and language processing. The nodes in the CNN input layer are organized into a set of "filters" (feature detectors inspired by the receptive fields found in the retina), and the output of each set of filters is propagated to nodes in successive layers of the network. The computations for a CNN include applying the convolution mathematical operation to each filter to produce the output of that filter. Convolution is a specialized kind of mathematical operation performed by two functions to produce a third function that is a modified version of one of the two original functions. In convolutional network terminology, the first function to the convolution can be referred to as the input, while the second function can be referred to as the convolution kernel. The output may be referred to as the feature map. The input to a convolution layer can be a multidimensional array of data that defines the various color components of an input image. The convolution kernel can be a multidimensional array of parameters, where the parameters are adapted by the training process for the neural network.

RNNs are a family of feedforward neural networks that include feedback connections between layers. RNNs enable modeling of sequential data by sharing parameter data across different parts of the neural network. The architecture for an RNN includes cycles that represent the influence of a present value of a variable on its own value at a future time, as at least a portion of the output data from the RNN is used as feedback for processing subsequent input in a sequence. This feature makes RNNs particularly useful for language processing due to the variable nature in which language data can be composed.

The figures described below present exemplary feedforward, CNN, and RNN networks, as well as describe a general process for respectively training and deploying each of those types of networks. It will be understood that these descriptions are exemplary and non-limiting as to any specific embodiment described herein and the concepts illustrated can be applied generally to deep neural networks and machine learning techniques in general.

Deep neural networks used in deep learning typically include a front-end network to perform feature recognition coupled to a back-end network which represents a mathematical model that can perform operations (e.g., object classification, speech recognition, etc.) based on the feature representation provided to the model. Deep learning enables machine learning to be performed without requiring hand crafted feature engineering to be performed for the model. Instead, deep neural networks can learn features based on statistical structure or correlation within the input data. The learned features can be provided to a mathematical model that can map detected features to an output. The mathematical model used by the network is generally specialized for the specific task to be performed, and different models will be used to perform different tasks.

Once the neural network is structured, a learning model can be applied to the network to train the network to perform specific tasks. The learning model describes how to adjust the weights within the model to reduce the output error of the network. Backpropagation of errors is a common method used to train neural networks. An input vector is presented to the network for processing. The output of the network is compared to the desired output using a loss function and an error value is calculated for each of the neurons in the output layer. The error values are then propagated backwards until each neuron has an associated error value which roughly represents its contribution to the original output. The network can then learn from those errors using an algorithm, such as the stochastic gradient descent algorithm, to update the weights of the of the neural network.

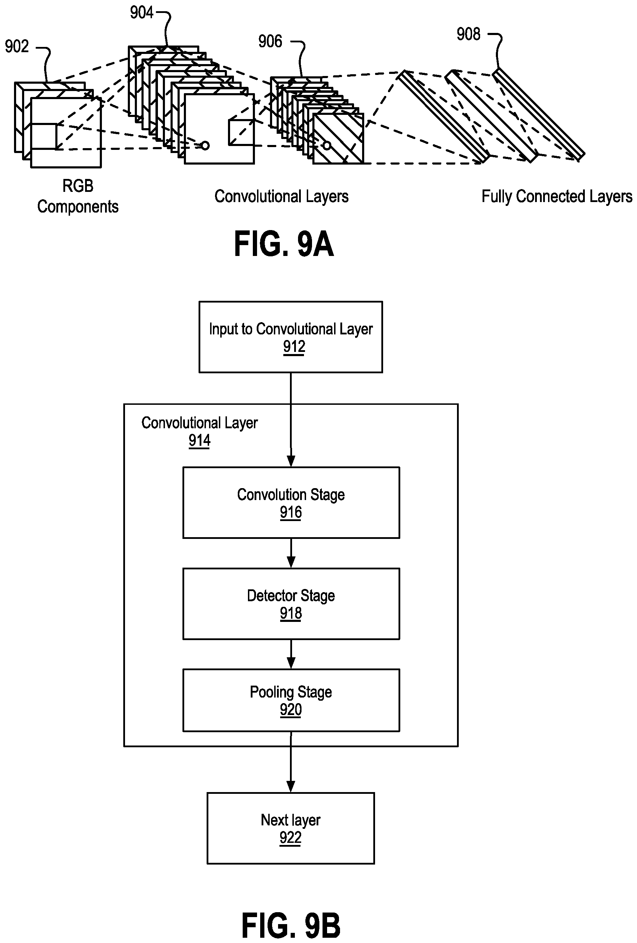

**FIGS. 9A-9B** illustrate an exemplary convolutional neural network. FIG. 9A illustrates various layers within a CNN. As shown in FIG. 9A, an exemplary CNN used to model image processing can receive input 902 describing the red, green, and blue (RGB) components of an input image. The input 902 can be processed by multiple convolutional layers (e.g., first convolutional layer 904, second convolutional layer 906). The output from the multiple convolutional layers may optionally be processed by fully connected layers 908. Neurons in a fully connected layer have full connections to all activations in the previous layer, as previously described for a feedforward network. The output from the fully connected layers 908 can be used to generate an output result from the network. The activations within the fully connected layers 908 can be computed using matrix multiplication instead of convolution. Not all CNN implementations make use of fully connected layers 908. For example, in some implementations the second convolutional layer 906 can generate output for the CNN.

The convolutional layers are sparsely connected, which differs from traditional neural network configuration found in the fully connected layers 908. Traditional neural network layers are fully connected, such that every output unit interacts with every input unit. However, the convolutional layers are sparsely connected because the output of the convolution of a field is input (instead of the respective state value of each of the nodes in the field) to the nodes of the subsequent layer, as illustrated. The kernels associated with the convolutional layers perform convolution operations, the output of which is sent to the next layer. The dimensionality reduction performed within the convolutional layers is one aspect that enables the CNN to scale to process large images.

FIG. 9B illustrates exemplary computation stages within a convolutional layer of a CNN. Input to a convolutional layer 912 of a CNN can be processed in three stages of a convolutional layer 914. The three stages can include a convolution stage 916, a detector stage 918, and a pooling stage 920. The convolutional layer 914 can then output data to a successive convolutional layer. The final convolutional layer of the network can generate output feature map data or provide input to a fully connected layer, for example, to generate a classification value for the input to the CNN.

In the convolution stage 916 performs several convolutions in parallel to produce a set of linear activations. The convolution stage 916 can include an affine transformation, which is any transformation that can be specified as a linear transformation plus a translation. Affine transformations include rotations, translations, scaling, and combinations of these transformations. The convolution stage computes the output of functions (e.g., neurons) that are connected to specific regions in the input, which can be determined as the local region associated with the neuron. The neurons compute a dot product between the weights of the neurons and the region in the local input to which the neurons are connected. The output from the convolution stage 916 defines a set of linear activations that are processed by successive stages of the convolutional layer 914.

The linear activations can be processed by a detector stage 918. In the detector stage 918, each linear activation is processed by a non-linear activation function. The non-linear activation function increases the nonlinear properties of the overall network without affecting the receptive fields of the convolution layer. Several types of non-linear activation functions may be used. One particular type is the rectified linear unit (ReLU), which uses an activation function defined as *f*(*x*) = max(0, *x*)*,* such that the activation is thresholded at zero.

The pooling stage 920 uses a pooling function that replaces the output of the second convolutional layer 906 with a summary statistic of the nearby outputs. The pooling function can be used to introduce translation invariance into the neural network, such that small translations to the input do not change the pooled outputs. Invariance to local translation can be useful in scenarios where the presence of a feature in the input data is more important than the precise location of the feature. Various types of pooling functions can be used during the pooling stage 920, including max pooling, average pooling, and l2-norm pooling. Additionally, some CNN implementations do not include a pooling stage. Instead, such implementations substitute and additional convolution stage having an increased stride relative to previous convolution stages.

The output from the convolutional layer 914 can then be processed by the next layer 922. The next layer 922 can be an additional convolutional layer or one of the fully connected layers 908. For example, the first convolutional layer 904 of FIG. 9A can output to the second convolutional layer 906, while the second convolutional layer can output to a first layer of the fully connected layers 908.

A variant on the CNN is a convolutional deep belief network, which has a structure similar to a CNN and is trained in a manner similar to a deep belief network. A deep belief network (DBN) is a generative neural network that is composed of multiple layers of stochastic (random) variables. DBNs can be trained layer-by-layer using greedy unsupervised learning. The learned weights of the DBN can then be used to provide pre-train neural networks by determining an optimal initial set of weights for the neural network.

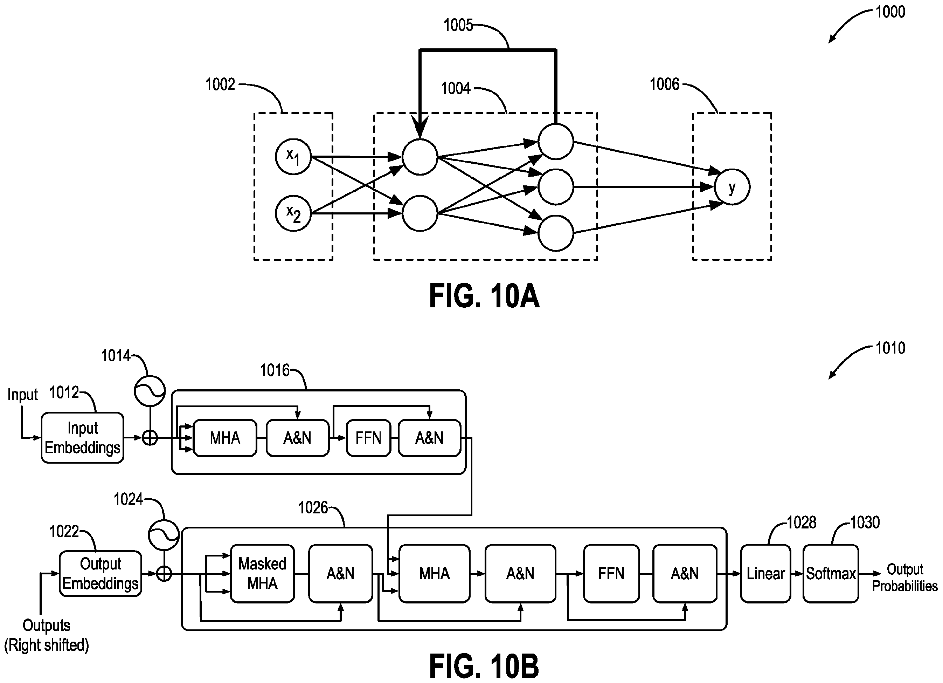

**FIGS. 10A-10B** illustrate an exemplary language models. FIG. 10A illustrates a recurrent neural network (RNN 1000). In a recurrent neural network (RNN), the previous state of the network influences the output of the current state of the network. RNNs can be built in a variety of ways using a variety of functions. The use of RNNs generally revolves around using mathematical models to predict the future based on a prior sequence of inputs. For example, an RNN may be used to perform statistical language modeling to predict an upcoming word given a previous sequence of words. The RNN 1000 can be described has having an input layer 1002 that receives an input vector, hidden layers 1004 to implement a recurrent function, a feedback mechanism 1005 to enable a 'memory' of previous states, and an output layer 1006 to output a result. The RNN 1000 operates based on time-steps. The state of the RNN at a given time step is influenced based on the previous time step via the feedback mechanism 1005. For a given time step, the state of the hidden layers 1004 is defined by the previous state and the input at the current time step. An initial input (x₁) at a first-time step can be processed by the hidden layer 1004. A second input (x₂) can be processed by the hidden layer 1004 using state information that is determined during the processing of the initial input (x₁). A given state can be computed as *sₜ = f*(*Uxₜ + Ws*_{*t-*1}), where *U* and *W* are parameter matrices. The function *f* is generally a nonlinearity, such as the hyperbolic tangent function (Tanh) or a variant of the rectifier function *f*(*x*) = max(0, *x*)*.* However, the specific mathematical function used in the hidden layers 1004 can vary depending on the specific implementation details of the RNN 1000. Acceleration for variations on RNN networks may also be enabled. One example RNN variant is the long short term memory (LSTM) RNN. LSTM RNNs are capable of learning long-term dependencies that may be necessary for processing longer sequences of language.

FIG. 10B illustrates baseline components of a transformer model 1010. The transformer model 1010 address issues found in RNN models with long input sequences as well as enabling increased parallelization. The transformer model 1010, and variants thereof, are used to build Language Models (LLMs) that perform various tasks such as machine translation, automatic summarization, and dialogue management. A transformer model 1010 may also be configured to perform image generation tasks, such as text-to-image generation.

The transformer model 1010 includes multiple instances of an encoder 1016 and a decoder 1026. The encoders are stacked end-to-end, with the output of the final encoder being routed as input to a multiheaded attention layer of each decoder 1026. Input that enters the bottommost instance of encoder 1016 is processed by input embeddings 1012 that convert input tokens into vectors that can be processed by the encoder 1016. The output dictionary is vectorized by output embeddings 1022 before entry into the bottommost instance of decoder 1026. Positional encodings 1014, 1024 are added to input vectors and output vectors at the bottoms of the encoder 1016 and decoder 1026 stacks. The positional encodings 1014, 1024, inject information about the relative or absolute position of tokens in a sequence of tokens to be processed as the transformer model 1010 does not naturally encode the order of the tokens.

The encoder 1016 of the transformer model 1010 analyses the input text and creates a number of hidden states that protect the context and meaning of the text data. Encoder 1016 layers make up part of the core of the transformer architecture, although decoder 1026 only variants of the transformer model 1010 are also possible. The encoder 1016 includes two sublayers, a multi-head attention (MHA) sublayer and a feedforward network (FFN) sublayer. The MHA sublayer performs multiple concurrent self-attention operations to compute attention scores, which enable the transformer model 1010 weigh the importance and relative relationships of different tokens in the input sequence in a context-aware manner. The FFN sublayer is a position-wise fully connected feedforward neural network. The output of each sublayer is processed by an add and normalize (A&N) operation, defined as *LayerNorm*(*x + Sublayer*(*x*)), where the output of the sublayer is added to the input of the sublayer and normalized. In some implementations, the normalization operation may be performed before the sublayer instead of afterwards.

The decoder 1026 includes three sublayers, a masked MHA sublayer, an MHA sublayer, and an FFN sublayer. The masked MHA sublayer is similar to the MHA layer, excepting that masking is applied to prevent query position from attending to the keys of future positions. The MHA sublayer of the decoder 1026 is similar to the MHA sublayer of the encoder, with an additional input from the encoder 1016. The FFN of the decoder 1026 is the same as the FFN of the encoder 1016. The Linear and Softmax block takes the output of the last instance of decoder 1026 of the decoder stack and generates a probability distribution that represent output probabilities.

GPU acceleration is also available for variants of the transformer model 1010 that replace some or all FFN sublayers with sparse mixture of experts (MoE) layers. MoE layers each include a number of experts, where each expert is a neural network. The MoE layers may themselves be FFNs, or may also be MoEs, allowing hierarchical MoE layers.

The training of a transformer model 1010 can be optimized via the use of adaptive precision logic that adjusts the computation precision that is applied during training. The adaptive precision logic can attempt to use the smallest datatype possible during training without significantly reducing training accuracy. For example, to minimize data loss due to the use of 16-bit, 8-bit, and 4-bit floating-point format, dynamic scaling and casting can be applied during training based on the statistical analysis of the tensor data that is generated during training. Tensor data that is generated during training can be statistically analyzed using a variety of analysis techniques to determine a set of scaling factors to apply to blocks of data, such as the input to each layer of the transformer model 1010. For example, absolute minimum and/or maximum values can be used to determine scaling factors that can prevent underflow or overflow of low-precision floating-point data types.

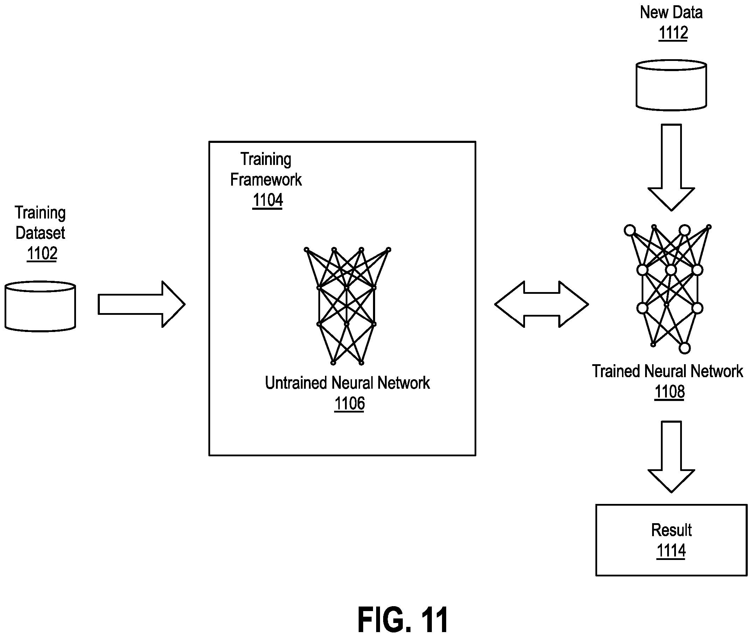

**FIG. 11** illustrates training and deployment of a deep neural network. Once a given network has been structured for a task the neural network is trained using a training dataset 1102. Training frameworks 1104 have been developed to enable hardware acceleration of the training process. For example, the machine learning framework 604 of FIG. 6 may be configured as a training framework 1104. The training framework 1104 can hook into an untrained neural network 1106 and enable the untrained neural net to be trained using the parallel processing resources described herein to generate a trained neural network 1108. To start the training process the initial weights may be chosen randomly or by pre-training using a deep belief network. The training cycle can then be performed in either a supervised or unsupervised manner.

Supervised learning is a learning method in which training is performed as a mediated operation, such as when the training dataset 1102 includes input paired with the desired output for the input, or where the training dataset includes input having known output and the output of the neural network is manually graded. The network processes the inputs and compares the resulting outputs against a set of expected or desired outputs. Errors are then propagated back through the system. The training framework 1104 can adjust to adjust the weights that control the untrained neural network 1106. The training framework 1104 can provide tools to monitor how well the untrained neural network 1106 is converging towards a model suitable to generating correct answers based on known input data. The training process occurs repeatedly as the weights of the network are adjusted to refine the output generated by the neural network. The training process can continue until the neural network reaches a statistically desired accuracy associated with a trained neural network 1108. The trained neural network 1108 can then be deployed to implement any number of machine learning operations to generate an inference result 1114 based on input of new data 1112.

Unsupervised learning is a learning method in which the network attempts to train itself using unlabeled data. Thus, for unsupervised learning the training dataset 1102 will include input data without any associated output data. The untrained neural network 1106 can learn groupings within the unlabeled input and can determine how individual inputs are related to the overall dataset. Unsupervised training can be used to generate a self-organizing map, which is a type of trained neural network 1108 capable of performing operations useful in reducing the dimensionality of data. Unsupervised training can also be used to perform anomaly detection, which allows the identification of data points in an input dataset that deviate from the normal patterns of the data.

Variations on supervised and unsupervised training may also be employed. Semi-supervised learning is a technique in which in the training dataset 1102 includes a mix of labeled and unlabeled data of the same distribution. Incremental learning is a variant of supervised learning in which input data is continuously used to further train the model. Incremental learning enables the trained neural network 1108 to adapt to the new data 1112 without forgetting the knowledge instilled within the network during initial training. Whether supervised or unsupervised, the training process for particularly deep neural networks may be too computationally intensive for a single compute node. Instead of using a single compute node, a distributed network of computational nodes can be used to accelerate the training process.

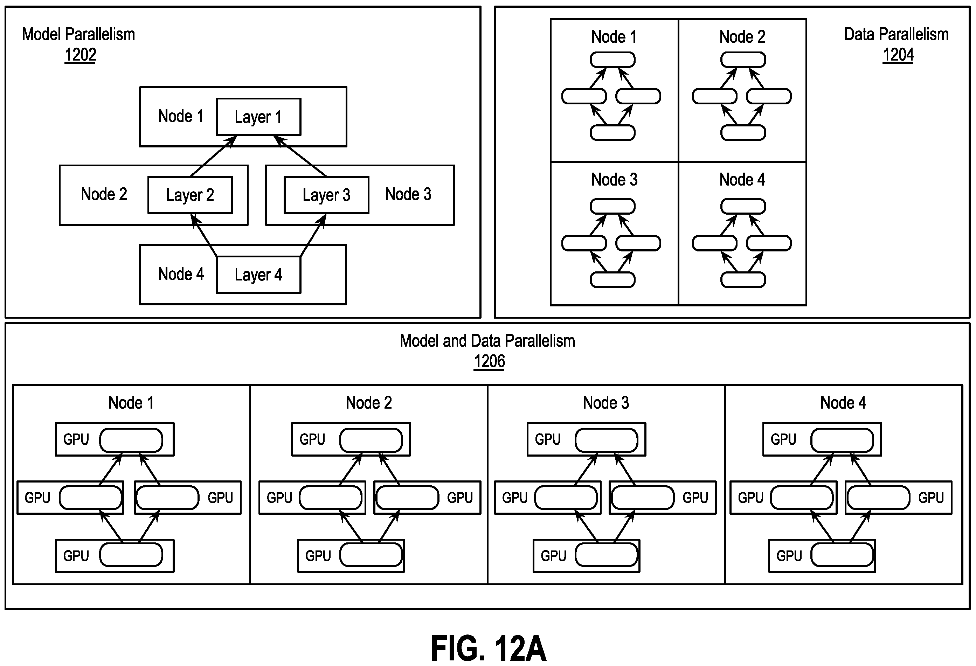

FIG. 12A is a block diagram illustrating distributed learning. Distributed learning is a training model that uses multiple distributed computing nodes to perform supervised or unsupervised training of a neural network. The distributed computational nodes can each include one or more host processors and one or more of the general-purpose processing nodes, such as the GPGPU 700 as in FIG. 7. As illustrated, distributed learning can be performed with model parallelism 1202, data parallelism 1204, or a combination of model and data parallelism 1206.

In model parallelism 1202, different computational nodes in a distributed system can perform training computations for different parts of a single network. For example, each layer of a neural network can be trained by a different processing node of the distributed system. The benefits of model parallelism include the ability to scale to particularly large models. Splitting the computations associated with different layers of the neural network enables the training of very large neural networks in which the weights of all layers would not fit into the memory of a single computational node. In some instances, model parallelism can be particularly useful in performing unsupervised training of large neural networks. Some implementations of model parallelism 1202 may also be referred to as tensor parallelism.

In data parallelism 1204, the different nodes of the distributed network have a complete instance of the model and each node receives a different portion of the data. The results from the different nodes are then combined. While different approaches to data parallelism are possible, data parallel training approaches all require a technique of combining results and synchronizing the model parameters between each node. Exemplary approaches to combining data include parameter averaging and update-based data parallelism. Parameter averaging trains each node on a subset of the training data and sets the global parameters (e.g., weights, biases) to the average of the parameters from each node. Parameter averaging uses a central parameter server that maintains the parameter data. Update based data parallelism is similar to parameter averaging except that instead of transferring parameters from the nodes to the parameter server, the updates to the model are transferred. Additionally, update-based data parallelism can be performed in a decentralized manner, where the updates are compressed and transferred between nodes.

Combined model and data parallelism 1206 can be implemented, for example, in a distributed system in which each computational node includes multiple GPUs. Combined model and data parallelism 1206 may also be referred to as hybrid parallelism. Each node can have a complete instance of the model, with separate GPUs within each node being used to train different portions of the model. Distributed training has increased overhead relative to training on a single machine. However, the parallel processors and GPGPUs described herein can each implement various techniques to reduce the overhead of distributed training, including techniques to enable high bandwidth GPU-to-GPU data transfer and accelerated remote data synchronization. Pipeline parallelism is a variant of combined model and data parallelism 1206, in which different nodes contain less than the entire model, but more than a single layer of the model. In pipeline parallelism, different groups of layers or sub-models are distributed across the different processing nodes. Another variant is expert parallelism, which routes requests to specific experts within the model to different GPUs. Expert parallelism can be used, for example, with MoE transformer models.

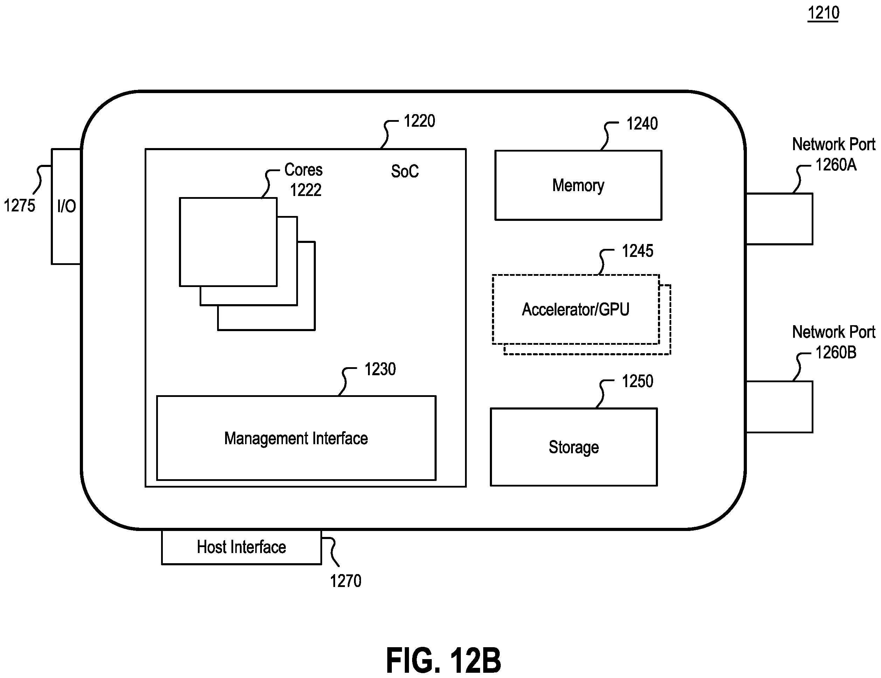

**FIG. 12B** is a block diagram illustrating a programmable network interface 1210 and data processing unit. The programmable network interface 1210 is a programmable network engine that can be used to accelerate network-based compute tasks within a distributed environment. The programmable network interface 1210 can couple with a host system via host interface 1270. The programmable network interface 1210 can be used to accelerate network or storage operations for CPUs or GPUs of the host system. The host system can be, for example, a node of a distributed learning system used to perform distributed training, for example, as shown in FIG. 12A. The host system can also be a data center node within a data center.

In one embodiment, access to remote storage containing model data can be accelerated by the programmable network interface 1210. For example, the programmable network interface 1210 can be configured to present remote storage devices as local storage devices to the host system. The programmable network interface 1210 can also accelerate remote direct memory access (RDMA) operations performed between GPUs of the host system with GPUs of remote systems. In one embodiment, the programmable network interface 1210 can enable storage functionality such as, but not limited to NVME-oF. The programmable network interface 1210 can also accelerate encryption, data integrity, compression, and other operations for remote storage on behalf of the host system, allowing remote storage to approach the latencies of storage devices that are directly attached to the host system.

The programmable network interface 1210 can also perform resource allocation and management on behalf of the host system. Storage security operations can be offloaded to the programmable network interface 1210 and performed in concert with the allocation and management of remote storage resources. Network-based operations to manage access to the remote storage that would otherwise by performed by a processor of the host system can instead be performed by the programmable network interface 1210.

In one embodiment, network and/or data security operations can be offloaded from the host system to the programmable network interface 1210. Data center security policies for a data center node can be handled by the programmable network interface 1210 instead of the processors of the host system. For example, the programmable network interface 1210 can detect and mitigate against an attempted network-based attack (e.g., DDoS) on the host system, preventing the attack from compromising the availability of the host system.

The programmable network interface 1210 can include a system on a chip (SoC 1220) that executes an operating system via multiple processor cores 1222. The processor cores 1222 can include general-purpose processor (e.g., CPU) cores. In one embodiment the processor cores 1222 can also include one or more GPU cores. The SoC 1220 can execute instructions stored in a memory device 1240. A storage device 1250 can store local operating system data. The storage device 1250 and memory device 1240 can also be used to cache remote data for the host system. Network ports 1260A-1260B enable a connection to a network or fabric and facilitate network access for the SoC 1220 and, via the host interface 1270, for the host system. The programmable network interface 1210 can also include an I/O interface 1275, such as a USB interface. The I/O interface 1275 can be used to couple external devices to the programmable network interface 1210 or as a debug interface. The programmable network interface 1210 also includes a management interface 1230 that enables software on the host device to manage and configure the programmable network interface 1210 and/or SoC 1220. In one embodiment the programmable network interface 1210 may also include one or more accelerators or GPUs 1245 to accept offload of parallel compute tasks from the SoC 1220, host system, or remote systems coupled via the network ports 1260A-1260B.

### Exemplary Machine Learning Applications

Machine learning can be applied to solve a variety of technological problems, including but not limited to computer vision, autonomous driving and navigation, speech recognition, and language processing. Computer vision has traditionally been one of the most active research areas for machine learning applications. Applications of computer vision range from reproducing human visual abilities, such as recognizing faces, to creating new categories of visual abilities. For example, computer vision applications can be configured to recognize sound waves from the vibrations induced in objects visible in a video. Parallel processor accelerated machine learning enables computer vision applications to be trained using significantly larger training dataset than previously feasible and enables inferencing systems to be deployed using low power parallel processors.

Parallel processor accelerated machine learning has autonomous driving applications including lane and road sign recognition, obstacle avoidance, navigation, and driving control. Accelerated machine learning techniques can be used to train driving models based on datasets that define the appropriate responses to specific training input. The parallel processors described herein can enable rapid training of the increasingly complex neural networks used for autonomous driving solutions and enables the deployment of low power inferencing processors in a mobile platform suitable for integration into autonomous vehicles.

Parallel processor accelerated deep neural networks have enabled machine learning approaches to automatic speech recognition (ASR). ASR includes the creation of a function that computes the most probable linguistic sequence given an input acoustic sequence. Accelerated machine learning using deep neural networks have enabled the replacement of the hidden Markov models (HMMs) and Gaussian mixture models (GMMs) previously used for ASR.

Parallel processor accelerated machine learning can also be used to accelerate natural language processing. Automatic learning procedures can make use of statistical inference algorithms to produce models that are robust to erroneous or unfamiliar input. Exemplary natural language processor applications include automatic machine translation between human languages.

The parallel processing platforms used for machine learning can be divided into training platforms and deployment platforms. Training platforms are generally highly parallel and include optimizations to accelerate multi-GPU single node training and multi-node, multi-GPU training. Exemplary parallel processors suited for training include the GPGPU 700 of FIG. 7 and the multi-GPU computing system 800 of FIG. 8. On the contrary, deployed machine learning platforms generally include lower power parallel processors suitable for use in products such as cameras, autonomous robots, and autonomous vehicles.

Additionally, machine learning techniques can be applied to accelerate or enhance graphics processing activities. For example, a machine learning model can be trained to recognize output generated by a GPU accelerated application and generate an upscaled version of that output. Such techniques can be applied to accelerate the generation of high-resolution images for a gaming application. Various other graphics pipeline activities can benefit from the use of machine learning. For example, machine learning models can be trained to perform tessellation operations on geometry data to increase the complexity of geometric models, allowing fine-detailed geometry to be automatically generated from geometry of relatively lower detail.

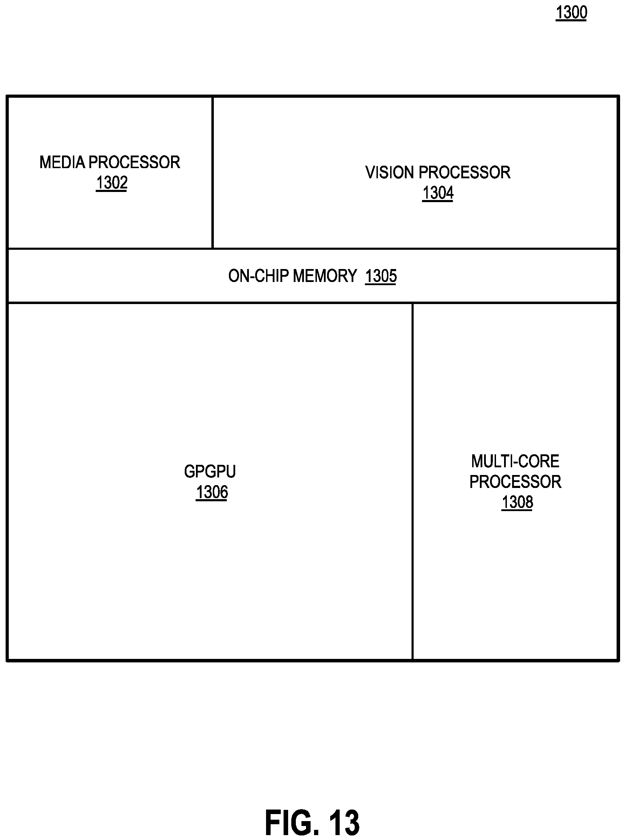

**FIG. 13** illustrates an exemplary inferencing system on a chip (SOC 1300) suitable for performing inferencing using a trained model. The SOC 1300 can integrate processing components including a media processor 1302, a vision processor 1304, a GPGPU 1306 and a multi-core processor 1308. The GPGPU 1306 may be a GPGPU as described herein, such as the GPGPU 700, and the multi-core processor 1308 may be a multi-core processor described herein, such as the multi-core processors 405-406. The SOC 1300 can additionally include on-chip memory 1305 that can enable a shared on-chip data pool that is accessible by each of the processing components. The processing components can be optimized for low power operation to enable deployment to a variety of machine learning platforms, including autonomous vehicles and autonomous robots. For example, one implementation of the SOC 1300 can be used as a portion of the main control system for an autonomous vehicle. Where the SOC 1300 is configured for use in autonomous vehicles, the SOC is designed and configured for compliance with the relevant functional safety standards of the deployment jurisdiction.

During operation, the media processor 1302 and vision processor 1304 can work in concert to accelerate computer vision operations. The media processor 1302 can enable low latency decode of multiple high-resolution (e.g., 4K, 8K) video streams. The decoded video streams can be written to a buffer in the on-chip memory 1305. The vision processor 1304 can then parse the decoded video and perform preliminary processing operations on the frames of the decoded video in preparation of processing the frames using a trained image recognition model. For example, the vision processor 1304 can accelerate convolution operations for a CNN that is used to perform image recognition on the high-resolution video data, while back-end model computations are performed by the GPGPU 1306.

The multi-core processor 1308 can include control logic to assist with sequencing and synchronization of data transfers and shared memory operations performed by the media processor 1302 and the vision processor 1304. The multi-core processor 1308 can also function as an application processor to execute software applications that can make use of the inferencing compute capability of the GPGPU 1306. For example, at least a portion of the navigation and driving logic can be implemented in software executing on the multi-core processor 1308. Such software can directly issue computational workloads to the GPGPU 1306 or the computational workloads can be issued to the multi-core processor 1308, which can offload at least a portion of those operations to the GPGPU 1306.

The GPGPU 1306 can include compute clusters such as a low power configuration of the processing clusters 706A-706H within the GPGPU 700. The compute clusters within the GPGPU 1306 can support instructions that are specifically optimized to perform inferencing computations on a trained neural network. For example, the GPGPU 1306 can support instructions to perform low precision computations such as 8-bit and 4-bit integer vector operations.

### Additional System Overview

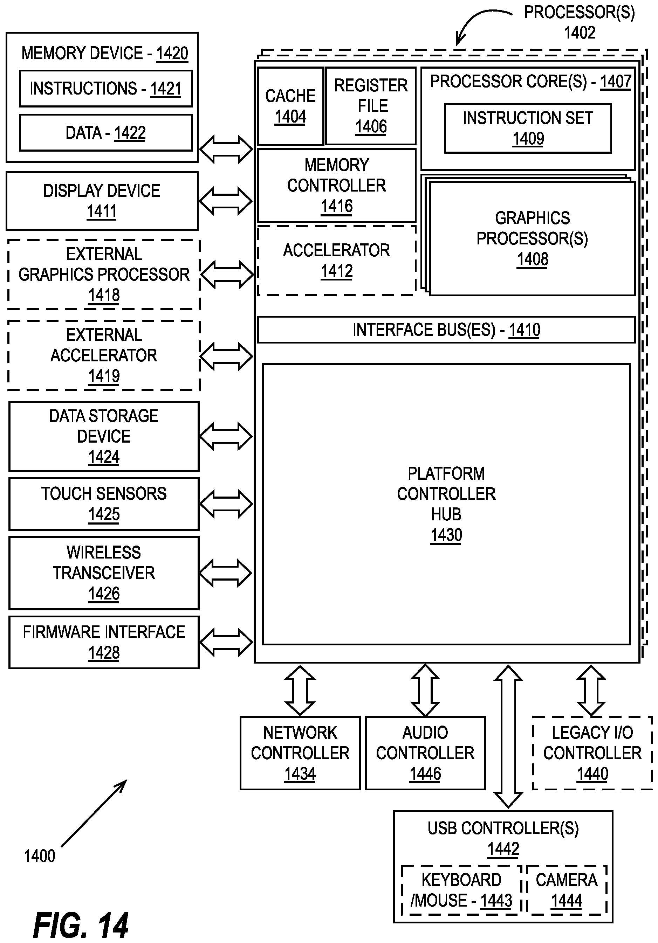

**FIG. 14** is a block diagram of a processing system 1400. The elements of FIG. 14 having the same or similar names as the elements of any other figure herein describe the same elements as in the other figures, can operate or function in a manner similar to that, can comprise the same components, and can be linked to other entities, as those described elsewhere herein, but are not limited to such. The processing system 1400 may be used in a single processor desktop system, a multiprocessor workstation system, or a server system having processor(s) 1402 or processor cores 1407. The processing system 1400 may be a processing platform incorporated within a system-on-a-chip (SoC) integrated circuit for use in mobile, handheld, or embedded devices such as within Internet-of-things (IoT) devices with wired or wireless connectivity to a local or wide area network.

The processing system 1400 may be a processing system having components that correspond with those of FIG. 1. For example, in different configurations, processor(s) 1402 or processor cores 1407 may correspond with processor(s) 102 of FIG. 1. The graphics processor(s) 1408 may correspond with parallel processor(s) 112 of FIG. 1. The external graphics processor 1418 may be one of the add-in device(s) 120 of FIG. 1.

The processing system 1400 can include, couple with, or be integrated within: a server-based gaming platform; a game console, including a game and media console; a mobile gaming console, a handheld game console, or an online game console. The processing system 1400 may be part of a mobile phone, smart phone, tablet computing device or mobile Internet-connected device such as a laptop with low internal storage capacity. The processing system 1400 can also include, couple with, or be integrated within: a wearable device, such as a smart watch wearable device; smart eyewear or clothing enhanced with augmented reality (AR) or virtual reality (VR) features to provide visual, audio or tactile outputs to supplement real world visual, audio or tactile experiences or otherwise provide text, audio, graphics, video, holographic images or video, or tactile feedback. The processing system 1400 may include or be part of a television or set top box device. The processing system 1400 can include, couple with, or be integrated within a self-driving vehicle such as a bus, tractor trailer, car, motor or electric power cycle, plane, or glider (or any combination thereof). The self-driving vehicle may use the processing system 1400 to process the environment sensed around the vehicle.

The processor(s) 1402 may include one or more instances of processor cores 1407 to process instructions which, when executed, perform operations for system or user software. The least one of the processor cores 1407 may be configured to process a specific instruction set 1409. The instruction set 1409 may facilitate Complex Instruction Set Computing (CISC), Reduced Instruction Set Computing (RISC), or computing via a Very Long Instruction Word (VLIW). In one embodiment, one of the processor cores 1407 may process a different instruction set 1409, which may include instructions to facilitate the emulation of other instruction sets. Processor core 1407 may also include other processing devices, such as a Digital Signal Processor (DSP).

The processor(s) 1402 may include cache memory 1404. Depending on the architecture, the processor(s) 1402 can have a single internal cache or multiple levels of internal cache. In some embodiments, the cache memory is shared among various components of the processor(s) 1402. In some embodiments, the processor(s) 1402 also uses an external cache (e.g., a Level-3 (L3) cache or Last Level Cache (LLC)) (not shown), which may be shared among processor cores 1407 using known cache coherency techniques. A register file 1406 can be additionally included in the processor(s) 1402 and may include different types of registers for storing different types of data (e.g., integer registers, floating-point registers, status registers, and an instruction pointer register). Some registers may be general-purpose registers, while other registers may be specific to the design of the processor(s) 1402.

The processor(s) 1402 may be coupled with one or more interface bus(es) 1410 to transmit communication signals such as address, data, or control signals between the processor(s) 1402 and other components in the processing system 1400. The interface bus(es) 1410, in one of these embodiments, can be a processor bus, such as a version of the Direct Media Interface (DMI) bus. However, processor buses are not limited to the DMI bus, and may include one or more Peripheral Component Interconnect buses (e.g., PCI, PCI express), memory buses, or other types of interface buses. For example, the processor(s) 1402 may include a memory controller 1416 and a platform controller hub 1430. The memory controller 1416 facilitates communication between a memory device and other components of the processing system 1400, while the platform controller hub 1430 provides connections to I/O devices via a local I/O bus.

The memory device 1420 can be a dynamic random-access memory (DRAM) device, a static random-access memory (SRAM) device, flash memory device, phase-change memory device, or some other memory device having suitable performance to serve as process memory. The memory device 1420 can, for example, operate as system memory for the processing system 1400, to store data 1422 and instructions 1421 for use when the processor(s) 1402 executes an application or process. The memory controller 1416 can optionally couple with an external graphics processor 1418, which may communicate with the graphics processor(s) 1408 in the processor(s) 1402 to perform graphics and media operations. In some embodiments, graphics, media, and or compute operations may be assisted by an accelerator 1412 which is a coprocessor that can be configured to perform a specialized set of graphics, media, or compute operations. For example, the accelerator 1412 may be a matrix multiplication accelerator used to optimize machine learning or compute operations. The accelerator 1412 can be a ray-tracing accelerator that can be used to perform ray-tracing operations in concert with the graphics processor(s) 1408. The accelerator 1412 may also be an AI accelerator or NPU to accelerate neural network training or inference operations. In one embodiment, an external accelerator 1419 may be used in place of or in concert with the accelerator 1412. The accelerator 1412 and/or external accelerator 1419 may have functionality similar to that of the accelerator device(s) 130 of FIG. 1.

A display device 1411 may be provided that can connect to the processor(s) 1402. The display device 1411 can be one or more of an internal display device, as in a mobile electronic device or a laptop device or an external display device attached via a display interface (e.g., DisplayPort, etc.). The display device 1411 can be a head mounted display (HMD) such as a stereoscopic display device for use in VR or AR applications.

The platform controller hub 1430 may enable peripherals to connect to memory device 1420 and processor(s) 1402 via a high-speed I/O bus. The I/O peripherals include, but are not limited to, an audio controller 1446, a network controller 1434, a firmware interface 1428, a wireless transceiver 1426, touch sensors 1425, a data storage device 1424 (e.g., non-volatile memory, volatile memory, hard disk drive, flash memory, NAND, 3D NAND, 3D XPoint/Optane, etc.). The data storage device 1424 can connect via a storage interface (e.g., SATA) or via a peripheral bus, such as a Peripheral Component Interconnect bus (e.g., PCI, PCI express). The touch sensors 1425 can include touch screen sensors, pressure sensors, or fingerprint sensors. The wireless transceiver 1426 can be a Wi-Fi transceiver, a Bluetooth transceiver, or a mobile network transceiver such as a 3G, 4G, 5G, or Long-Term Evolution (LTE) transceiver. The firmware interface 1428 enables communication with system firmware, and can be, for example, a unified extensible firmware interface (UEFI). The network controller 1434 can enable a network connection to a wired network. In some embodiments, a high-performance network controller (not shown) couples with the interface bus(es) 1410. The audio controller 1446 may be a multi-channel high-definition audio controller. In some of these embodiments the processing system 1400 includes an optional legacy I/O controller 1440 for coupling legacy (e.g., Personal System 2 (PS/2)) devices to the system. The platform controller hub 1430 can also connect to one or more Universal Serial Bus (USB) controllers 1442 to connect to input devices, such as keyboard and mouse 1443 combinations, a camera 1444, or other USB input devices.

It will be appreciated that the processing system 1400 shown is exemplary and not limiting, as other types of data processing systems that are differently configured may also be used. For example, an instance of the memory controller 1416 and platform controller hub 1430 may be integrated into a discrete external graphics processor, such as the external graphics processor 1418. The platform controller hub 1430 and/or memory controller 1416 may be external to the processor(s) 1402. For example, the memory controller 1416 and platform controller hub 1430 may be external to the processing system 1400 and configured as a memory controller hub and peripheral controller hub within a system chipset that is in communication with the processor(s) 1402.

For example, circuit boards ("sleds") can be used on which components such as CPUs, memory, and other components are placed and are designed for increased thermal performance. Processing components such as the processors may be located on a top side of a sled while near memory, such as DIMMs, are located on a bottom side of the sled. As a result of the enhanced airflow provided by this design, the components may operate at higher frequencies and power levels than in typical systems, thereby increasing performance. Furthermore, the sleds are configured to blindly mate with power and data communication cables in a rack, thereby enhancing their ability to be quickly removed, upgraded, reinstalled, and/or replaced. Similarly, individual components located on the sleds, such as processors, accelerators, memory, and data storage drives, are configured to be easily upgraded due to their increased spacing from each other. In the illustrative embodiment, the components additionally include hardware attestation features to prove their authenticity.

A data center can utilize a single network architecture ("fabric") that supports multiple other network architectures including Ethernet and Omni-Path. The sleds can be coupled to switches via optical fibers, which provide higher bandwidth and lower latency than typical twisted pair cabling (e.g., Category 5, Category 5e, Category 6, Category 7, Category 8, etc.). Due to the high bandwidth, low latency interconnections and network architecture, the data center may, in use, pool resources, such as memory, accelerators (e.g., GPUs, graphics accelerators, FPGAs, ASICs, neural network and/or artificial intelligence accelerators, etc.), and data storage drives that are physically disaggregated, and provide them to compute resources (e.g., processors) on an as needed basis, enabling the compute resources to access the pooled resources as if they were local.

A power supply or source can provide voltage and/or current to the processing system 1400 or any component or system described herein. In one example, the power supply includes an AC to DC (alternating current to direct current) adapter to plug into a wall outlet. Such AC power can be renewable energy (e.g., solar power) power source. In one example, the power source includes a DC power source, such as an external AC to DC converter. A power source or power supply may also include wireless charging hardware to charge via proximity to a charging field. The power source can include an internal battery, alternating current supply, motion-based power supply, solar power supply, or fuel cell source.

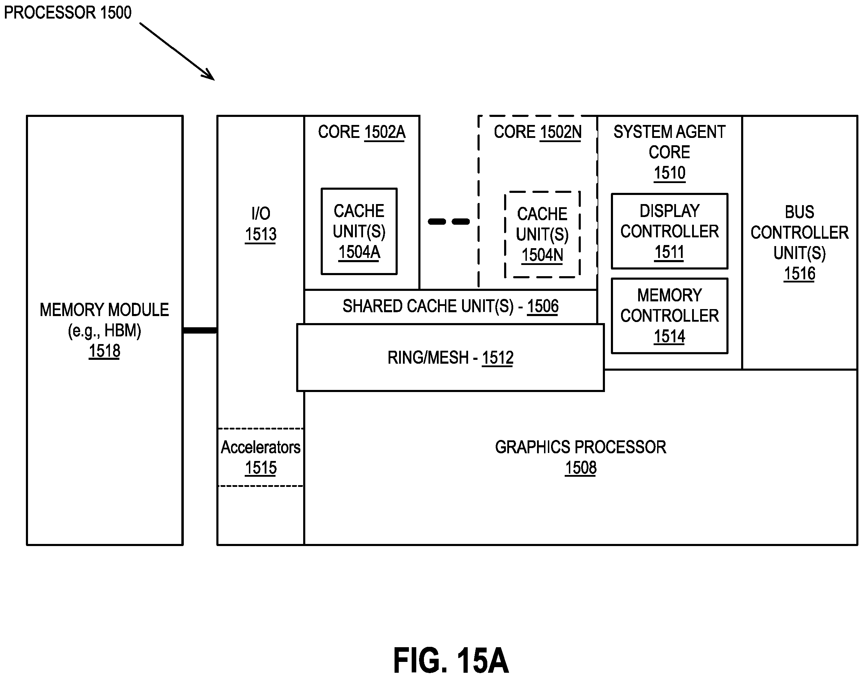

**FIGS. 15A-15C** illustrate computing systems and graphics processors. The elements of FIGS. 15A-15C having the same or similar names as the elements of any other figure herein describe the same elements as in the other figures, can operate or function in a manner similar to that, can comprise the same components, and can be linked to other entities, as those described elsewhere herein, but are not limited to such.

**FIG. 15A** is a block diagram of a processor 1500, which may be a variant of one of the processor(s) 1402 and may be used in place of one of those. Therefore, the disclosure of any features in combination with the processor 1500 herein also discloses a corresponding combination with the processor(s) 1402 but is not limited to such. The processor 1500 may have one or more processor cores 1502A-1502N, at least one memory controller 1514, and a graphics processor 1508. The graphics processor 1508 may be integrated within the processor 1500, within a system chipset, or coupled via a system bus. The processor 1500 can include additional cores up to and including additional core 1502N represented by the dashed lined boxes. Each of processor cores 1502A-1502N includes one or more internal cache unit(s) 1504A-1504N. In some embodiments each processor core 1502A-1502N also has access to one or more shared cache unit(s) 1506. The internal cache units 1504A-1504N and shared cache unit(s) 1506 represent a cache memory hierarchy within the processor 1500. The cache memory hierarchy may include at least one level of instruction and data cache within each processor core and one or more levels of shared mid-level cache, such as a Level 2 (L2), Level 3 (L3), Level 4 (L4), or other levels of cache, where the highest level of cache before external memory is classified as the LLC. In some embodiments, cache coherency logic maintains coherency between the various cache units (e.g., shared cache unit(s) 1506 and internal cache unit(s) 1504A-1504N).

The processor 1500 may also include one or more bus controller units 1516 and a system agent core 1510. The one or more bus controller units 1516 manage a set of peripheral buses, such as one or more PCI or PCI express buses. The one or more bus controller units 1516 can also manage one or more memory buses to various external memory devices (not shown). The system agent core 1510 provides management functionality for the various processor components and can include the at least one memory controller 1514.

For example, one or more of the processor cores 1502A-1502N may include support for simultaneous multi-threading. The system agent core 1510 includes components for coordinating and operating cores 1502A-1502N during multi-threaded processing. System agent core 1510 may additionally include a power control unit (PCU), which includes logic and components to regulate the power state of processor cores 1502A-1502N and a graphics processor 1508.

The processor 1500 may additionally include a graphics processor 1508 to execute graphics processing operations. In some of these embodiments, the graphics processor 1508 couples with the one or more shared cache unit(s) 1506, and the system agent core 1510, including the at least one memory controller 1514. The system agent core 1510 may also include a display controller 1511 to drive graphics processor output to one or more coupled displays. The display controller 1511 may also be a separate module coupled with the graphics processor via at least one interconnect or may be integrated within the graphics processor 1508.

A ring or mesh based interconnect 1512 may be used to couple the internal components of the processor 1500. However, an alternative interconnect unit may be used, such as a point-to-point interconnect, a switched interconnect, or other techniques, including techniques well known in the art. In some of these embodiments with a ring or mesh based interconnect 1512, the graphics processor 1508 couples with the ring or mesh based interconnect 1512 via an I/O link 1513.

The exemplary I/O link 1513 represents at least one of multiple varieties of I/O interconnects, including an on package I/O interconnect which facilitates communication between various processor components and a high-performance memory module 1518, such as an embedded DRAM module (eDRAM) or a high-bandwidth memory (HBM) module. Optionally, each of the processor cores 1502A-1502N and the graphics processor 1508 can use the high-performance memory module 1518 as unified memory and/or a shared Last Level Cache when a DRAM memory system is also present. Optionally, one or more accelerators 1515 may also be included within the processor 1500, including, for example, an NPU to accelerate certain neural network operations. The NPU can enable lower power inference operations relative to use of the graphics processor 1508, or can operate in concert with the graphics processor 1508 to enable higher inference performance relative to the graphics processor 1508 alone. In one embodiment, an NPU within the one or more accelerators 1515 can include matrix or tensor acceleration logic and can be used to implement at least some of the computational operations that are described herein as implementable via the graphics processor 1508.

The processor cores 1502A-1502N may, for example, be homogenous cores executing the same instruction set architecture. Alternatively, the processor cores 1502A-1502N are heterogeneous in terms of instruction set architecture (ISA), where one or more of processor cores 1502A-1502N execute a first instruction set, while at least one of the other cores executes a subset of the first instruction set or a different instruction set. The processor cores 1502A-1502N may be heterogeneous in terms of microarchitecture, where one or more cores having a relatively higher power consumption couple with one or more power cores having a lower power consumption. As another example, the processor cores 1502A-1502N are heterogeneous in terms of computational capability. Additionally, the processor 1500 can be implemented on one or more chips or chiplets, or as an SoC integrated circuit having the illustrated components, in addition to other components. The SoC integrated circuit may be implemented using multiple chiplets.

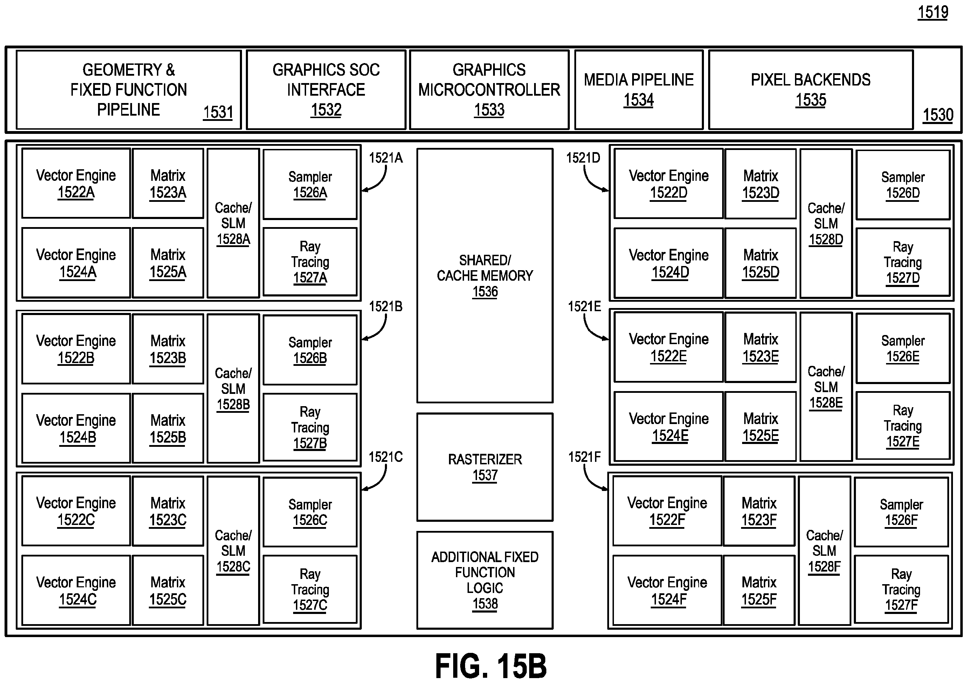

**FIG. 15B** is a block diagram of hardware logic of a graphics processor core block 1519, according to some embodiments described herein. In some embodiments, elements of **FIG. 15B** having the same reference numbers (or names) as the elements of any other figure herein may operate or function in a manner similar to that described elsewhere herein. In one embodiment, the graphics processor core block 1519 is exemplary of one partition of a graphics processor. The graphics processor core block 1519 can be included within the graphics processor 1508 of FIG. 15A or a discrete graphics processor, parallel processor, and/or compute accelerator. A graphics processor as described herein may include multiple graphics core blocks based on target power and performance envelopes. Each graphics processor core block 1519 can include a function block 1530 coupled with multiple graphics cores 1521A-1521F that include modular blocks of fixed function logic and general-purpose programmable logic. The graphics processor core block 1519 also includes shared/cache memory 1536 that is accessible by all graphics cores 1521A-1521F, rasterizer logic 1537, and additional fixed function logic 1538.

In some embodiments, the function block 1530 includes a geometry/fixed function pipeline 1531 that can be shared by all graphics cores in the graphics processor core block 1519. In various embodiments, the geometry/fixed function pipeline 1531 includes a 3D geometry pipeline, a video front-end unit, a thread spawner and global thread dispatcher, and a unified return buffer manager, which manages unified return buffers. In one embodiment the function block 1530 also includes a graphics SoC interface 1532, a graphics microcontroller 1533, and a media pipeline 1534. The graphics SoC interface 1532 provides an interface between the graphics processor core block 1519 and other core blocks within a graphics processor or compute accelerator SoC. The graphics microcontroller 1533 is a programmable sub-processor that is configurable to manage various functions of the graphics processor core block 1519, including thread dispatch, scheduling, and pre-emption. The media pipeline 1534 includes logic to facilitate the decoding, encoding, preprocessing, and/or post-processing of multimedia data, including image and video data. The media pipeline 1534 implement media operations via requests to compute or sampling logic within the graphics cores 1521-1521F. One or more pixel backends 1535 can also be included within the function block 1530. The one or more pixel backends 1535 include a cache memory to store pixel color values and can perform blend operations and lossless color compression of rendered pixel data.

In one embodiment the graphics SoC interface 1532 enables the graphics processor core block 1519 to communicate with general-purpose application processor cores (e.g., CPUs) and/or other components within an SoC or a system host CPU that is coupled with the SoC via a peripheral interface. The graphics SoC interface 1532 also enables communication with off-chip memory hierarchy elements such as a shared last level cache memory, system RAM, and/or embedded on-chip or on-package DRAM. The graphics SoC interface 1532 can also enable communication with fixed function devices within the SoC, such as camera imaging pipelines, and enables the use of and/or implements global memory atomics that may be shared between the graphics processor core block 1519 and CPUs within the SoC. The graphics SoC interface 1532 can also implement power management controls for the graphics processor core block 1519 and enable an interface between a clock domain of the graphics processor core block 1519 and other clock domains within the SoC. In one embodiment the graphics SoC interface 1532 enables receipt of command buffers from a command streamer and global thread dispatcher that are configured to provide commands and instructions to each of one or more graphics cores within a graphics processor. The commands and instructions can be dispatched to the media pipeline 1534 when media operations are to be performed, the geometry and fixed function pipeline 1531 when graphics processing operations are to be performed. When compute operations are to be performed, compute dispatch logic can dispatch the commands to the graphics cores 1521A-1521F, bypassing the geometry and media pipelines.

The graphics microcontroller 1533 can be configured to perform various scheduling and management tasks for the graphics processor core block 1519. In one embodiment the graphics microcontroller 1533 can perform graphics and/or compute workload scheduling on the various vector engines 1522A-1522F, 1524A-1524F and matrix engines 1523A-1523F, 1525A-1525F within the graphics cores 1521A-1521F. In this scheduling model, host software executing on a CPU core of an SoC including the graphics processor core block 1519 can submit workloads to one of multiple graphics processor doorbells, which invokes a scheduling operation on the appropriate graphics engine. Scheduling operations include determining which workload to run next, submitting a workload to a command streamer, pre-empting existing workloads running on an engine, monitoring progress of a workload, and notifying host software when a workload is complete. In one embodiment the graphics microcontroller 1533 can also facilitate low-power or idle states for the graphics processor core block 1519, providing the graphics processor core block 1519 with the ability to save and restore registers within the graphics processor core block 1519 across low-power state transitions independently from the operating system and/or graphics driver software on the system.

The graphics processor core block 1519 may have greater than or fewer than the illustrated graphics cores 1521A-1521F, up to *N* modular graphics cores. For each set of *N* graphics cores, the graphics processor core block 1519 can also include shared/cache memory 1536, which can be configured as shared memory or cache memory, rasterizer logic 1537, and additional fixed function logic 1538 to accelerate various graphics and compute processing operations.

Within each graphics cores 1521A-1521F is set of execution resources that may be used to perform graphics, media, and compute operations in response to requests by graphics pipeline, media pipeline, or shader programs. The graphics cores 1521A-1521F include multiple vector engines 1522A-1522F, 1524A-1524F, matrix acceleration units 1523A-1523F, 1525A-1525D, cache/shared local memory (SLM), a sampler 1526A-1526F, and a ray tracing unit 1527A-1527F.

The vector engines 1522A-1522F, 1524A-1524F are general-purpose graphics processing units capable of performing floating-point and integer/fixed-point logic operations in service of a graphics, media, or compute operation, including graphics, media, or compute/GPGPU programs. The vector engines 1522A-1522F, 1524A-1524F can operate at variable vector widths using SIMD, SIMT, or SIMT+SIMD execution modes. The matrix acceleration units 1523A-1523F, 1525A-1525D include matrix-matrix and matrix-vector acceleration logic that improves performance on matrix operations, particularly low and mixed precision (e.g., INT8, FP16, BF16, FP8, FP4) matrix operations used for machine learning. In one embodiment, the matrix acceleration units 1523A-1523F, 1525A-1525D have support for microscaling (MX) formats. In one embodiment, each of the matrix acceleration units 1523A-1523F, 1525A-1525D includes one or more systolic arrays of processing elements that can perform concurrent matrix multiply or dot product operations on matrix elements.

The sampler 1526A-1526F can read media or texture data into memory and can sample data differently based on a configured sampler state and the texture/media format that is being read. Threads executing on the vector engines 1522A-1522F, 1524A-1524F or matrix acceleration units 1523A-1523F, 1525A-1525D can make use of the cache/SLM 1528A-1528F within each of the graphics cores 1521A-1521F. The cache/SLM 1528A-1528F can be configured as cache memory or as a pool of shared memory that is local to each of the respective graphics cores 1521A-1521F. The ray tracing units 1527A-1527F within the graphics cores 1521A-1521F include ray traversal/intersection circuitry for performing ray traversal using bounding volume hierarchies (BVHs) and identifying intersections between rays and primitives enclosed within the BVH volumes. In one embodiment the ray tracing units 1527A-1527F include circuitry for performing depth testing and culling (e.g., using a depth buffer or similar arrangement). In one implementation, the ray tracing units 1527A-1527F perform traversal and intersection operations in concert with image denoising, at least a portion of which may be performed using an associated matrix acceleration unit 1523A-1523F, 1525A-1525D.

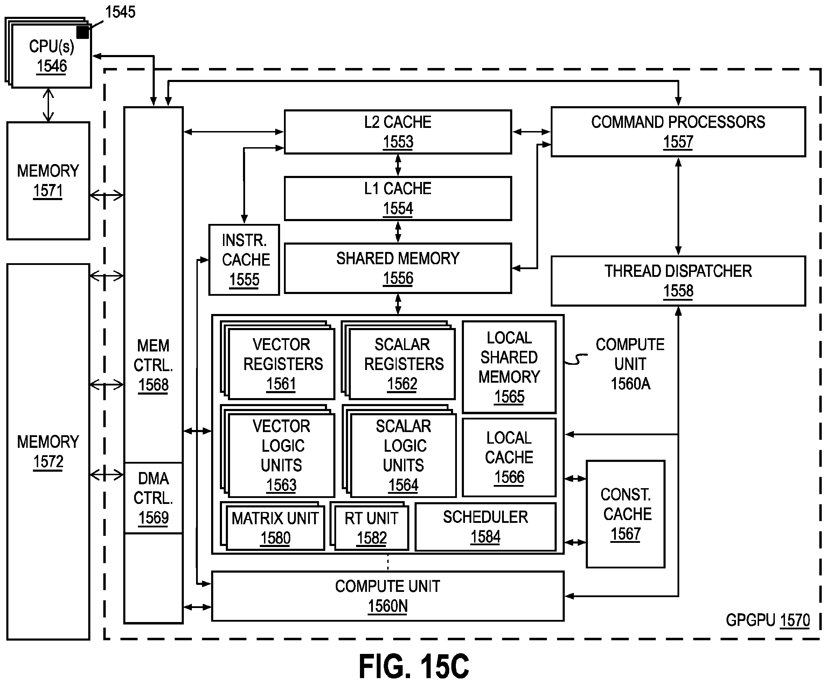

**FIG. 15C** is a block diagram of general-purpose graphics processing unit (GPGPU 1570) that can be configured as a graphics processor, e.g., the graphics processor 1508, and/or compute accelerator, according to embodiments described herein. The GPGPU 1570 can interconnect with host processors (e.g., one or more CPU(s) 1546) and memory 1571, 1572 via one or more system and/or memory buses. Memory 1571 may be system memory that can be shared with the one or more CPU(s) 1546, while memory 1572 is device memory that is dedicated to the GPGPU 1570. For example, components within the GPGPU 1570 and memory 1572 may be mapped into memory addresses that are accessible to the one or more CPU(s) 1546. Access to memory 1571 and 1572 may be facilitated via a memory controller 1568. The memory controller 1568 may include an internal direct memory access (DMA) controller 1569 or can include logic to perform operations that would otherwise be performed by a DMA controller. In one embodiment, at least one of the one or more CPU(s) 1546 can include one or more accelerators 1545, including but not limited to neural network accelerators.

The GPGPU 1570 includes multiple global cache memories, including an L2 cache 1553, L1 cache 1554, an instruction cache 1555, and shared memory 1556, at least a portion of which may also be partitioned as a cache memory. The GPGPU 1570 also includes multiple compute units 1560A-1560N. Each compute unit 1560A-1560N includes a set of vector registers 1561, scalar registers 1562, vector logic units 1563, scalar logic units 1564, and a scheduler 1584. The compute units 1560A-1560N can also include local shared memory 1565 and local cache memory1566. The compute units 1560A-1560N can couple with a constant cache 1567, which can be used to store constant data, which is data that will not change during the run of kernel or shader program that executes on the GPGPU 1570. The constant cache 1567 may be a scalar data cache and cached data can be fetched directly into the scalar registers 1562. In one embodiment, the compute unit 1560A-1560N additionally include at least one matrix unit 1580 to accelerate matrix, tensor, or artificial intelligence operations and at least one ray tracing unit (RT unit 1582) to accelerate ray tracing operations. The at least one matrix unit 1580 and RT unit 1582 can include similar functionality as other matrix/tensor accelerators and ray tracing accelerators described herein.

During operation, the one or more CPU(s) 1546 can write commands into registers or memory in the GPGPU 1570 that has been mapped into an accessible address space. The command processors 1557 can read the commands from registers or memory and determine how those commands will be processed within the GPGPU 1570. A thread dispatcher 1558 can then be used to dispatch threads to the compute units 1560A-1560N to perform those commands. Each compute unit 1560A-1560N can execute threads independently of the other compute units. Additionally, each compute unit 1560A-1560N can be independently configured for conditional computation and can conditionally output the results of computation to memory. The command processors 1557 can interrupt the one or more CPU(s) 1546 when the submitted commands are complete.

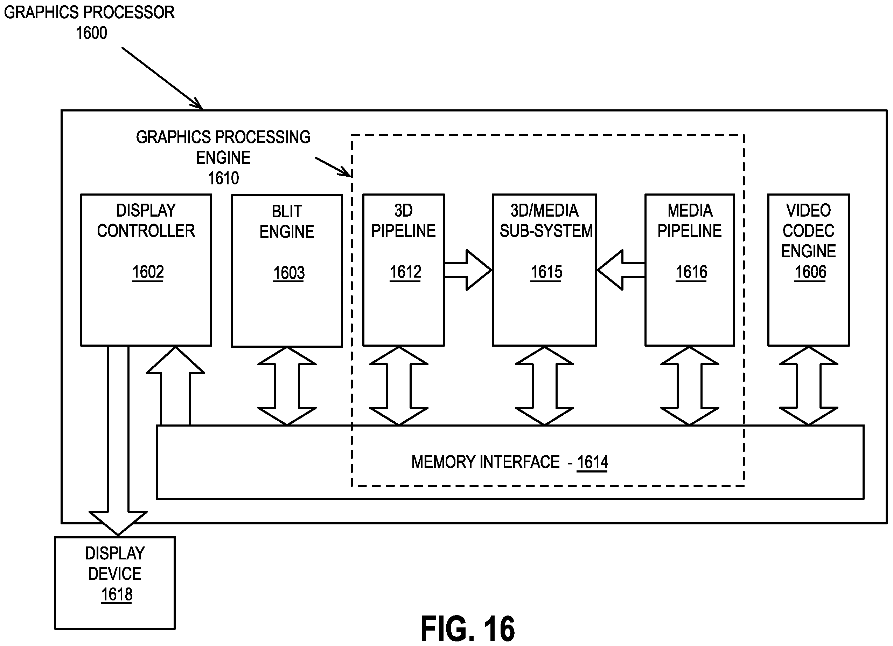

**FIG. 16** is a block diagram of a graphics processor 1600, which may be a discrete graphics processing unit, or may be a graphics processor integrated with a plurality of processing cores, or other semiconductor devices such as, but not limited to, memory devices or network interfaces. The elements of the graphics processor 1600 having the same or similar names as the elements of any other figure herein describe the same elements as in the other figures, can operate or function in a manner similar to that, can comprise the same components, and can be linked to other entities, as those described elsewhere herein, but are not limited to such. For example, the graphics processor 1600 may be a variant of the graphics processor 1508 and may be used in place of the graphics processor 1508. The graphics processor may communicate via a memory mapped I/O interface to registers on the graphics processor and with commands placed into the processor memory. The graphics processor 1600 may include a memory interface 1614 to access local memory, one or more internal caches, one or more shared external caches, and/or system memory.

The graphics processor 1600 can include a display controller 1602 to drive display output data to a display device 1618. Display controller 1602 includes hardware for one or more overlay planes for the display and composition of multiple layers of video or user interface elements. The display device 1618 can be an internal or external display device. In one embodiment the display device 1618 is a head mounted display device, such as a VR or AR display device. Graphics processor 1600 may include a video codec engine 1606 to encode, decode, or transcode media to, from, or between one or more media encoding formats, including, but not limited to Moving Picture Experts Group (MPEG) formats such as MPEG-2, Advanced Video Coding (AVC) formats such as H.264/MPEG-4 AVC, H.265/HEVC, Alliance for Open Media (AOMedia) VP8, VP9, as well as the Society of Motion Picture & Television Engineers (SMPTE) 421M/VC-1, and Joint Photographic Experts Group (JPEG) formats such as JPEG, and Motion JPEG (MJPEG) formats.

The graphics processor 1600 may include a block image transfer (BLIT) engine 1603 to perform two-dimensional (2D) rasterizer operations including, for example, bit-boundary block transfers, or 2D graphics operations may be performed using one or more components of graphics processing engine (GPE 1610). GPE 1610 may include a 3D pipeline 1612 for performing 3D operations, such as rendering three-dimensional images and scenes using processing functions that act upon 3D primitive shapes (e.g., rectangle, triangle, etc.). The 3D pipeline 1612 includes programmable and fixed function elements that perform various tasks within the element and/or spawn execution threads to a 3D/Media subsystem 1615. While 3D pipeline 1612 can be used to perform media operations, the GPE 1610 may also include a media pipeline 1616 that is specifically used to perform media operations, such as image or video decode, encode, post-processing, and enhancement. The media pipeline 1616 may include fixed function or programmable logic units to perform one or more specialized media operations, such as video decode acceleration, video de-interlacing, and video encode acceleration in place of, or on behalf of video codec engine 1606. Media pipeline 1616 may additionally include a thread spawning unit to spawn threads for execution on 3D/Media subsystem 1615. The spawned threads perform computations for the media operations on one or more graphics execution units included in 3D/Media subsystem 1615.

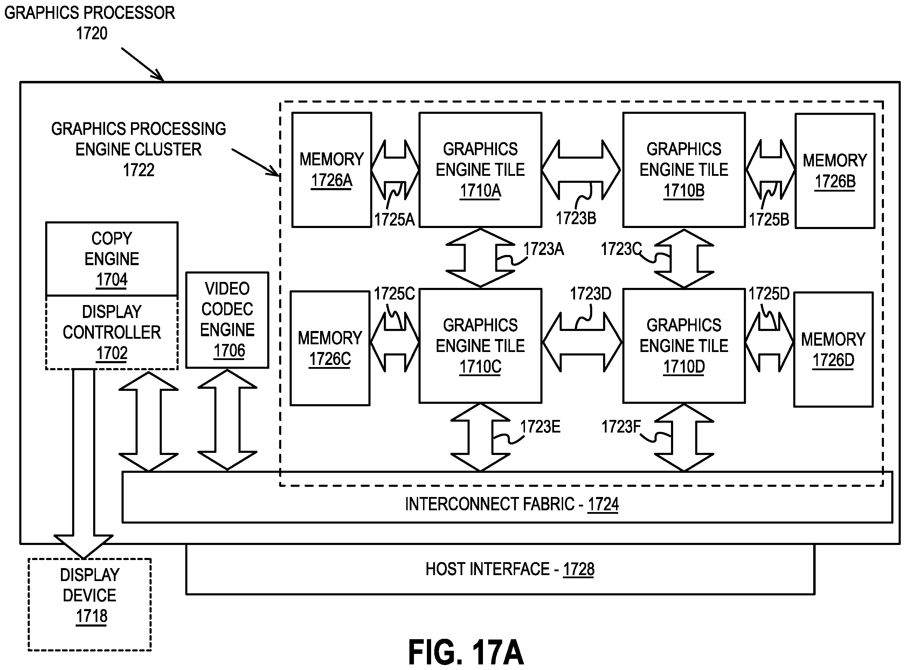

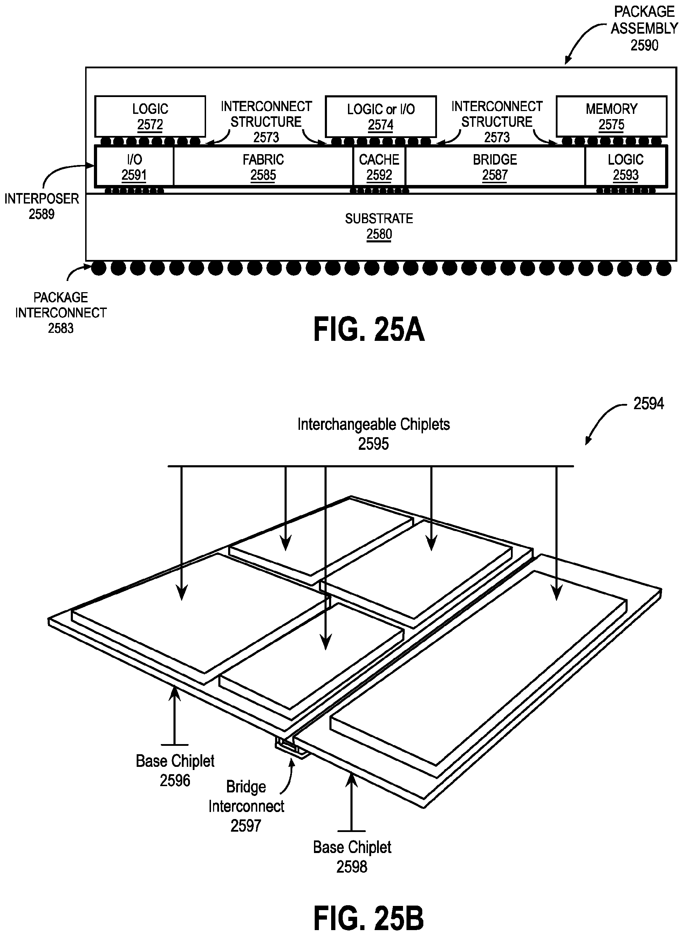

**FIG. 17A** illustrates a graphics processor 1720, being a variant of the graphics processor 1600 of FIG. 16 and may be used in place of the graphics processor 1600 and vice versa. Therefore, the disclosure of any features in combination with the graphics processor 1600 herein also discloses a corresponding combination with the graphics processor 1720 but is not limited to such. The graphics processor 1720 has a tiled architecture, according to embodiments described herein. The graphics processor 1720 may include a graphics processing engine cluster 1722 having multiple graphics processing engines within a plurality of graphics engine tiles. Each graphics engine tile 1710A-1710D can be interconnected via a set of tile interconnects 1723A-1723F. Each graphics engine tile 1710A-1710D can also be connected to a memory module or memory devices 1726A-1726D via memory interconnects 1725A-1725D. The memory devices 1726A-1726D can use any graphics memory technology. For example, the memory devices 1726A-1726D may be graphics double data rate (GDDR) memory. The memory devices 1726A-1726D may be high-bandwidth memory (HBM) modules that can be on-die with their respective graphics engine tile 1710A-1710D. The memory devices 1726A-1726D may be stacked memory devices that can be stacked on top of their respective graphics engine tile 1710A-1710D. Each graphics engine tile 1710A-1710D and associated memory devices 1726A-1726D may reside on separate chiplets, which are bonded to a base die or base substrate, as described in further detail in FIGS. 25A-25B.

The graphics processor 1720 may be configured with a non-uniform memory access (NUMA) system in which memory devices 1726A-1726D are coupled with associated graphics engine tiles 1710A-1710D. A given memory device may be accessed by graphics engine tiles other than the tile to which it is directly connected. However, access latency to the memory devices 1726A-1726D may be lowest when accessing a local tile. In one embodiment, a cache coherent NUMA (ccNUMA) system is enabled that uses the tile interconnects 1723A-1723F to enable communication between cache controllers within the graphics engine tiles 1710A-1710D to keep a consistent memory image when more than one cache stores the same memory location.

The graphics processing engine cluster 1722 can connect with an interconnect fabric 1724, which may interconnect with an on-chip or on-package fabric. In one embodiment the interconnect fabric 1724 includes a network processor, network on a chip (NoC), or another switching processor to enable the interconnect fabric 1724 to act as a packet switched interconnect fabric that switches data packets between components of the graphics processor 1720. The interconnect fabric 1724 can enable communication between graphics engine tiles 1710A-1710D and components such as the video codec engine 1706 and one or more copy engines 1704. The one or more copy engines 1704 can be used to move data out of, into, and between the memory devices 1726A-1726D and memory that is external to the graphics processor 1720 (e.g., system memory). The interconnect fabric 1724 can also be used to interconnect the graphics engine tiles 1710A-1710D. The graphics processor 1720 may optionally include a display controller 1702 to enable a connection with a display device 1718. The graphics processor may also be configured as a graphics or compute accelerator. In the accelerator configuration, the display controller 1702 and display device 1718 may be omitted.

The graphics processor 1720 can connect to a host system via a host interface 1728. The host interface 1728 can enable communication between the graphics processor 1720, system memory, and/or other system components. The host interface 1728 can be, for example, a PCI express bus or another type of host system interface. For example, the host interface 1728 may be an NVLink or NVSwitch interface. The host interface 1728 and interconnect fabric 1724 can cooperate to enable multiple instances of the graphics processor 1720 to act as single logical device. Cooperation between the host interface 1728 and interconnect fabric 1724 can also enable the individual graphics engine tiles 1710A-1710D to be presented to the host system as distinct logical graphics devices.

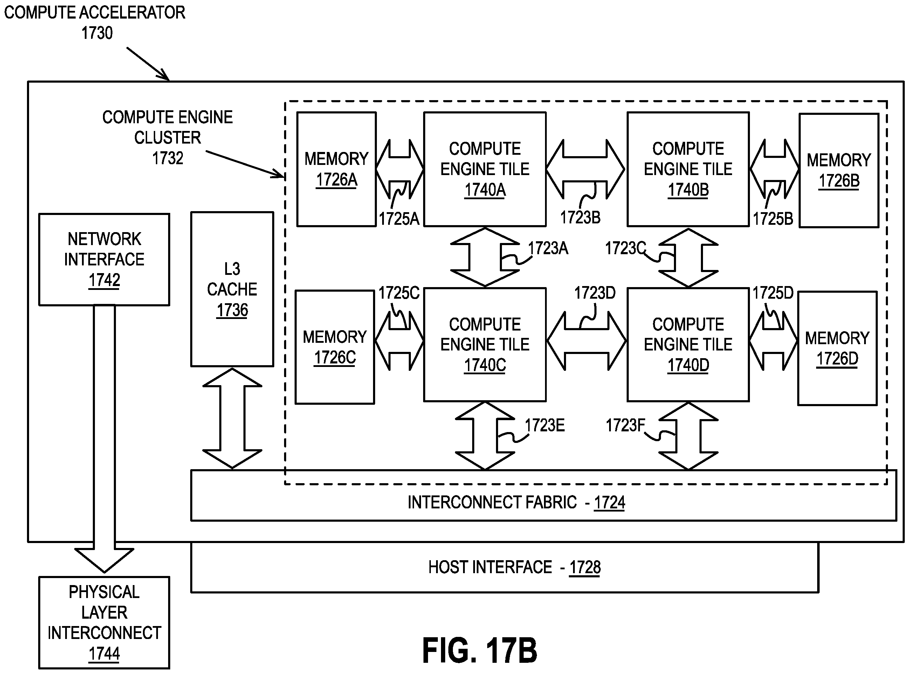

**FIG. 17B** illustrates a compute accelerator 1730, according to embodiments described herein. The compute accelerator 1730 can include architectural similarities with the graphics processor 1720 of FIG. 17B and is optimized for compute acceleration. A compute engine cluster 1732 can include a set of compute engine tiles 1740A-1740D that include execution logic that is optimized for parallel or vector-based general-purpose compute operations. In one embodiment, the compute accelerator 1730 may be configured as an AI accelerator or NPU. In such embodiment, the execution logic of the compute engine tiles 1740A-1740D may be directed primarily towards matrix or tensor operations and include tensor cores or matrix engines described herein. The compute engine tiles 1740A-1740D may not include fixed function graphics processing logic, although in some embodiments one or more of the compute engine tiles 1740A-1740D can include logic to perform media acceleration. The compute engine tiles 1740A-1740D can connect to the memory devices 1726A-1726D via memory interconnects 1725A-1725D. The memory devices 1726A-1726D and memory interconnects 1725A-1725D may be similar technology as in graphics processor 1720 or can be different. The compute engine tiles 1740A-1740D can also be interconnected via a set of tile interconnects 1723A-1723F and may be connected with and/or interconnected by the interconnect fabric 1724. In one embodiment the compute accelerator 1730 includes a large L3 cache 1736 that can be configured as a device-wide cache. The compute accelerator 1730 can also connect to a host processor and memory via a host interface 1728 in a similar manner as the graphics processor 1720 of FIG. 17B.

The compute accelerator 1730 can also include an integrated network interface 1742. In one embodiment the integrated network interface 1742 includes a network processor and controller logic that enables the compute engine cluster 1732 to communicate over a physical layer interconnect 1744 without requiring data to traverse memory of a host system. In one embodiment, one of the compute engine tiles 1740A-1740D is replaced by network processor logic and data to be transmitted or received via the physical layer interconnect 1744 may be transmitted directly to or from the memory devices 1726A-1726D. Multiple instances of the compute accelerator 1730 may be joined via the physical layer interconnect 1744 into a single logical device. Alternatively, the various compute engine tiles 1740A-1740D may be presented as distinct network accessible compute accelerator devices.

### Graphics Processing Resources

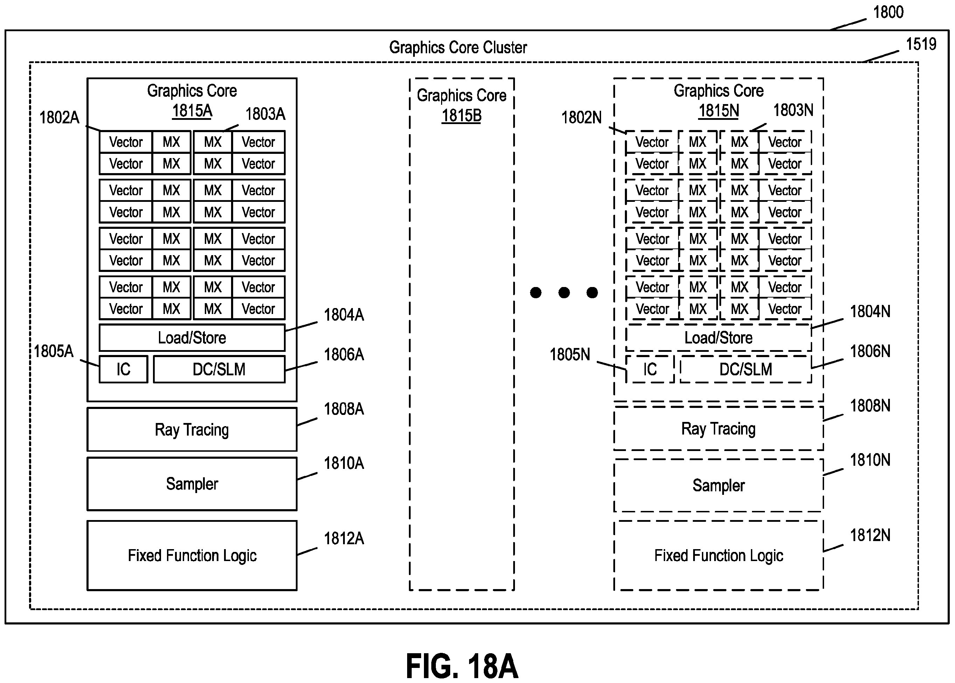

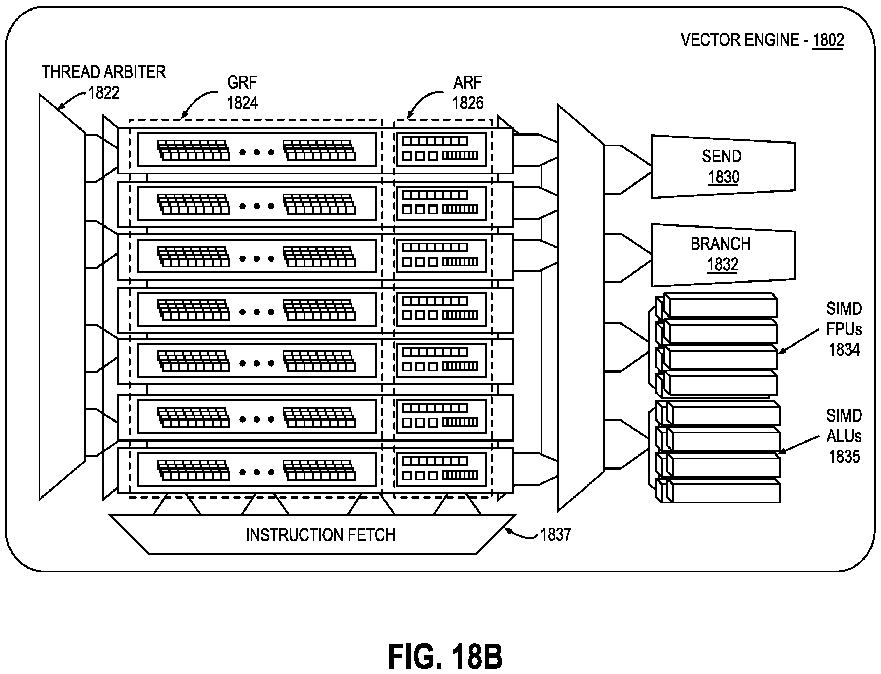

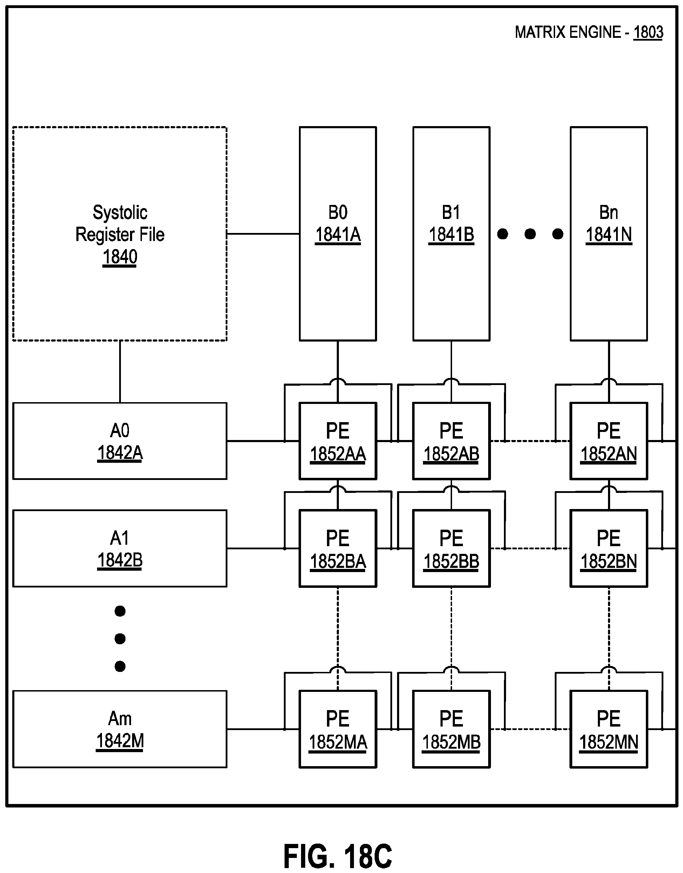

**FIGS. 18A-18C** illustrate execution logic including an array of processing elements employed in a graphics processor, according to embodiments described herein. **FIG. 18A** illustrates a graphics core cluster, according to an embodiment. **FIG. 18B** illustrates a vector engine of a graphics core, according to an embodiment. **FIG. 18C** illustrates a matrix engine of a graphics core, according to an embodiment. Elements of FIGS. 18A-18C having the same reference numbers as the elements of any other figure herein may operate or function in any manner similar to that described elsewhere herein but are not limited as such. For example, the elements of FIGS. 18A-18C can be considered in the context of the graphics processor core block 1519 of FIG. 15B. In one embodiment, the elements of FIGS. 18A-18C have similar functionality to equivalent components of the graphics processor 1508 of FIG. 15A or the GPGPU 1570 of FIG. 15C.

As shown in FIG. 18A, in one embodiment the graphics core cluster 1800 includes a graphics processor core block 1519, which can include any number of graphics cores (e.g., graphics core 1815A, graphics core 1815B, through graphics core 1815N). Multiple instances of the graphics processor core block 1519 may be included. In one embodiment the elements of the graphics cores 1815A-1815N have similar or equivalent functionality as the elements of the graphics cores 1521A-1521F of FIG. 15B. In such embodiment, the graphics cores 1815A-1815N each include circuitry including but not limited to vector engines 1802A-1802N, matrix engines 1803A-1803N, memory load/store units 1804A-1804N, instruction caches 1805A-1805N, data caches/shared local memory 1806A-1806N, ray tracing units 1808A-1808N, samplers 1810A-1810N. The circuitry of the graphics cores 1815A-1815N can additionally include fixed function logic 1812A-1812N. The number of vector engines 1802A-1802N and matrix engines 1803A-1803N within the graphics cores 1815A-1815N of a design can vary based on the workload, performance, and power targets for the design.

With reference to graphics core 1815A, the vector engine 1802A and matrix engine 1803A are configurable to perform parallel compute operations on data in a variety of integer and floating-point data formats based on instructions associated with shader programs. Each vector engine 1802A and matrix engine 1803A can act as a programmable general-purpose computational unit that is capable of executing multiple simultaneous hardware threads while processing multiple data elements in parallel for each thread. The vector engine 1802A and matrix engine 1803A support the processing of variable width vectors at various SIMD widths, including but not limited to SIMD8, SIMD16, and SIMD32. Input data elements can be stored as a packed data type in a register and the vector engine 1802A and matrix engine 1803A can process the various elements based on the data size of the elements. For example, when operating on a 256-bit wide vector, the bits of the vector are stored in a register and the vector is processed as four separate 64-bit packed data elements (Quad-Word (QW) size data elements), eight separate 32-bit packed data elements (Double Word (DW) size data elements), sixteen separate 16-bit packed data elements (Word (W) size data elements), or thirty-two separate 8-bit data elements (byte (B) size data elements). However, different vector widths and register sizes are possible. In one embodiment, the vector engine 1802A and matrix engine 1803A are also configurable for SIMT operation on warps or thread groups of various sizes (e.g., 8, 16, or 32 threads).

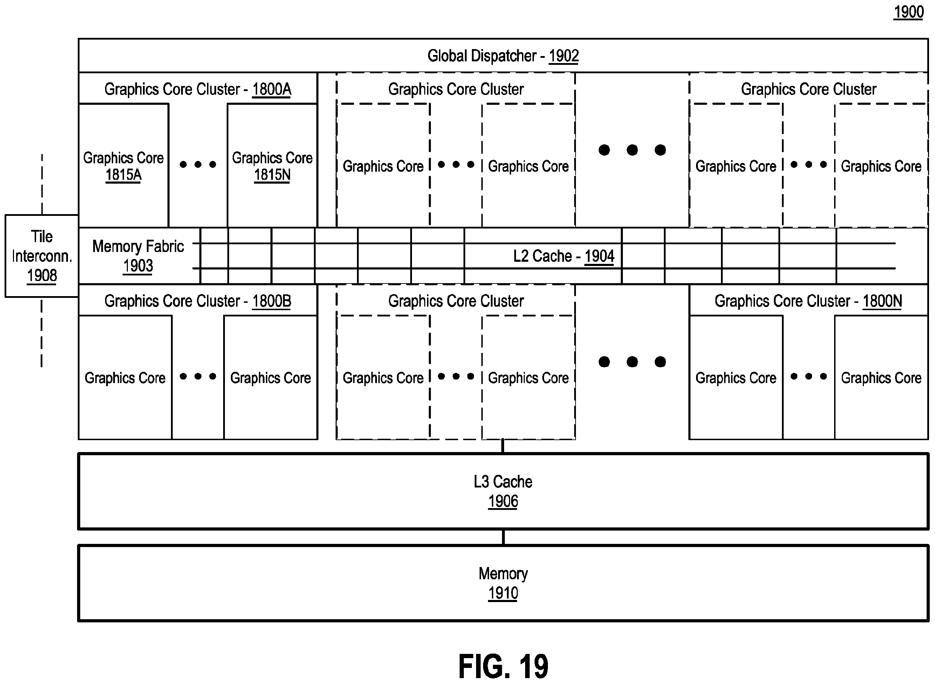

Continuing with graphics core 1815A, the memory load/store unit 1804A services memory access requests that are issued by the vector engine 1802A, matrix engine 1803A, and/or other components of the graphics core 1815A that have access to memory. The memory access request can be processed by the memory load/store unit 1804A to load or store the requested data to or from cache or memory into a register file associated with the vector engine 1802A and/or matrix engine 1803A. The memory load/store unit 1804A can also perform prefetching operations. With additional reference to FIG. 19, in one embodiment, the memory load/store unit 1804A is configured to provide SIMT scatter/gather prefetching or block prefetching for data stored in memory 1910, from memory that is local to other tiles via the tile interconnect 1908, or from system memory. Prefetching can be performed to a specific L1 cache (e.g., data cache/shared local memory 1806A), the L2 cache 1904 or the L3 cache 1906. In one embodiment, a prefetch to the L3 cache 1906 automatically results in the data being stored in the L2 cache 1904.

The instruction cache 1805A stores instructions to be executed by the graphics core 1815A. In one embodiment, the graphics core 1815A also includes instruction fetch and prefetch circuitry that fetches or prefetches instructions into the instruction cache 1805A. The graphics core 1815A also includes instruction decode logic to decode instructions within the instruction cache 1805A. The data cache/shared local memory 1806A can be configured as a data cache that is managed by a cache controller that implements a cache replacement policy and/or configured as explicitly managed shared memory. The ray tracing unit 1808A includes circuitry to accelerate ray tracing operations. The sampler 1810A provides texture sampling for 3D operations and media sampling for media operations. The fixed function logic 1812A includes fixed function circuitry that is shared between the various instances of the vector engine 1802A and matrix engine 1803A. Graphics cores 1815B-1815N can operate in a similar manner as graphics core 1815A.

Functionality of the instruction caches 1805A-1805N, data caches/shared local memory 1806A-1806N, ray tracing units 1808A-1808N, samplers 1810A-1810N, and fixed function logic 1812A-1812N corresponds with equivalent functionality in the graphics processor architectures described herein. For example, the instruction caches 1805A-1805N can operate in a similar manner as instruction cache 1555 of FIG. 15C. The data caches/shared local memory 1806A-1806N, ray tracing units 1808A-1808N, and samplers 1810A-1810N can operate in a similar manner as the cache/SLM 1528A-1528F, ray tracing units 1527A-1527F, and samplers 1526A-1526F of FIG. 15B. The fixed function logic 1812A-1812N can include elements of the geometry/fixed function pipeline 1531 and/or additional fixed function logic 1538 of FIG. 15B. In one embodiment, the ray tracing units 1808A-1808N include circuitry to perform ray tracing acceleration operations performed by the ray tracing cores 372 of FIG. 3.

As shown in FIG. 18B, in one embodiment the vector engine 1802 includes an instruction fetch unit 1837, a general register file array (GRF 1824), an architectural register file array (ARF 1826), a thread arbiter 1822, a send unit 1830, a branch unit 1832, SIMD FPUs 1834, and in one embodiment, SIMD ALUs 1835. The GRF 1824 and ARF 1826 includes the set of general register files and architecture register files associated with each hardware thread that may be active in the vector engine 1802. In one embodiment, per thread architectural state is maintained in the ARF 1826, while data used during thread execution is stored in the GRF 1824. The execution state of each thread, including the instruction pointers for each thread, can be held in thread-specific registers in the ARF 1826. Register renaming may be used to dynamically allocate registers to hardware threads.

In one embodiment, the vector engine 1802 has an architecture that is a combination of Simultaneous Multi-Threading (SMT) and fine-grained Interleaved Multi-Threading (IMT). The architecture has a modular configuration that can be fine-tuned at design time based on a target number of simultaneous threads and number of registers per graphics core, where graphics core resources are divided across logic used to execute multiple simultaneous threads. The number of logical threads that may be executed by the vector engine 1802 is not limited to the number of hardware threads, and multiple logical threads can be assigned to each hardware thread.

In one embodiment, the vector engine 1802 can co-issue multiple instructions, which may each be different instructions. The thread arbiter 1822 can dispatch the instructions to one of the send unit 1830, branch unit 1832, or SIMD FPUs 1834 for execution. Each execution thread can access 128 general-purpose registers within the GRF 1824, where each register can store 32 bytes, accessible as a variable width vector of 32-bit data elements. In one embodiment, each thread has access to 4 Kbytes within the GRF 1824, although embodiments are not so limited, and greater or fewer register resources may be provided in other embodiments. In one embodiment the vector engine 1802 is partitioned into seven hardware threads that can independently perform computational operations, although the number of threads per vector engine 1802 can also vary according to embodiments. For example, in one embodiment up to 16 hardware threads are supported. In an embodiment in which seven threads may access 4 Kbytes, the GRF 1824 can store a total of 28 Kbytes. Where 16 threads may access 4Kbytes, the GRF 1824 can store a total of 64Kbytes. Flexible addressing modes can permit registers to be addressed together to build effectively wider registers or to represent strided rectangular block data structures.

In one embodiment, memory operations, sampler operations, and other longer-latency system communications are dispatched via "send" instructions that are executed by the message passing send unit 1830. In one embodiment, branch instructions are dispatched to the branch unit 1832 to facilitate SIMD divergence and eventual convergence.

In one embodiment the SIMD FPUs 1834 of the vector engine 1802 perform floating-point operations. In one embodiment, the SIMD FPUs 1834 also support integer computation. In one embodiment the SIMD FPUs 1834 can execute up to M number of 32-bit floating-point (or integer) operations, or execute up to 2M 16-bit integer or 16-bit floating-point operations. In one embodiment, at least one of the FPUs provides extended math capability to support high-throughput transcendental math functions and double precision 64-bit floating-point. In some embodiments, SIMD ALUs 1835 configured to perform 8-bit integer operations are also present and may be specifically optimized to perform operations associated with machine learning computations. In one embodiment, the SIMD ALUs 1835 are replaced by SIMD FPUs 1834 that are configurable to perform integer and floating-point operations. In one embodiment, the SIMD FPUs 1834 and SIMD ALUs 1835 are configurable to execute SIMT programs. In one embodiment, combined SIMD+SIMT operation is supported.

In one embodiment, arrays of multiple instances of the vector engine 1802 can be instantiated in a graphics core. For scalability, product architects can choose the exact number of vector engines per graphics core grouping. In one embodiment the vector engine 1802 can execute instructions across a plurality of execution channels. In a further embodiment, each thread executed on the vector engine 1802 is executed on a different channel.

As shown in FIG. 18C, in one embodiment the matrix engine 1803 includes an array of processing elements that are configured to perform tensor operations including vector/matrix and matrix/matrix operations, such as but not limited to matrix multiply and/or dot product operations. The matrix engine 1803 is configured with M rows and N columns of processing elements 1852AA-1852MN that include multiplier and adder circuits organized in a pipelined fashion. In one embodiment, the processing elements 1852AA- 1852MN make up the physical pipeline stages of an N wide and M deep systolic array that can be used to perform vector/matrix or matrix/matrix operations in a data-parallel manner, including matrix multiply, fused multiply-add, dot product or other general matrix-matrix multiplication (GEMM) operations. In one embodiment the matrix engine 1803 supports 16-bit and 8-bit floating-point operations, as well as 8-bit, 4-bit, 2-bit, and binary integer operations. The matrix engine 1803 can also be configured to accelerate specific machine learning operations. In such embodiments, the matrix engine 1803 can be configured with support for the bfloat (brain floating-point) 16-bit floating-point format or a tensor float 32-bit floating-point format (TF32) that have different numbers of mantissa and exponent bits relative to Institute of Electrical and Electronics Engineers (IEEE) 754 formats.

In one embodiment, during each cycle, each stage can add the result of operations performed at that stage to the output of the previous stage. In other embodiments, the pattern of data movement between the processing elements 1852AA-1852MN after a set of computational cycles can vary based on the instruction or macro-operation being performed. For example, in one embodiment partial sum loopback is enabled and the processing elements may instead add the output of a current cycle with output generated in the previous cycle. In one embodiment, the final stage of the systolic array can be configured with a loopback to the initial stage of the systolic array. In such embodiment, the number of physical pipeline stages may be decoupled from the number of logical pipeline stages that are supported by the matrix engine 1803. For example, where the processing elements 1852AA-1852MN are configured as a systolic array of M physical stages, a loopback from stage M to the initial pipeline stage can enable the processing elements 1852AA-1852MN to operate as a systolic array of, for example, 2M, 3M, 4M, etc., logical pipeline stages.

In one embodiment, the matrix engine 1803 includes memory 1841A-1841N, 1842A-1842M to store input data in the form of row and column data for input matrices. Memory 1842A-1842M is configurable to store row elements (A0-Am) of a first input matrix and memory 1841A-1841N is configurable to store column elements (B0-Bn) of a second input matrix. The row and column elements are provided as input to the processing elements 1852AA-1852MN for processing. In one embodiment, row and column elements of the input matrices can be stored in a systolic register file 1840 within the matrix engine 1803 before those elements are provided to the memory 1841A-1841N, 1842A-1842M. In one embodiment, the systolic register file 1840 is excluded and the memory 1841A-1841N, 1842A-1842M is loaded from registers in an associated vector engine (e.g., GRF 1824 of vector engine 1802 of FIG. 18B) or other memory of the graphics core that includes the matrix engine 1803 (e.g., data cache/shared local memory 1806A for matrix engine 1803A of FIG. 18A). Results generated by the processing elements 1852AA-1852MN are then output to an output buffer and/or written to a register file (e.g., systolic register file 1840, GRF 1824, data cache/shared local memory 1806A-1806N) for further processing by other functional units of the graphics processor or for output to memory.

In some embodiments, the matrix engine 1803 is configured with support for input sparsity, where multiplication operations for sparse regions of input data can be bypassed by skipping multiply operations that have a zero-value operand. In one embodiment, the processing elements 1852AA-1852MN are configured to skip the performance of certain operations that have zero value input. In one embodiment, sparsity within input matrices can be detected and operations having known zero output values can be bypassed before being submitted to the processing elements 1852AA-1852MN. The loading of zero value operands into the processing elements can be bypassed and the processing elements 1852AA-1852MN can be configured to perform multiplications on the non-zero value input elements. The matrix engine 1803 can also be configured with support for output sparsity, such that operations with results that are pre-determined to be zero are bypassed. For input sparsity and/or output sparsity, in one embodiment, metadata is provided to the processing elements 1852AA-1852MN to indicate, for a processing cycle, which processing elements and/or data channels are to be active during that cycle.

In one embodiment, the matrix engine 1803 includes hardware to enable operations on sparse data having a compressed representation of a sparse matrix that stores non-zero values and metadata that identifies the positions of the non-zero values within the matrix. Exemplary compressed representations include but are not limited to compressed tensor representations such as compressed sparse row (CSR), compressed sparse column (CSC), compressed sparse fiber (CSF) representations. Support for compressed representations enable operations to be performed on input in a compressed tensor format without requiring the compressed representation to be decompressed or decoded. In such embodiment, operations can be performed only on non-zero input values and the resulting non-zero output values can be mapped into an output matrix. In some embodiments, hardware support is also provided for machine-specific lossless data compression formats that are used when transmitting data within hardware or across system buses. Such data may be retained in a compressed format for sparse input data and the matrix engine 1803 can use the compression metadata for the compressed data to enable operations to be performed on only non-zero values, or to enable blocks of zero data input to be bypassed for multiply operations.

In various embodiments, input data can be provided by a programmer in a compressed tensor representation, or a codec can compress input data into the compressed tensor representation or another sparse data encoding. In addition to support for compressed tensor representations, streaming compression of sparse input data can be performed before the data is provided to the processing elements 1852AA-1852MN. In one embodiment, compression is performed on data written to a cache memory associated with the graphics core cluster 1800, with the compression being performed with an encoding that is supported by the matrix engine 1803. In one embodiment, the matrix engine 1803 includes support for input having structured sparsity in which a pre-determined level or pattern of sparsity is imposed on input data. This data may be compressed to a known compression ratio, with the compressed data being processed by the processing elements 1852AA-1852MN according to metadata associated with the compressed data.

**FIG. 19** illustrates a tile 1900 of a multi-tile processor, according to an embodiment. In one embodiment, the tile 1900 is representative of one of the graphics engine tiles 1710A-1710D of FIG. 17A or compute engine tiles 1740A-1740D of FIG. 17B. The tile 1900 of the multi-tile graphics processor includes an array of graphics core clusters (e.g., graphics core cluster 1800A, graphics core cluster 1800B, through graphics core cluster 1800N), with each graphics core cluster having an array of graphics cores 515A-515N. The tile 1900 also includes a global dispatcher 1902 to dispatch threads to processing resources of the tile 1900.

The tile 1900 can include or couple with an L3 cache 1906 and memory 1910. In various embodiments, the L3 cache 1906 may be excluded or the tile 1900 can include additional levels of cache, such as an L4 cache. In one embodiment, each instance of the tile 1900 in the multi-tile graphics processor is associated with memory 1910, such as in FIG. 17A and FIG. 17B. In one embodiment, a multi-tile processor can be configured as a multi-chip module in which the L3 cache 1906 and/or memory 1910 reside on separate chiplets than the graphics core clusters 1800A-1800N. In this context, a chiplet is an at least partially packaged integrated circuit that includes distinct units of logic that can be assembled with other chiplets into a larger package. For example, the L3 cache 1906 can be included in a dedicated cache chiplet or can reside on the same chiplet as the graphics core clusters 1800A-1800N. In one embodiment, the L3 cache 1906 can be included in an active base die or active interposer.

A memory fabric 1903 enables communication among the graphics core clusters 1800A-1800N, L3 cache 1906, and memory 1910. An L2 cache 1904 couples with the memory fabric 1903 and is configurable to cache transactions performed via the memory fabric 1903. A tile interconnect 1908 enables communication with other tiles on the graphics processors and may be one of tile interconnects 1723A-1723F of FIGS. 17A and 17B. In embodiments in which the L3 cache 1906 is excluded from the tile 1900, the L2 cache 1904 may be configured as a combined L2/L3 cache. The memory fabric 1903 is configurable to route data to the L3 cache 1906 or memory controllers associated with the memory 1910 based on the presence or absence of the L3 cache 1906 in a specific implementation. The L3 cache 1906 can be configured as a per-tile cache that is dedicated to processing resources of the tile 1900 or may be a partition of a GPU-wide L3 cache.

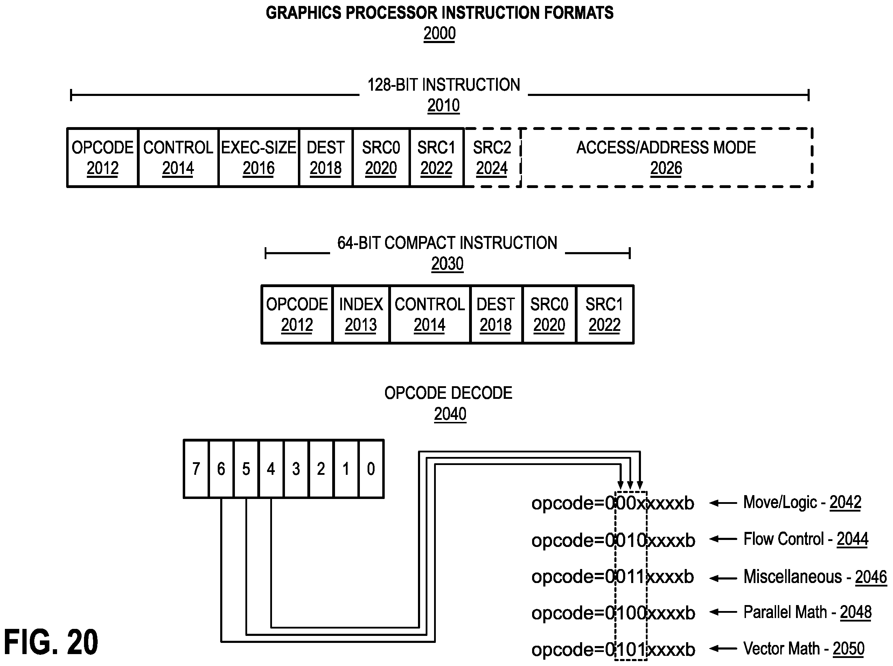

**FIG. 20** is a block diagram illustrating graphics processor instruction formats 2000. The graphics processor execution units support an instruction set having instructions in multiple formats. The solid lined boxes illustrate the components that are generally included in an execution unit instruction, while the dashed lines include components that are optional or that are only included in a sub-set of the instructions. In some embodiments the graphics processor instruction formats 2000 described and illustrated are macro-instructions, in that they are instructions supplied to the execution unit, as opposed to micro-operations resulting from instruction decode once the instruction is processed. Thus, a single instruction may cause hardware to perform multiple micro-operations.

The graphics processor execution units as described herein may natively support instructions in a 128-bit instruction format 2010. A compacted 64-bit instruction format 2030 is available for some instructions based on the selected instruction, instruction options, and number of operands. The native 128-bit instruction format 2010 provides access to all instruction options, while some options and operations are restricted in the 64-bit instruction format 2030. The native instructions available in the 64-bit instruction format 2030 vary by embodiment. The instruction is compacted in part using a set of index values in an index field 2013. The execution unit hardware references a set of compaction tables based on the index values and uses the compaction table outputs to reconstruct a native instruction in the 128-bit instruction format 2010. Other sizes and formats of instruction can be used.

For each format, instruction opcode 2012 defines the operation that the execution unit is to perform. The execution units execute each instruction in parallel across the multiple data elements of each operand. For example, in response to an add instruction the execution unit performs a simultaneous add operation across each color channel representing a texture element or picture element. By default, the execution unit performs each instruction across all data channels of the operands. Instruction control field 2014 may enable control over certain execution options, such as channels selection (e.g., predication) and data channel order (e.g., swizzle). For instructions in the 128-bit instruction format 2010 an exec-size field 2016 limits the number of data channels that will be executed in parallel. An exec-size field 2016 may not be available for use in the compacted 64-bit instruction format 2030.

Some execution unit instructions have up to three operands including two source operands, src0 2020, src1 2022, and one destination operand (dest 2018). Other instructions, such as, for example, data manipulation instructions, dot product instructions, multiply-add instructions, or multiply-accumulate instructions, can have a third source operand (e.g., SRC2 2024). The instruction opcode 2012 determines the number of source operands. An instruction's last source operand can be an immediate (e.g., hard-coded) value passed with the instruction. The execution units may also support multiple destination instructions, where one or more of the destinations is implied or implicit based on the instruction and/or the specified destination.

The 128-bit instruction format 2010 may include an access/address mode field 2026 specifying, for example, whether direct register addressing mode or indirect register addressing mode is used. When direct register addressing mode is used, the register address of one or more operands is directly provided by bits in the instruction.

The 128-bit instruction format 2010 may also include an access/address mode field 2026, which specifies an address mode and/or an access mode for the instruction. The access mode may be used to define a data access alignment for the instruction. Access modes including a 16-byte aligned access mode and a 1-byte aligned access mode may be supported, where the byte alignment of the access mode determines the access alignment of the instruction operands. For example, when in a first mode, the instruction may use byte-aligned addressing for source and destination operands and when in a second mode, the instruction may use 16-byte-aligned addressing for all source and destination operands.

The address mode portion of the access/address mode field 2026 may determine whether the instruction is to use direct or indirect addressing. When direct register addressing mode is used bits in the instruction directly provide the register address of one or more operands. When indirect register addressing mode is used, the register address of one or more operands may be computed based on an address register value and an address immediate field in the instruction.

Instructions may be grouped based on instruction opcode 2012 bit-fields to simplify Opcode decode 2040. For an 8-bit opcode, bits 4, 5, and 6 allow the execution unit to determine the type of opcode. The precise opcode grouping shown is merely an example. A move and logic opcode group 2042 may include data movement and logic instructions (e.g., move (mov), compare (cmp)). The move and logic opcode group 2042 may share the five least significant bits (LSB), where move (mov) instructions are in the form of 0000xxxxb and logic instructions are in the form of 0001xxxxb. A flow control instruction group 2044 (e.g., call, jump (jmp)) includes instructions in the form of 0010xxxxb (e.g., 0x20). A miscellaneous instruction group 2046 includes a mix of instructions, including synchronization instructions (e.g., wait, send) in the form of 001 1xxxxb (e.g., 0x30). A parallel math instruction group 2048 includes component-wise arithmetic instructions (e.g., add, multiply (mul)) in the form of 0100xxxxb (e.g., 0x40). The parallel math instruction group 2048 performs the arithmetic operations in parallel across data channels. The vector math group 2050 includes arithmetic instructions (e.g., dp4) in the form of 0101xxxxb (e.g., 0x50). The vector math group performs arithmetic such as dot product calculations on vector operands. The opcode decode 2040, in one embodiment, can be used to determine which portion of an execution unit will be used to execute a decoded instruction. For example, some instructions may be designated as systolic instructions that will be performed by a systolic array. Other instructions, such as ray-tracing instructions (not shown) can be routed to a ray-tracing core or ray-tracing logic within a slice or partition of execution logic.

### Graphics Pipeline

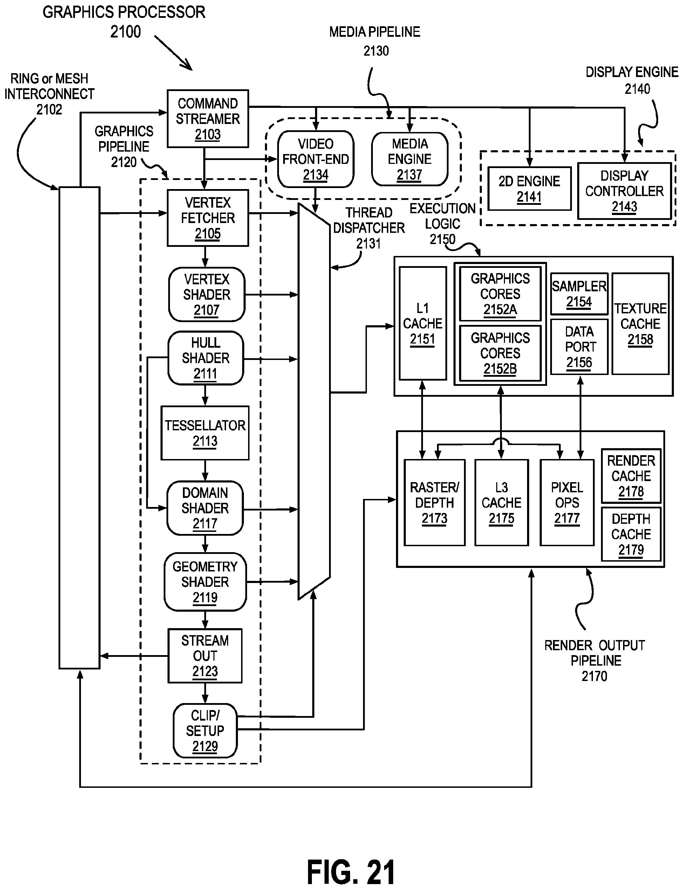

**FIG. 21** is a block diagram of a graphics processor 2100, according to another embodiment. The elements of FIG. 21 having the same or similar names as the elements of any other figure herein describe the same elements as in the other figures, can operate or function in a manner similar to that, can comprise the same components, and can be linked to other entities, as those described elsewhere herein, but are not limited to such.

The graphics processor 2100 may include different types of graphics processing pipelines, such as a geometry pipeline 2120, a media pipeline 2130, a display engine 2140, thread execution logic 2150, and a render output pipeline 2170. The graphics processor 2100 may be a graphics processor within a multi-core processing system that includes one or more general-purpose processing cores. The graphics processor may be controlled by register writes to one or more control registers (not shown) or via commands issued to the graphics processor 2100 via a ring or mesh interconnect 2102. The ring or mesh interconnect 2102 may couple the graphics processor 2100 to other processing components, such as other graphics processors or general-purpose processors. Commands from ring or mesh interconnect 2102 are interpreted by a command streamer 2103, which supplies instructions to individual components of the geometry pipeline 2120 or the media pipeline 2130.

Command streamer 2103 may direct the operation of a vertex fetcher 2105 that reads vertex data from memory and executes vertex-processing commands provided by command streamer 2103. The vertex fetcher 2105 may provide vertex data to a vertex shader 2107, which performs coordinate space transformation and lighting operations to each vertex. Vertex fetcher 2105 and vertex shader 2107 may execute vertex-processing instructions by dispatching execution threads to graphics cores 2152A-2152B via a thread dispatcher 2131.

The graphics cores 2152A-2152B may be an array of vector processors having an instruction set for performing graphics and media operations. The graphics cores 2152A-2152B may have an attached L1 cache 2151 that is specific for each array or shared between the arrays. The cache can be configured as a data cache, an instruction cache, or a single cache that is partitioned to contain data and instructions in different partitions.

A geometry pipeline 2120 may include tessellation components to perform hardware-accelerated tessellation of 3D objects. A programmable hull shader 2111 may configure the tessellation operations. A programmable domain shader 2117 may provide back-end evaluation of tessellation output. A tessellator 2113 may operate at the direction of a programmable hull shader 2111 and contain special purpose logic to generate a set of detailed geometric objects based on a coarse geometric model that is provided as input to geometry pipeline 2120. In addition, if tessellation is not used, tessellation components (e.g., programmable hull shader 2111, tessellator 2113, and programmable domain shader 2117) can be bypassed. The tessellation components can operate based on data received from the vertex shader 2107.

Complete geometric objects may be processed by a geometry shader 2119 via one or more threads dispatched to graphics cores 2152A-2152B, or can proceed directly to the clipper 2129. The geometry shader may operate on entire geometric objects, rather than vertices or patches of vertices as in previous stages of the graphics pipeline. If the tessellation is disabled, the geometry shader 2119 receives input from the vertex shader 2107. The geometry shader 2119 may be programmable by a geometry shader program to perform geometry tessellation if the tessellation units are disabled.

Before rasterization, a clipper 2129 processes vertex data. The clipper 2129 may be a fixed function clipper or a programmable clipper having clipping and geometry shader functions. A rasterizer and depth test component 2173 in the render output pipeline 2170 may dispatch pixel shaders to convert the geometric objects into per pixel representations. The pixel shader logic may be included in thread execution logic 2150. Optionally, an application can bypass the rasterizer and depth test component 2173 and access un-rasterized vertex data via a stream out unit 2123.

The graphics processor 2100 has an interconnect bus, interconnect fabric, or some other interconnect mechanism that allows data and message passing amongst the major components of the processor. In some embodiments, graphics cores 2152A-2152B and associated logic units (e.g., L1 cache 2151, sampler 2154, texture cache 2158, etc.) interconnect via a data port 2156 to perform memory access and communicate with render output pipeline components of the processor. A sampler 2154, L1 cache 2151, texture cache 2158 and graphics cores 2152A-2152B each may have separate memory access paths. Optionally, the texture cache 2158 can also be configured as a sampler cache.

The render output pipeline 2170 may contain a rasterizer and depth test component 2173 that converts vertex-based objects into an associated pixel-based representation. The rasterizer logic may include a windower/masker unit to perform fixed function triangle and line rasterization. An associated render cache 2178 and depth cache 2179 are also available in some embodiments. A pixel operations component 2177 performs pixel-based operations on the data, though in some instances, pixel operations associated with 2D operations (e.g., bit block image transfers with blending) are performed by the 2D engine 2141 or substituted at display time by the display controller 2143 using overlay display planes. A shared L3 cache 2175 may be available to all graphics components, allowing the sharing of data without the use of main system memory.

The media pipeline 2130 may include a media engine 2137 and a video front-end 2134. Video front-end 2134 may receive pipeline commands from the command streamer 2103. The media pipeline 2130 may include a separate command streamer. Video front-end 2134 may process media commands before sending the command to the media engine 2137. Media engine 2137 may include thread spawning functionality to spawn threads for dispatch to thread execution logic 2150 via thread dispatcher 2131.

The graphics processor 2100 may include a display engine 2140. This display engine 2140 may be external to the graphics processor 2100 and may couple with the graphics processor via the ring or mesh interconnect 2102, or some other interconnect bus or fabric. Display engine 2140 may include a 2D engine 2141 and a display controller 2143. Display engine 2140 may contain special purpose logic capable of operating independently of the 3D pipeline. Display controller 2143 may couple with a display device (not shown), which may be a system integrated display device, as in a laptop computer, or an external display device attached via a display device connector.

The geometry pipeline 2120 and media pipeline 2130 maybe configurable to perform operations based on multiple graphics and media programming interfaces and are not specific to any one application programming interface (API). A driver software for the graphics processor may translate API calls that are specific to a particular graphics or media library into commands that can be processed by the graphics processor. Support may be provided for the Open Graphics Library (OpenGL), Open Computing Language (OpenCL), and/or Vulkan graphics and compute API, all from the Khronos Group. Support may also be provided for the Direct3D library from the Microsoft Corporation. A combination of these libraries may be supported. Support may also be provided for the Open Source Computer Vision Library (OpenCV). A future API with a compatible 3D pipeline would also be supported if a mapping can be made from the pipeline of the future API to the pipeline of the graphics processor.

### Graphics Pipeline Programming

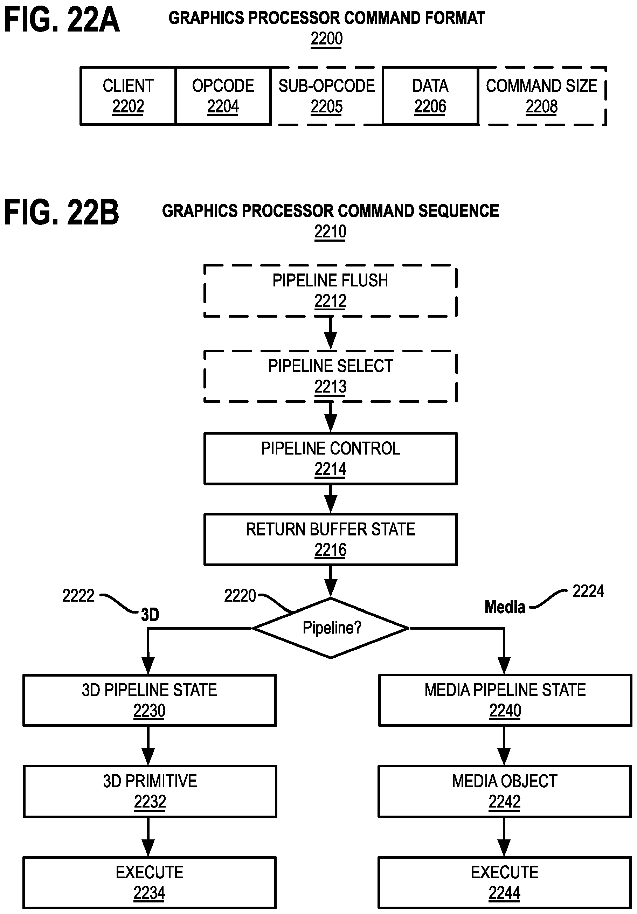

**FIG. 22A** is a block diagram illustrating a graphics processor command format 2200 used for programming graphics processing pipelines, such as, for example, the pipelines described herein in conjunction with FIG. 16 and FIG. 21. **FIG. 22B** is a block diagram illustrating a graphics processor command sequence 2210 according to an embodiment. The solid lined boxes in **FIG. 22A** illustrate the components that are generally included in a graphics command while the dashed lines include components that are optional or that are only included in a sub-set of the graphics commands. The graphics processor command format 2200 of **FIG. 22A** includes fields to identify a client 2202, a command operation code (opcode 2204), and a data field 2206 for the command. A sub-opcode 2205 and a command size 2208 are also included in some commands.

Client 2202 may specify the client unit of the graphics device that processes the command data. A graphics processor command parser may examine the client field of each command to condition the further processing of the command and route the command data to the appropriate client unit. The graphics processor client units may include a memory interface unit, a render unit, a 2D unit, a 3D unit, and a media unit. Each client unit may have a corresponding processing pipeline that processes the commands. Once the command is received by the client unit, the client unit reads the opcode 2204 and, if present, sub-opcode 2205 to determine the operation to perform. The client unit performs the command using information in data field 2206. For some commands, a command size 2208 is expected to explicitly specify the size of the command. The command parser may automatically determine the size of at least some of the commands based on the command opcode. Commands may be aligned via multiples of a double word. Other command formats can also be used.

The flow diagram in **FIG. 22B** illustrates a graphics processor command sequence 2210. Software or firmware of a data processing system that features an exemplary graphics processor may use a version of the command sequence shown to set up, execute, and terminate a set of graphics operations. A sample command sequence is shown and described for purposes of example only and is not limited to these specific commands or to this command sequence. Moreover, the commands may be issued as batch of commands in a command sequence, such that the graphics processor will process the sequence of commands at least partially in concurrence.

The graphics processor command sequence 2210 may begin with a pipeline flush command 2212 to cause any active graphics pipeline to complete the currently pending commands for the pipeline. Optionally, the 3D pipeline 2222 and the media pipeline 2224 may not operate concurrently. The pipeline flush is performed to cause the active graphics pipeline to complete any pending commands. In response to a pipeline flush, the command parser for the graphics processor will pause command processing until the active drawing engines complete pending operations and the relevant read caches are invalidated. Optionally, any data in the render cache that is marked 'dirty' can be flushed to memory. Pipeline flush command 2212 can be used for pipeline synchronization or before placing the graphics processor into a low power state.

A pipeline select command 2213 may be used when a command sequence requires the graphics processor to explicitly switch between pipelines. A pipeline select command 2213 may be required only once within an execution context before issuing pipeline commands unless the context is to issue commands for both pipelines. A pipeline flush command 2212 may be required immediately before a pipeline switch via the pipeline select command 2213.

A pipeline control command 2214 may configure a graphics pipeline for operation and may be used to program the 3D pipeline 2222 and the media pipeline 2224. The pipeline control command 2214 may configure the pipeline state for the active pipeline. The pipeline control command 2214 may be used for pipeline synchronization and to clear data from one or more cache memories within the active pipeline before processing a batch of commands.

Commands related to the return buffer state 2216 may be used to configure a set of return buffers for the respective pipelines to write data. Some pipeline operations require the allocation, selection, or configuration of one or more return buffers into which the operations write intermediate data during processing. The graphics processor may also use one or more return buffers to store output data and to perform cross thread communication. The return buffer state 2216 may include selecting the size and number of return buffers to use for a set of pipeline operations.

The remaining commands in the command sequence differ based on the active pipeline for operations. Based on a pipeline determination 2220, the command sequence is tailored to the 3D pipeline 2222 beginning with the 3D pipeline state 2230 or the media pipeline 2224 beginning at the media pipeline state 2240.

The commands to configure the 3D pipeline state 2230 include 3D state setting commands for vertex buffer state, vertex element state, constant color state, depth buffer state, and other state variables that are to be configured before 3D primitive commands are processed. The values of these commands are determined at least in part based on the particular 3D API in use. The 3D pipeline state 2230 commands may also be able to selectively disable or bypass certain pipeline elements if those elements will not be used.

A 3D primitive 2232 command may be used to submit 3D primitives to be processed by the 3D pipeline. Commands and associated parameters that are passed to the graphics processor via the 3D primitive 2232 command are forwarded to the vertex fetch function in the graphics pipeline. The vertex fetch function uses the 3D primitive 2232 command data to generate vertex data structures. The vertex data structures are stored in one or more return buffers. The 3D primitive 2232 command may be used to perform vertex operations on 3D primitives via vertex shaders. To process vertex shaders, 3D pipeline 2222 dispatches shader execution threads to graphics processor execution units.

The 3D pipeline 2222 may be triggered via an execute 2234 command or event. A register may write trigger command executions. An execution may be triggered via a 'go' or 'kick' command in the command sequence. Command execution may be triggered using a pipeline synchronization command to flush the command sequence through the graphics pipeline. The 3D pipeline will perform geometry processing for the 3D primitives. Once operations are complete, the resulting geometric objects are rasterized and the pixel engine colors the resulting pixels. Additional commands to control pixel shading and pixel back-end operations may also be included for those operations.

The graphics processor command sequence 2210 may follow the media pipeline 2224 path when performing media operations. In general, the specific use and manner of programming for the media pipeline 2224 depends on the media or compute operations to be performed. Specific media decode operations may be offloaded to the media pipeline during media decode. The media pipeline can also be bypassed and media decode can be performed in whole or in part using resources provided by one or more general-purpose processing cores. The media pipeline may also include elements for general-purpose graphics processor unit (GPGPU) operations, where the graphics processor is used to perform SIMD vector operations using computational shader programs that are not explicitly related to the rendering of graphics primitives.

Media pipeline 2224 may be configured in a similar manner as the 3D pipeline 2222. A set of commands to configure the media pipeline state 2240 are dispatched or placed into a command queue before the media object commands 2242. Commands for the media pipeline state 2240 may include data to configure the media pipeline elements that will be used to process the media objects. This includes data to configure the video decode and video encode logic within the media pipeline, such as encode or decode format. Commands for the media pipeline state 2240 may also support the use of one or more pointers to "indirect" state elements that contain a batch of state settings.

Media object commands 2242 may supply pointers to media objects for processing by the media pipeline. The media objects include memory buffers containing video data to be processed. Optionally, all media pipeline states must be valid before issuing a media object command 2242. Once the pipeline state is configured and media object commands 2242 are queued, the media pipeline 2224 is triggered via an execute command 2244 or an equivalent execute event (e.g., register write). Output from media pipeline 2224 may then be post processed by operations provided by the 3D pipeline 2222 or the media pipeline 2224. GPGPU operations may be configured and executed in a similar manner as media operations.

### Graphics Software Architecture

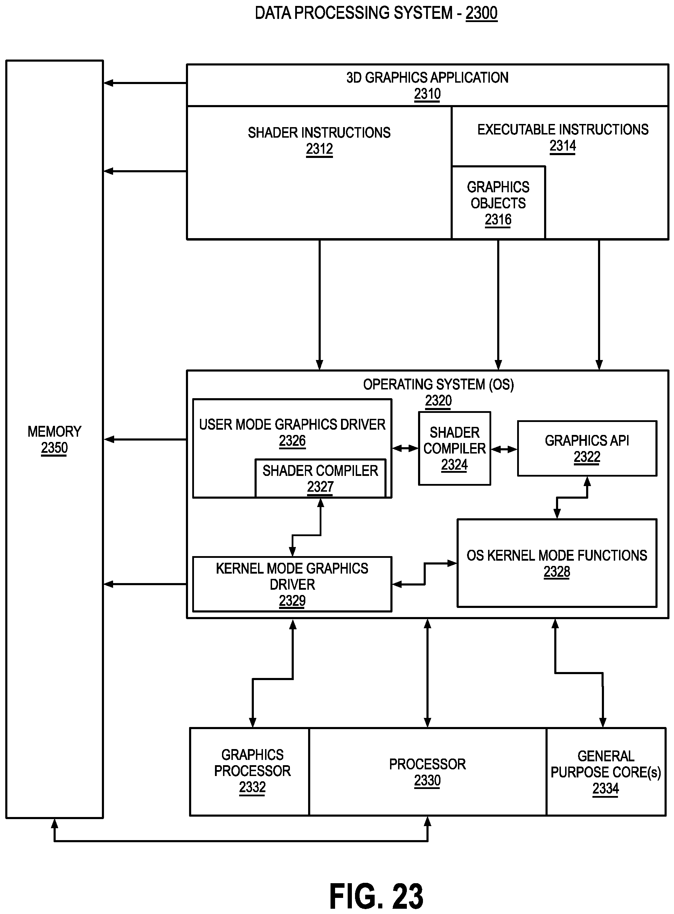

**FIG. 23** illustrates an exemplary graphics software architecture for a data processing system 2300. Such a software architecture may include a 3D graphics application 2310, an operating system 2320, and a processor 2330. The processor 2330 may include a graphics processor 2332 and one or more general-purpose processor core(s) 2334. The processor 2330 may be a variant of one of the processor(s) 1402 or any other of the processors described herein, and may be used in place thereof. Therefore, the disclosure of any features in combination with the processor(s) 1402 or any other of the processors described herein also discloses a corresponding combination with the graphics processor 2332 but is not limited to such. Moreover, the elements of FIG. 23 having the same or similar names as the elements of any other figure herein describe the same elements as in the other figures, can operate or function in a manner similar to that, can comprise the same components, and can be linked to other entities, as those described elsewhere herein, but are not limited to such. The 3D graphics application 2310 and operating system 2320 are each executed in the system memory 2350 of the data processing system.

3D graphics application 2310 may contain one or more shader programs including shader instructions 2312. The shader language instructions may be in a high-level shader language, such as the High-Level Shader Language (HLSL) of Direct3D, the OpenGL Shader Language (GLSL), and so forth. The application may also include executable instructions 2314 in a machine language suitable for execution by the general-purpose processor core(s) 2334. The application may also include graphics objects 2316 defined by vertex data.

The operating system 2320 may be a Microsoft^{®} Windows^{®} operating system from the Microsoft Corporation, a proprietary UNIX-like operating system, or an open source UNIX-like operating system using a variant of the Linux kernel. The operating system 2320 can support a graphics API 2322 such as the Direct3D API, the OpenGL API, or the Vulkan API. When the Direct3D API is in use, the operating system 2320 uses a front-end shader compiler 2324 to compile any shader instructions 2312 in HLSL into a lower-level shader language. The compilation may be a just-in-time (JIT) compilation or the application can perform shader pre-compilation. High-level shaders may be compiled into low-level shaders during the compilation of the 3D graphics application 2310. The shader instructions 2312 may be provided in an intermediate form, such as a version of the Standard Portable Intermediate Representation (SPIR) used by the Vulkan API.

User mode graphics driver 2326 may contain a back-end shader compiler 2327 to convert the shader instructions 2312 into a hardware specific representation. When the OpenGL API is in use, shader instructions 2312 in the GLSL high-level language are passed to a user mode graphics driver 2326 for compilation. The user mode graphics driver 2326 may use operating system kernel mode functions 2328 to communicate with a kernel mode graphics driver 2329. The kernel mode graphics driver 2329 may communicate with graphics processor 2332 to dispatch commands and instructions.

### IP Core Implementations

One or more aspects may be implemented by representative code stored on a machine-readable medium which represents and/or defines logic within an integrated circuit such as a processor. For example, the machine-readable medium may include instructions which represent various logic within the processor. When read by a machine, the instructions may cause the machine to fabricate the logic to perform the techniques described herein. Such representations, known as "IP cores," are reusable units of logic for an integrated circuit that may be stored on a tangible, machine-readable medium as a hardware model that describes the structure of the integrated circuit. The hardware model may be supplied to various customers or manufacturing facilities, which load the hardware model on fabrication machines that manufacture the integrated circuit. The integrated circuit may be fabricated such that the circuit performs operations described in association with any of the embodiments described herein.

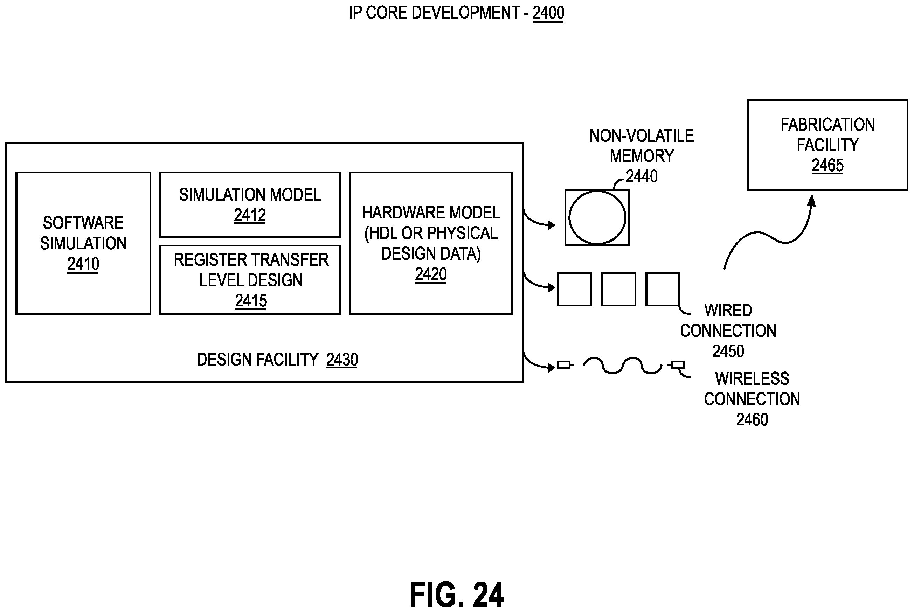

**FIG. 24** is a block diagram illustrating an IP core development system 2400 that may be used to manufacture an integrated circuit to perform operations according to an embodiment. The IP core development system 2400 may be used to generate modular, re-usable designs that can be incorporated into a larger design or used to construct an entire integrated circuit (e.g., an SOC integrated circuit). A design facility 2430 can generate a software simulation 2410 of an IP core design in a high-level programming language (e.g., C/C++). The software simulation 2410 can be used to design, test, and verify the behavior of the IP core using a simulation model 2412. The simulation model 2412 may include functional, behavioral, and/or timing simulations. A register transfer level design (RTL design 2415) can then be created or synthesized from the simulation model 2412. The RTL design 2415 is an abstraction of the behavior of the integrated circuit that models the flow of digital signals between hardware registers, including the associated logic performed using the modeled digital signals. In addition to an RTL design 2415, lower-level designs at the logic level or transistor level may also be created, designed, or synthesized. Thus, the particular details of the initial design and simulation may vary.

The RTL design 2415 or equivalent may be further synthesized by the design facility into a hardware model 2420, which may be in a hardware description language (HDL), or some other representation of physical design data. The HDL may be further simulated or tested to verify the IP core design. The IP core design can be stored for delivery to a fabrication facility 2465 using non-volatile memory 2440 (e.g., hard disk, flash memory, or any non-volatile storage medium). The fabrication facility 2465 may be a 3^{rd} party fabrication facility. Alternatively, the IP core design may be transmitted (e.g., via the Internet) over a wired connection 2450 or wireless connection 2460. The fabrication facility 2465 may then fabricate an integrated circuit that is based at least in part on the IP core design. The fabricated integrated circuit can be configured to perform operations in accordance with at least one embodiment described herein.

**FIG. 25A** illustrates cross-section side view of a package assembly 2590 for an integrated circuit that includes multiple units of hardware logic chiplets connected to a substrate 2580 (e.g., base die). A graphics processing unit, parallel processor, and/or compute accelerator as described herein can be composed from diverse silicon chiplets that are separately manufactured. In this context, a chiplet is an at least partially packaged integrated circuit that includes distinct units of logic that can be assembled with other chiplets into a larger package. A diverse set of chiplets with different IP core logic can be assembled into a single device. Additionally, the chiplets can be integrated into a base die or base chiplet using active interposer technology. The concepts described herein enable the interconnection and communication between the different forms of IP within the GPU. IP cores can be manufactured using different process technologies and composed during manufacturing, which avoids the complexity of converging multiple IPs, especially on a large SoC with several flavors IPs, to the same manufacturing process. Enabling the use of multiple process technologies improves the time to market and provides a cost-effective way to create multiple product SKUs. Additionally, the disaggregated IPs are more amenable to being power gated independently, components that are not in use on a given workload can be powered off, reducing overall power consumption.

In various embodiments a package assembly 2590 can include fewer or greater number of components and chiplets that are interconnected by an interconnect fabric 2585 or a bridge structure 2587. The bridge structure 2587 may be used to facilitate a point-to-point interconnect between, for example, a logic or I/O chiplet 2574 and memory chiplets 2575. In some implementations, the bridge structure 2587 may also be embedded within the substrate 2580. The chiplets within the package assembly 2590 may have a 2.5D arrangement using Chip-on-Wafer-on-Substrate (CoWoS) stacking in which multiple dies are stacked side-by-side on a silicon interposer that includes through-silicon vias (TSVs) to couple the chiplets with the substrate 2580, which includes electrical connections to the package interconnect 2583.

In one embodiment, silicon interposer is an active interposer 2589 that includes embedded logic in addition to TSVs. In such embodiment, the chiplets within the package assembly 2590 are arranged using 3D face to face die stacking on top of the active interposer 2589. The active interposer 2589 can include I/O hardware logic 2591, cache memory 2592, and other hardware logic 2593, in addition to the interconnect fabric 2585 and the bridge structure 2587. The interconnect fabric 2585 enables communication between the various logic chiplets within the active interposer 2589. The interconnect fabric 2585 may be an NoC interconnect or another form of packet switched fabric that switches data packets between components of the package assembly. For complex assemblies, the interconnect fabric 2585 may be a dedicated chiplet enables communication between the various hardware logic of the package assembly 2590.

The hardware logic chiplets can include special purpose hardware logic chiplets 2572, a logic or I/O chiplet 2574, and/or memory chiplets 2575. The special purpose hardware logic chiplets 2572 and logic or I/O chiplet 2574 may be implemented at least partly in configurable logic or fixed-functionality logic hardware and can include one or more portions of any of the processor core(s), graphics processor(s), parallel processors, or other accelerator devices described herein. The memory chiplets 2575 can be DRAM (e.g., GDDR, HBM) memory or cache (SRAM) memory. Cache memory 2592 within the active interposer 2589 (or substrate 2580) can act as a global cache for the package assembly 2590, part of a distributed global cache, or as a dedicated cache for the interconnect fabric 2585.

Each chiplet can be fabricated as separate semiconductor die and coupled with a base die that is embedded within or coupled with the substrate 2580. The coupling with the substrate 2580 can be performed via an interconnect structure 2573. The interconnect structure 2573 may be configured to route electrical signals between the various chiplets and logic within the substrate 2580. The interconnect structure 2573 can include interconnects such as, but not limited to bumps or pillars. In some embodiments, the interconnect structure 2573 may be configured to route electrical signals such as, for example, input/output (I/O) signals and/or power or ground signals associated with the operation of the logic, I/O, and memory chiplets. In one embodiment, an additional interconnect structure couples the active interposer 2589 with the substrate 2580.

The substrate 2580 may be an epoxy-based laminate substrate and/or may also include other suitable types of substrates. The package assembly 2590 can be connected to other electrical devices via a package interconnect 2583. The package interconnect 2583 may be coupled to a surface of the substrate 2580 to route electrical signals to other electrical devices, such as a motherboard, other chipset, or multi-chip module.

A logic or I/O chiplet 2574 and a memory chiplet 2575 may be electrically coupled via a bridge structure 2587 that is configured to route electrical signals between the logic or I/O chiplet 2574 and a memory chiplet 2575. The bridge structure 2587 may be a dense interconnect structure that provides a route for electrical signals. The bridge structure 2587 may include a bridge substrate composed of glass or a suitable semiconductor material. Electrical routing features can be formed on the bridge substrate to provide a chip-to-chip connection between the logic or I/O chiplet 2574 and a memory chiplet 2575. The bridge structure 2587 may also be referred to as a silicon bridge or an interconnect bridge. For example, the bridge structure 2587 is an Embedded Multi-die Interconnect Bridge (EMIB). Alternatively, the bridge structure 2587 may simply be a direct connection from one chiplet to another chiplet.

**FIG. 25B** illustrates a package assembly 2594 including interchangeable chiplets 2595, according to an embodiment. The interchangeable chiplets 2595 can be assembled into standardized chiplet slots or chiplet sockets on base chiplets 2596, 2598. The base chiplets 2596, 2598 can be coupled via a bridge interconnect 2597, which can be similar to the other bridge interconnects described herein and may be, for example, an EMIB. Memory chiplets can also be connected to logic or I/O chiplets via a bridge interconnect. I/O and logic chiplets can communicate via an interconnect fabric. The base chiplets can each support one or more slots in a standardized format for one of logic or I/O or memory/cache.

SRAM and power delivery circuits may be fabricated into one or more of the base chiplets 2596, 2598, which can be fabricated using a different process technology relative to the interchangeable chiplets 2595 that are stacked on top of the base chiplets. For example, the base chiplets 2596, 2598 can be fabricated using a larger process technology, while the interchangeable chiplets can be manufactured using a smaller process technology. One or more of the interchangeable chiplets 2595 may be memory (e.g., DRAM) chiplets. Different memory densities can be selected for the package assembly 2594 based on the power, and/or performance targeted for the product that uses the package assembly 2594. Additionally, logic chiplets with a different number of types of functional units can be selected at time of assembly based on the power, and/or performance targeted for the product. Additionally, chiplets containing IP logic cores of differing types can be inserted into the interchangeable chiplet slots, enabling hybrid processor designs that can mix and match different technology IP blocks.

### Exemplary System on a Chip Integrated Circuit

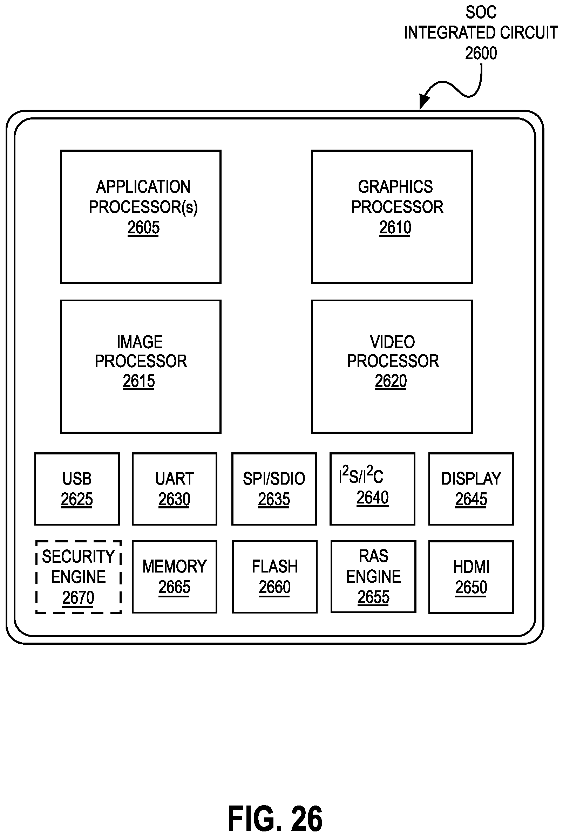

**FIG. 26** illustrates an exemplary integrated circuit that may be fabricated using one or more IP cores. In addition to what is illustrated, other logic and circuits may be included, including additional graphics processors/cores, peripheral interface controllers, or general-purpose processor cores. The elements of FIG. 26 having the same or similar names as the elements of any other figure herein describe the same elements as in the other figures, can operate or function in a manner similar to that, can comprise the same components, and can be linked to other entities, as those described elsewhere herein, but are not limited to such.

The system on a chip integrated circuit 2600 includes one or more application processor(s) 2605 (e.g., CPUs), a graphics processor 2610, which may be a variant of the graphics processor(s) 1408, or of any graphics processor described herein and may be used in place of any graphics processor described. Therefore, the disclosure of any features in combination with a graphics processor herein also discloses a corresponding combination with the graphics processor 2610 but is not limited to such. The system on a chip integrated circuit 2600 may additionally include an image processor 2615 and/or a video processor 2620, any of which may be a modular IP core from the same or multiple different design facilities. The system on a chip integrated circuit 2600 may include peripheral or bus logic including a USB controller 2625, UART controller 2630, an SPI/SDIO controller 2635, and an I²S/I²C controller 2640. Additionally, the integrated circuit can include a display device 2645 coupled to one or more of a high-definition multimedia interface (HDMI) controller 2650 and a reliability, availability, and serviceability engine (RAS engine 2655). The RAS engine 2655 is used to identify potential faults that may occur during device runtime to minimize the downtime that would result if those potential faults were to occur. Storage may be provided by a flash memory subsystem 2660 including flash memory and a flash memory controller. Memory interface may be provided via a memory controller 2665 for access to SDRAM or SRAM memory devices. Some integrated circuits additionally include an embedded security engine 2670.

### Low-rank Decomposition-based Hardware Compression of Matrices and Tensors

In artificial intelligence (AI) operations, the costs of storage, bandwidth, and power for matrix multiplication operations is growing quickly because of the expansion of all elements and usages of AI neural processing. AI and machine learning (ML) processing are dominated by matrix operations, which create a greater and greater burden on the processing, memory, and bandwidth capabilities of computing systems.

There are existing technologies that allow for many types of compression of matrices and tensors, which may assist in memory and bandwidth limitations of neural processing. In general, as used herein, a matrix represents a rectangular, two-dimensional array or grid of values, which are arranged in rows and columns; and tensors represents a generalized multidimensional array of values. For simplicity, tensors are illustrated as three-dimensional constructs, but tensors are not limited to any particular dimensionality.

For example, the large number of matrix decompositions include examples such as PCA (Principal Component Analysis) and SVD (Singular Value Decomposition). For tensors, there is, for example, tensor decomposition that takes a three-dimensional (3D) tensor and decomposes this into multiple sub-tensors. However, these are only limited examples. Further, there are different number formats that may be applied in neural network and other processing that will reduce the amount of data to be transferred, stored, and processed in neural network calculations. For example, 4-bit floating-point (FP4) provides an improvement in considering a sub-block of a tensor, introducing a shared factor per block, thus providing a block-wise compression rather than a per element compression. This has implications in that the quality of the network, providing a better quality than, for example, 8-bit floating-point (FP8).

However, there remain opportunities for significant improvement in processing in response to data formats and compression formats for matrix and tensor operations in neural networks. There selections can reduce the pressure on memory, such as HBM (High Bandwidth Memory), and on system bandwidth.

In some embodiments, compression is implemented in hardware for matrices and tensors, wherein the implemented compression of the full matrix or tensor is more principled than, for example, mere quantization of a matrix or other similar solutions. In some embodiments, an apparatus, system, or process is to provide a decomposition based streaming lossy matrix compression as implemented in accelerator hardware. Low-rank decomposition based compression is orthogonal to the low-precision data types (FP8, FP4, etc.) and thus can be applied in combination or separately from such data types, providing additional benefits and flexibility in addressing AI processing costs.

In operation, the selection of optimized compressed formats can assist in providing advantages in implementations including neural networks. This alleviates the pressures on the amount of memory and system bandwidth, as well as limitations on caches and registers. The compression further assists in reduction of the overall power consumption for neural processing as the amount of energy per operation is reduced.

In terms of compressing a matrix or tensor, there are existing methods for decomposition. Lossy compression may be applied on top of this, with low rank compression. When there is a matrix or tensor with a particular structure, this can be decomposed in a lower dimensional sub-matrices and thus gain bandwidth and computational benefits from this, while dropping only an insignificant amount of information in the matrix or tensor. This is low rank decomposition, which may be utilized to provide an approximation of the matrix or tensor.

In some embodiments, an apparatus, system, or process operates to perform one or more of the following utilizing accelerator hardware to improve matrix or tensor operations:
(a) Low rank decomposition of matrices;
(b) Low rank decomposition of tensors;
(c) Hardware implementation of full singular decomposition of matrices or tensors, and
(d) Hardware implementation of approximate, iterative decomposition of matrices or tensors. The iterative decomposition, allowing for a practical and effective implementation of decomposition in an apparatus or system.

Low-rank decomposition may be utilized in embodiments to provide additional benefits in system operations. In an example, low-rank decomposition may be applied to provide for informational bottlenecking application in a network. The Information Bottleneck Method refers to a technique developed in information theory for pattern analysis and representation learning, providing a balance or tradeoff between data compression and information preservation. (The Information Bottleneck Method, N. Tishby, et al., 1999)

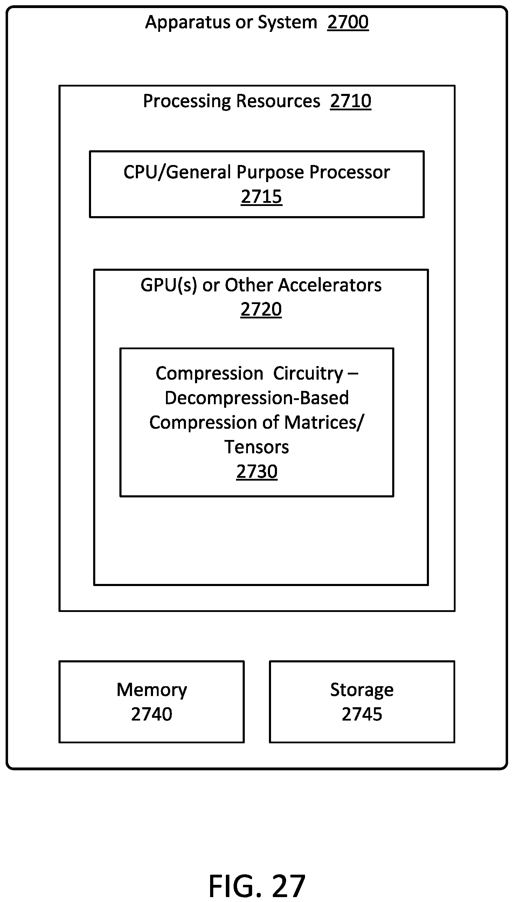

**FIG. 27** is an illustration of an apparatus or system to provide for low-rank decomposition-based hardware compression, according to some embodiments. In some embodiments, an apparatus or system 2700 includes processing resources 2710, which may include one or more central processing units (CPUs) or other general purpose processors 2715, and one or more GPUs or other accelerators 2720. The apparatus or system 2700 further includes a memory 2740, such as DRAM and other memory technologies, to store data for processing, and storage 2745, such as solid state drive (SSD) and other storage technologies, to provide nonvolatile storage of data.

In some embodiments, the one or more GPUs or other accelerators 2720 enable decomposition-based compression to provide for improvements in neural network process. In some embodiments, the one or more GPUs or other accelerators 2720 include compression circuitry 2730 to perform decompression-based compression of matrices, tensors, or both. The compression circuitry 2730 may be utilized for decomposition of matrices, tensors, or both in lossy compression of the matrices or tensors. The resulting approximated matrices or tensors may be utilized in calculations involving the matrices or tensors, while providing improved efficiency in memory, bandwidth, and power usage in operation. In some embodiments, the compression circuitry 2730 generates a compact storage of matrices and tensors through use of lossy compression based on mathematical matrix decomposition and dimensionality reduction.

Other elements of the apparatus or system 2700 and the processing resources 2710, including GPUs and other accelerators 2720, may be as described above in relation to FIGS. 1 through 26.

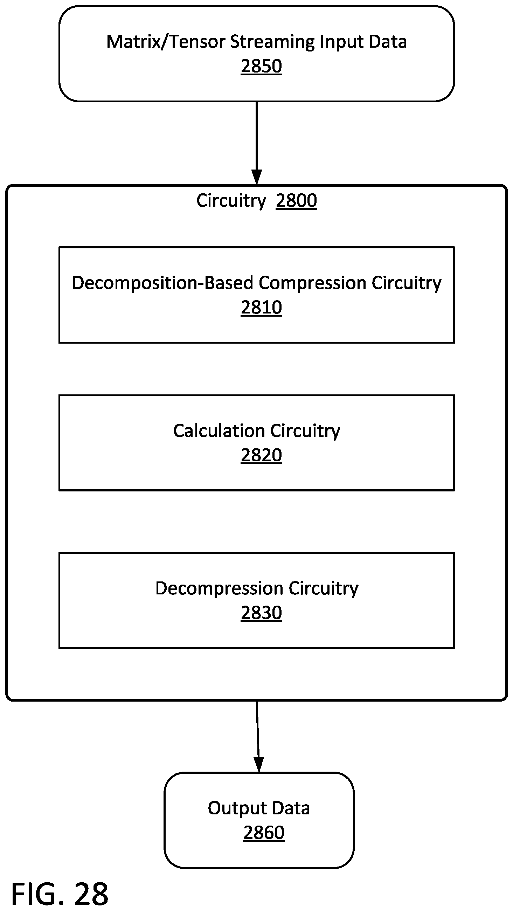

**FIG. 28** is an illustration of circuitry of a graphical processing unit (GPU) or other accelerator, according to some embodiments. In some embodiments, circuitry 2800, which may include compression circuitry 2730 illustrated in FIG. 27 of a GPU or other accelerator, provides for lossy compression based on mathematical matrix decomposition and dimensionality reduction.

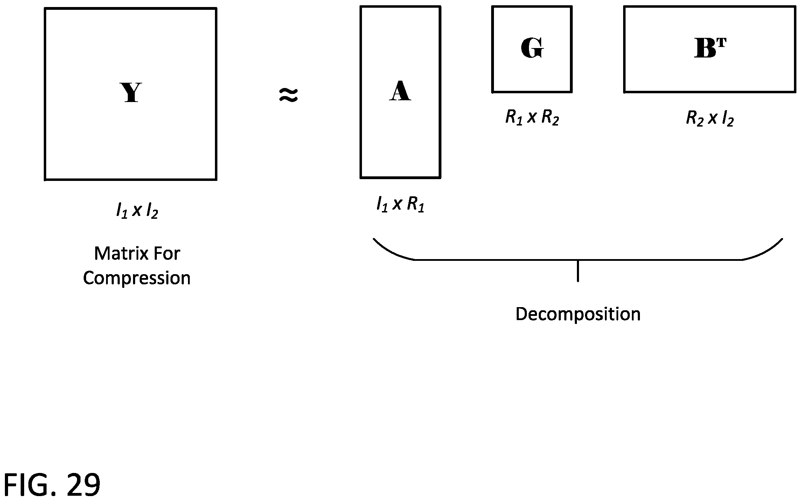

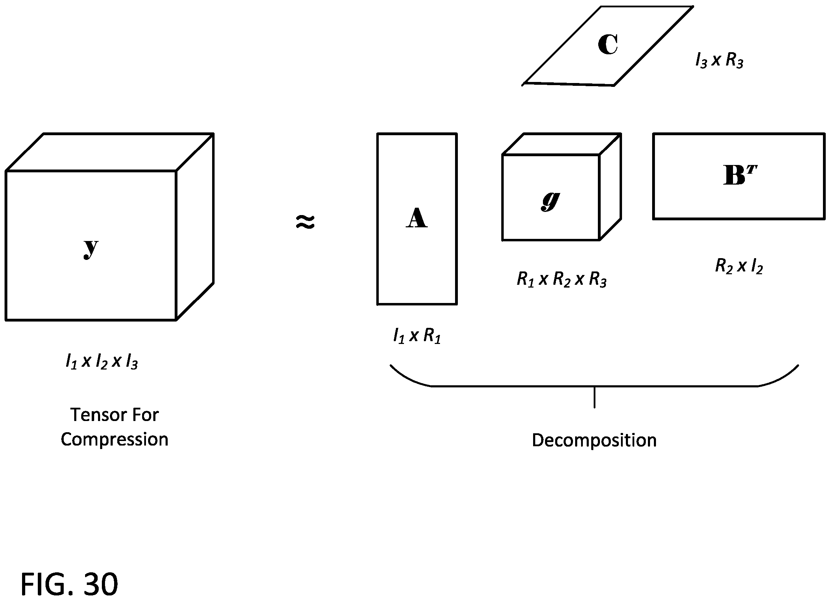

In some embodiments, circuitry 2800 includes one or more of:
(a) Decomposition-based compression circuitry 2810 for streaming decomposition and compression of matrices, tensors, or both to generated approximated matrices or tensors in the form of multiple sub-matrices or sub-tensors. The decomposition may include, but is not limited to, the decomposition of matrices illustrated in FIG. 29 and the decomposition of tensors illustrated in FIG. 30 to generate a set of components representing approximated versions of the matrices or tensors.
(b) Calculation circuitry 2820 providing for multiplication of compressed matrices, tensors, or both, including calculation involving matrices and tensors that have been decomposed as illustrated in FIGS. 29 and 30. In some embodiments, the calculation circuitry 2820 provides for calculations based on sub-matrices or sub-tensors that result from decomposition-based compression.
(c) In some embodiments, the circuitry 2800 further includes decompression circuitry 2830, the decompression circuitry 2830 providing for decompression of a matrix or tensor compressed utilizing for lossy compression based on mathematical matrix decomposition and dimensionality reduction.

In some embodiments, an apparatus, system, or process utilizes accelerator circuitry, such as circuitry 2800, to perform decomposition-based streaming lossy matrix compression, such as the processing of matrix or tensor streaming input data 2850 to generate compressed output data 2860.

In a decomposition operation, a matrix may be received and decomposed into two sub-matrices, the sub-matrices having reduced dimensions, with the amount of compression being increased by minimizing the resulting dimensions. Similarly, a tensor may be decomposed into multiple sub-matrices with reduced dimensions. The multiplication of the reduced sub-matrices will result in an approximation of the original matrix, with the sub-matrices requiring fewer resources to handle in operation. A matrix or tensor may be received and decomposed into the multiple sub-matrices with reduced dimensions, with compression being maximized by minimizing the resulting dimensions. The multiplication of the reduced sub-matrices will result in an approximation of the original matrix or tensor, As machine learning operation is dominated by the multiplication of matrices, the multiplication of two matrices can be viewed as the multiplication of each matrix decomposed into the reduced sub-matrices, and thus four of such sub-matrices in an operation for the multiplication of two matrices, with the multiplication of the reduced sub-matrices being more efficient because of the lower number of computations for the compressed matrices. This decomposition-based compression provides further benefits because of the lower memory footprint for the sub-matrices, and the reduction in bandwidth required for data transfer.

In some embodiments, multiple operations may be applied to provide a principled compression of a matrix. Matrix or tensor decomposition is performed in hardware, allowing for significant benefits in compression. In some embodiments, the hardware decomposition, such as performed by circuitry 2800, may be performed by either:
(a) Matrix or tensor decomposition in a singular operation performed by the hardware; or
(b) Matrix or tensor decomposition performed in an iterative manner by the hardware. An iterative decomposition may be utilized in operations including training of machine learning models.

In some embodiments, an apparatus, system or process is to achieve a more compact storage of matrices and tensors through use of lossy compression that is based on mathematical matrix decomposition and dimensionality reduction methods that may include examples such as PCA (Principal Component Analysis), SVD (Singular Value Decomposition), and others for matrices, and canonical polyadic decomposition (CPD) and Tucker decomposition for tensors. This compression allows a system to store the most significant components (e.g., vectors) of a matrix, while dropping less significant information in a mathematically principled way via dimensionality reduction. The more compact lossy representation of matrices may be applied to reduce storage, bandwidth, and power for processing, while maintaining sufficient accuracy needed for AI workloads.

In an example of lossy compression utilizing PCA, a matrix X of size n * p can be decomposed into a matrix of the most important basis vectors W (dimensionality n * l) and a matrix of projection weights onto these vectors T (dimensionality l * p). The dimension l may be chosen to be significantly smaller than n or p. This may be viewed as considering the first l most significant dimensions. The approximation of the original matrix X can then be reconstructed as a product T * W.

While an operation requires additional multiplication to reconstruct the compressed approximation of the original matrix, the decomposed matrices may be truncated to the lower number of dimensions (e.g., l in case of PCA example). Therefore, the product of two approximate matrices X' and Y' can be computed in an optimized (e.g., streamed) fashion, similarly to other matrix products, while maintaining the dimensionality of the lower-dimensional decomposed matrices T_x, W_x, T_y, and W_y lower than the original dimensionality of the original matrices X and Y. This may then be applied to require fewer bytes of data and fewer operations for matrix multiplication, while mathematically managing the compression error. A decomposition (such as, for example, PCA) that is applied in lossy compression may be computationally costly when considered by itself. However, streaming decomposition, such as streaming PCA methods, may be utilized to efficiently compute the lower-dimensional decomposition on the fly.

**FIG. 29** is an illustration of an example decomposition of a matrix in a compression operation, according to some embodiments. As illustrated in FIG. 29, a matrix Y is of dimensions I₁ x I₂. In a decomposition by a circuitry, such as circuitry 2800 of FIG. 28, matrix Y may be decomposed into two reduced (sliver) matrices that are each reduced in a dimension, the reduced matrices being matrix A with dimensions I₁ x R₁, with R₁ being less than I₂, matrix B^{T} with dimensions R₂ x I₂, with R₂ being less than I₁. and matrix G with dimensions R₁ x R₂, G being a matrix of projected weights onto the sub-matrices A and B. The more compression that is applied, the thinner the matrices A and B will be. At the canonical limit, matrix A is a single column, and matrix B is a single row, and G would be 1 x 1, and thus drops out mathematically. When multiplied together, these elements provide an approximation of the original matrix Y. In some embodiments, the identification of the R₁ and R₂ values for compression may be established by software or hardware during training, and provided to hardware. As training is performed, the matrix Y becomes more structured, resulting in more compression opportunities. In a particular implementation, there may be a fixed or set power, such as 2x, 4x, or any other value, that a matrix may be reduced in dimensionality, which may provide certain simplification in hardware. However, embodiments are not limited to a particular level or reduction for compression. In an operation, software or hardware may be utilized to determine an amount of compression for a particular matrix or tensor, based on the characteristics of the matrix or tensor.

In an example operation, the matrix Y is to be multiplied by another matrix, which may be matrix X in this example. X is also subjected to decompression-based lossy compression in the same fashion as matrix. In this case, each of Y and X has a product of the reduced sub-matrices representing them in the matrix decomposition operation, with the multiplication being by the rows and columns of the sub-matrices. This results in an operation represented by three multiplications utilizing the reduced matrices. These multiplication operations are much easier to stream in, with a smaller footprint than the original matrices.

The performance of decomposition may be a costly operation computationally. For decomposition, the operation involves processing a matrix and finding the effective dimensionality of the matrix, which requires complex calculation. In some embodiments, the calculation may be performed in a circuit effectively using an iterative algorithm for the particular decomposition algorithm.

In a particular implementation, a truncated SVD (Singular Value Decomposition) is utilized, the SVD including a factorization of a matrix. The SVD is approximated by iterative algorithm for eigen decomposition. The iterative process may be expressed as, in one example, the following power iteration algorithm:
1. Initialize random x
2. Update *x* ← *Ax*
3. Normalize *x* ← *x*/∥*x*∥
4. Goto #2 unless converged

In this example, the iteration proceeds in a loop until the decomposition is generated. If there is training in a neural network or other similar operation, then matrices and tensors do not generally change greatly from one iteration to a following iteration. In a hardware implementation, an approximate operation may be implemented, and at each iteration of the training, the decomposition is refined. As training is an iterative process, this allows for the iterative decomposition to be accomplished in an incremental manner by carrying results from one training iteration to a following training iteration. In a particular example, this may be implemented as one iteration per training iteration, allowing for a simplified implementation in hardware for decomposition-based compression. This can provide an efficient implementation in hardware that may be utilized instead of a full SVD or other decomposition, while providing a good decomposition of a matrix or tensor.

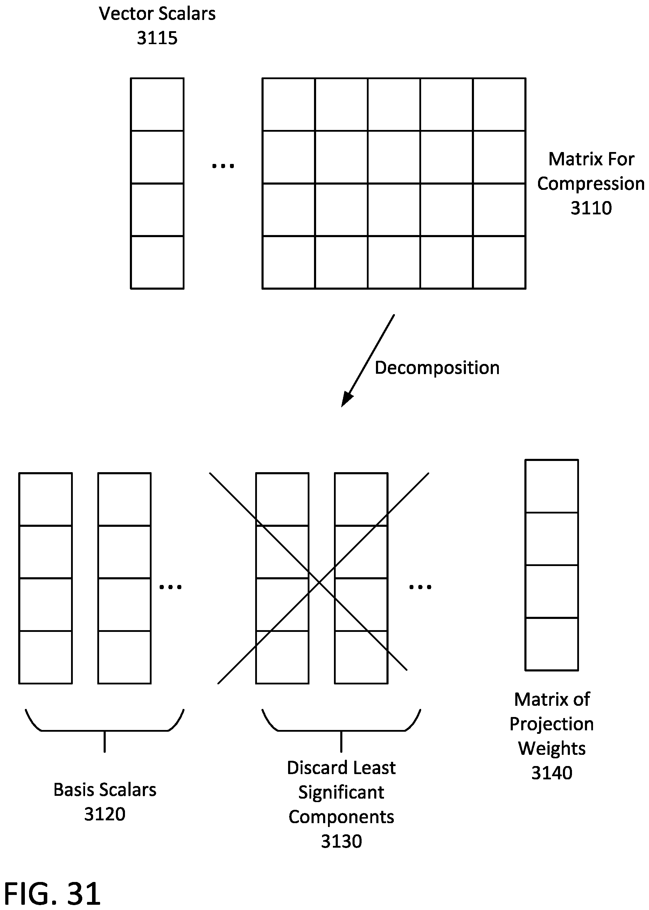

**FIG. 30** is an illustration of an example decomposition of a tensor in an operation, according to some embodiments. As illustrated in FIG. 31, a tensor y is of dimensions I₁ x I₂ x I₃. In a decomposition by a circuitry, tensor *y* may be decomposed into three reduced sub-matrices that are each reduced in a dimension, the sub-matrices being sub-matrix A with dimensions I₁ x R₁, sub-matrix B^{T} with dimensions R₂ x I₂, and sub-matrix C with dimensions I₂ x R₃, and a tensor with dimensions R₁ x R₂ x R₃. G being a tensor of projected weights onto the sub-matrices A, B, and C. At the canonical limit, each of A, B, and C contain a single row or column, with the tensor thus being 1 x 1 x 1, and thus drops out mathematically.

In an example operation, the tensor y is to be multiplied by another tensor, which may be tensor x in this example. In this case, each of *y* and x has a product of the reduced sub-matrices representing them in the matrix conversion.

**FIG. 31** is an illustration of an example decomposition of a matrix in an operation, according to some embodiments. As shown in a simplified example, a matrix 3110 for compression may be viewed as being composed of vector scalars 3115 representing each of the columns of the matrix 3110.

Upon implementing a decomposition algorithm in operation of a circuit, the matrix 3110 is decomposed into a set of basis scalars 3120 representing more significant values components of the matrix, with the least significant components 3130 being discarded. Further, a matrix of projection weights 3140 is generated, with the basis scalars 3120 and matrix of projection weight 3140 representing an approximated version of the original matrix.

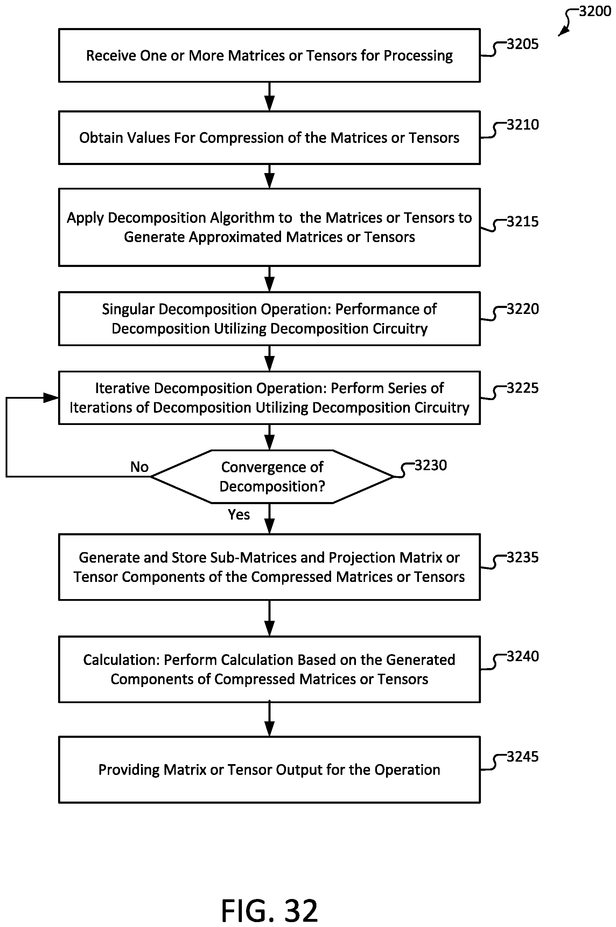

**FIG. 32** is an illustration of a process for decomposition-based compression of a matrix or tensor, according to some embodiments. In a process 3200, one or more matrices or tensors are received for processing 3205, wherein the processing includes application of a decomposition-based compression circuitry, such as circuitry 2800 illustrated in FIG. 28. The one or more matrices or tensors may be received for decomposition-based compression for storage, or may be received for a calculation, such as multiplication of matrices or tensors.

In some embodiments, values are obtained for compression of the one or more matrices or tensors 3210. In an example, the one or more matrices or tensors may be processed, such as by software or hardware, to determine a level of compression to be applied to the one or more matrices or tensors. A greater or lesser level of compression may be acceptable for a matrix or tensor based on the characteristics of the matrices or tensors.

In some embodiments, a decomposition algorithm is applied to the one or more matrices or tensors utilizing the decomposition-based compression circuitry to generate approximated matrices or tensors 3215. In some embodiments, decomposition and compression of the one or more matrices or tensors is based at least in part on the values obtained for compression of the one or more matrices or tensors.

In some embodiments, the application of a decomposition algorithm involves performance of a singular decomposition operation 3220 by decomposition circuitry, in which a decomposition result for a matrix or tensor input is generated by the circuitry. In some embodiments, the application of a decomposition algorithm alternatively involves performance of a series of iterations of decomposition utilizing composition circuitry 3225. In an iterative decomposition example, following an iteration a determination 3230 is made whether the decomposition has converged. If not, the series of iterations are continued, and, if so, the decomposition operation is completed. However, it is noted decomposition operations in embodiments are not limited to the singular decomposition operation 3220 or iterative decomposition operations 3225-3230 illustrated in FIG. 32.

Following the completion of the decomposition operation, the resulting sub-matrices and projection matrix or tensor components for the approximated matrix or tensor are generated and may be stored as needed 3235. The resulting components may be stored in a smaller memory footprint than required for the original matrix or tensor, and may be transferred with less required bandwidth than the original matrix or tensor.

In some embodiments, an operation may proceed with a calculation 3240 involving compressed matrices or tensors, such as a multiplication of matrices or tensors. In some embodiments, the calculation 3240 is performed based on the generated components of compressed matrices or tensors. For example, the multiplication of a first matrix with a second matrix is performed utilizing a multiplication of sub-matrices generated from the decomposition-based compression of the first matrix with sub-matrices generated from the decomposition-based compression of the second matrix, such as illustrated in FIG 29.

The operation may then continue with providing the resulting matrix or tensor output for the operation 3245.

The following Examples pertain to certain embodiments:
In Example 1, an apparatus includes a computer memory to store data for processing; and one or more processing resources including one or more accelerators, the one or more accelerators including circuitry for processing of one or more matrices, wherein the circuitry includes decomposition-based compression circuitry, the decomposition-based compression circuitry performing decomposition of one or more input matrices to generate components representing approximated versions of the one or more input matrices.
In Example 2, for an apparatus as provided in Example 1, the components include a plurality of sub-matrices having a reduced dimension from the one or more input matrices.
In Example 3, for an apparatus as provided in Example 1 or 2, the components further include a matrix to provide projected weights onto the plurality of sub-matrices.
In Example 4, for an apparatus as provided in any of Examples 1 to 3, the circuitry further includes calculation circuitry, the calculation circuitry to perform a multiplication of a set of input matrices utilizing processing of the generated components for the set of input matrices.
In Example 5, for an apparatus provided in any of Examples 1 to 4, the decomposition-based compression circuitry performs decomposition of the one or more input matrices in a singular operation.
In Example 6, for an apparatus as provided in any of Examples 1 to 5, the decomposition-based compression circuitry performs decomposition of the one or more input matrices in an iterative operation including a plurality of iterations.
In Example 7, for an apparatus as provided in any of Examples 1 to 6, the decomposition of the one or more input matrices by the decomposition-based compression circuitry is based at least in part on one or more values for compression received for the one or more input matrices.
In Example 8, for an apparatus as provided in any of Examples 1 to 7, the circuitry further includes decompression circuitry to decompression of the one or more input matrices following processing by the decomposition-based compression circuitry.
In Example 9, for an apparatus as provided in any of Examples 1 to 8, the one or more accelerators include one or more graphics processing units (GPUs).
In Example 10, a method includes receiving one or more input tensors for processing; performing compression of the one or more input tensors utilizing a circuitry, the circuitry including decomposition-based compression circuitry to perform decomposition of the one or more input tensors; and generating components representing approximated versions of the one or more input tensors.
In Example 11, for a method as provided in Example 10, the components include a plurality of sub-matrices having a reduced dimension from the one or more input tensors.
In Example 12, for a method as provided in Example 10 or 11, the method further includes performing a multiplication of a set of input tensors utilizing processing of the generated components for the set of input tensors.
In Example 13, for a method as provided in any of Examples 10 to 12, performing decomposition of the one or more input tensors includes performing decomposition of the one or more input tensors in a singular operation.
In Example 14, for a method as provided in any of Examples 10 to 13, performing decomposition of the one or more input tensors includes performing decomposition of the one or more input tensors in an iterative operation including a plurality of iterations.
In Example 15, for a method as provided in any of Examples 10 to 14, performing decomposition of the one or more input tensors is based at least in part on one or more values for compression received for the one or more input tensors.
In Example 16, one or more non-transitory computer-readable storage mediums have stored thereon executable computer program instructions that, when executed by one or more processors, cause the one or more processors to perform operations including receiving one or more input matrices or tensors for processing; performing compression of the one or more input matrices or tensors utilizing a circuitry, the circuitry including decomposition-based compression circuitry to perform decomposition of the one or more input matrices or tensors; and generating components representing approximated versions of the one or more input matrices or tensors.
In Example 17, for storage mediums as provided in Example 16, the components include a plurality of sub-matrices having a reduced dimension from the one or more input matrices or tensors.
In Example 18, for storage mediums as provided in Example 16 or 17, the storage mediums further include instructions that, when executed by one or more processors, cause the one or more processors to perform operations including performing a multiplication of a set of input matrices or tensors utilizing processing of the generated components for the set of input matrices or tensors.
In Example 19, for storage mediums as provided in any of Examples 16 to 18, performing decomposition of the one or more input matrices or tensors includes performing decomposition of the one or more input matrices or tensors in a singular operation.
In Example 20, for storage mediums as provided in any of Examples 16 to 19, performing decomposition of the one or more input matrices or tensors includes performing decomposition of the one or more input matrices or tensors in an iterative operation including a plurality of iterations.
In Example 21, an apparatus includes means for receiving one or more input matrices or tensors for processing; means for performing compression of the one or more input matrices or tensors utilizing a circuitry, the circuitry including decomposition-based compression circuitry to perform decomposition of the one or more input matrices or tensors; and means for generating components representing approximated versions of the one or more input matrices or tensors.
In Example 22, for an apparatus as provided in Example 21, the components include a plurality of sub-matrices having a reduced dimension from the one or more input matrices or tensors.
In Example 23, for an apparatus as provided in Example 21 or 22, the apparatus further includes means for performing a multiplication of a set of input matrices or tensors utilizing processing of the generated components for the set of input matrices or tensors.
In Example 24, for an apparatus as provided in any of Examples 21 to 23, the means for performing decomposition of the one or more input matrices or tensors includes means for performing decomposition of the one or more input matrices or tensors in a singular operation.
In Example 25, for an apparatus as provided in any of Examples 21 to 24, the means for performing decomposition of the one or more input matrices or tensors includes means for performing decomposition of the one or more input matrices or tensors in an iterative operation including a plurality of iterations.
In Example 26, for an apparatus as provided in any of Examples 21 to 25, performing decomposition of the one or more input matrices or tensors is based at least in part on one or more values for compression received for the one or more input matrices or tensors.

While the description and illustration of embodiments provided herein describe specific components, persons of skill in the art will be aware that such components may be combined into fewer elements, or may be split into a greater number of components as required or convenient for a particular implementation. For example, the described component providing for sorting and buffering of inputs may be expressed as a first sorting component and a second buffering component.

In the description above, for the purposes of explanation, numerous specific details are set forth in order to provide a thorough understanding of the described embodiments. It will be apparent, however, to one skilled in the art that embodiments may be practiced without some of these specific details. In other instances, well-known structures and devices are shown in block diagram form. There may be intermediate structure between illustrated components. The components described or illustrated herein may have additional inputs or outputs that are not illustrated or described.

Various embodiments may include various processes. These processes may be performed by hardware components or may be embodied in computer program or machine-executable instructions, which may be used to cause a general-purpose or special-purpose processor or logic circuits programmed with the instructions to perform the processes. Alternatively, the processes may be performed by a combination of hardware and software.

Portions of various embodiments may be provided as a computer program product, which may include a non-transitory computer-readable storage medium having stored thereon computer program instructions, which may be used to program a computer (or other electronic devices) for execution by one or more processors to perform a process according to certain embodiments. The computer-readable storage medium may include, but is not limited to, magnetic disks, optical disks, read-only memory (ROM), random access memory (RAM), erasable programmable read-only memory (EPROM), electrically-erasable programmable read-only memory (EEPROM), magnetic or optical cards, flash memory, or other type of computer-readable medium suitable for storing electronic instructions. Moreover, embodiments may also be downloaded as a computer program product, wherein the program may be transferred from a remote computer to a requesting computer.

Many of the methods are described in their most basic form, but processes can be added to or deleted from any of the methods and information can be added or subtracted from any of the described messages without departing from the basic scope of the present embodiments. It will be apparent to those skilled in the art that many further modifications and adaptations can be made. The particular embodiments are not provided to limit the concept but to illustrate it. The scope of the embodiments is not to be determined by the specific examples provided above but only by the claims below.

If it is said that an element "A" is coupled to or with element "B," element A may be directly coupled to element B or be indirectly coupled through, for example, element C. When the specification or claims state that a component, feature, structure, process, or characteristic A "causes" a component, feature, structure, process, or characteristic B, it means that "A" is at least a partial cause of "B" but that there may also be at least one other component, feature, structure, process, or characteristic that assists in causing "B." If the specification indicates that a component, feature, structure, process, or characteristic "may", "might", or "could" be included, that particular component, feature, structure, process, or characteristic is not required to be included. If the specification or claim refers to "a" or "an" element, this does not mean there is only one of the described elements.

An embodiment is an implementation or example. Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. It should be appreciated that in the foregoing description of exemplary embodiments, various features are sometimes grouped together in a single embodiment, figure, or description thereof for the purpose of streamlining the disclosure and aiding in the understanding of one or more of the various novel aspects. This method of disclosure, however, is not to be interpreted as reflecting an intention that the claimed embodiments requires more features than are expressly recited in the claims. Rather, as the following claims reflect, novel aspects lie in less than all features of a single foregoing disclosed embodiment. Thus, the claims are hereby expressly incorporated into this description, with a claim standing on its own as a separate embodiment.

The foregoing description and drawings are to be regarded in an illustrative rather than a restrictive sense. Persons skilled in the art will understand that various modifications and changes may be made to the embodiments described herein without departing from the broader spirit and scope of the features set forth in the appended claims.

## Claims

1. An apparatus comprising:
a computer memory to store data for processing; and
one or more processing resources including one or more accelerators, the one or more accelerators including circuitry for processing of one or more matrices;
wherein the circuitry includes decomposition-based compression circuitry, the decomposition-based compression circuitry performing decomposition of one or more input matrices to generate components representing approximated versions of the one or more input matrices.

2. The apparatus of claim 1, wherein the components include a plurality of sub-matrices having a reduced dimension from the one or more input matrices.

3. The apparatus of claim 2, wherein the components further include a matrix to provide projected weights onto the plurality of sub-matrices.

4. The apparatus of any of claims 1 to 3, wherein the circuitry further includes calculation circuitry, the calculation circuitry to perform a multiplication of a set of input matrices utilizing processing of the generated components for the set of input matrices.

5. The apparatus of any of claims 1 to 4, wherein:
the decomposition-based compression circuitry performs decomposition of the one or more input matrices in a singular operation; or
the decomposition-based compression circuitry performs decomposition of the one or more input matrices in an iterative operation including a plurality of iterations.

6. The apparatus of any of claims 1 to 5, wherein the decomposition of the one or more input matrices by the decomposition-based compression circuitry is based at least in part on one or more values for compression received for the one or more input matrices.

7. An apparatus of any of claims 1 to 6, wherein the circuitry further includes decompression circuitry to decompression of the one or more input matrices following processing by the decomposition-based compression circuitry.

8. An apparatus of any of claims 1 to 7, wherein the one or more accelerators include one or more graphics processing units (GPUs).

9. A method comprising:
receiving one or more input tensors for processing;
performing compression of the one or more input tensors utilizing a circuitry, the circuitry including decomposition-based compression circuitry to perform decomposition of the one or more input tensors; and
generating components representing approximated versions of the one or more input tensors.

10. The method of claim 9, wherein the components include a plurality of sub-matrices having a reduced dimension from the one or more input tensors.

11. The method of claim 9 or 10, further comprising:
performing a multiplication of a set of input tensors utilizing processing of the generated components for the set of input tensors.

12. The method of any of claims 9 to 11, wherein:
performing decomposition of the one or more input tensors includes performing decomposition of the one or more input tensors in a singular operation; or
performing decomposition of the one or more input tensors includes performing decomposition of the one or more input tensors in an iterative operation including a plurality of iterations.

13. The method of any of claims 9 to 12, wherein performing decomposition of the one or more input tensors is based at least in part on one or more values for compression received for the one or more input tensors.

14. One or more non-transitory computer-readable storage mediums having stored thereon executable computer program instructions that, when executed by one or more processors, cause the one or more processors to perform operations comprising:
receiving one or more input matrices or tensors for processing;
performing compression of the one or more input matrices or tensors utilizing a circuitry, the circuitry including decomposition-based compression circuitry to perform decomposition of the one or more input matrices or tensors; and
generating components representing approximated versions of the one or more input matrices or tensors.

15. The one or more non-transitory computer-readable storage mediums of claim 14, wherein the components include a plurality of sub-matrices having a reduced dimension from the one or more input matrices or tensors.
